# EUROPEAN PATENT APPLICATION

(11) **EP 2 259 140 A1**
(43) Date of publication of application: **08.12.2010**
(21) Application number: 09724711.8
(22) Date of filing: 25.03.2009
(51) Int. Cl.: G03F 7/30, G03F 7/32

(54) **IMMERSION AUTOMATIC DEVELOPMENT APPARATUS AND AUTOMATIC DEVELOPMENT METHOD FOR MANUFACTURING PLANOGRAPHIC PRINTING PLATE**

(30) Priority: 25.03.2008 JP 2008079337
(71) Applicant: FUJIFILM Corporation, Tokyo 106-0031 (JP)
(72) Inventor: OHISHI, Chikashi, Haibara-gun Shizuoka (JP); KAWAUCHI, Ikuo, Haibara-gun Shizuoka (JP); ADACHI, Keiichi, Haibara-gun Shizuoka (JP)
(74) Representative: HOFFMANN EITLE
(86) International application number: PCT/JP2009/056000
(87) International publication number: WO 2009/119687

(57) **Abstract**

An object of the invention is to provide an immersion type automatic developing apparatus and automatic developing method for preparing a lithographic printing plate capable of preparing a lithographic printing plate of high quality.

An immersion type automatic developing apparatus (2) for a lithographic printing plate in which removal of a non-image area is conducted in a state where a lithographic printing plate precursor (4) having on a support an image-recording layer exposed imagewise is immersed in a developing bath (20) filled with an aqueous solution containing a carbonate ion, a hydrogen carbonate ion and a water-soluble polymer compound, wherein a developer composed of the aqueous solution is circulated between the immersion type developing bath (20) forming a processing pass line and an external tank (55) provided outside the processing path line so as to keep constant a liquid level of the immersion type developing bath (20).

## Description

### Technical Field

The present invention relates to an immersion type automatic developing apparatus for preparing a lithographic printing plate and an automatic developing method.

### Background Art

In general, a lithographic printing plate is composed of an oleophilic image area accepting ink and a hydrophilic non-image area accepting dampening water in the process of printing. Lithographic printing is a printing method which comprises rendering the oleophilic image area of the lithographic printing plate to an ink-receptive area and the hydrophilic non-image area thereof to a dampening water-receptive area (ink unreceptive area), thereby making a difference in adherence of ink on the surface of the lithographic printing plate, and depositing the ink only on the image area by utilising the nature of water and printing ink to repel with each other, and then transferring the ink to a printing material, for example, paper.
In order to prepare the lithographic printing plate, a lithographic printing plate precursor (PS plate) comprising a hydrophilic support having provided thereon an oleophilic photosensitive resin layer (a photosensitive layer or an image-recording layer) has heretofore been broadly used. Ordinarily, the lithographic printing plate is obtained by conducting plate making according to a method of exposing the lithographic printing plate precursor through an original, for example, a lith film, and then while leaving the image-recording layer in the portion for forming the image area, removing the unnecessary image-recording layer other than the image area by dissolving with an alkaline developer or an organic solvent thereby revealing the hydrophilic surface of support to form the non-image area.

Thus, in the hitherto known plate making process of lithographic printing plate precursor, after exposure, the step of removing the unnecessary portion of the image-recording layer by dissolving with a developer or the like is required. However, in view of the environment and safety, a processing with a developer closer to a neutral range and a small amount of waste liquid are problems to be solved. Particularly, since disposal of waste liquid discharged accompanying the wet treatment has become a great concern throughout the field of industry in view of the consideration for global environment in recent years, the demand for the resolution of the above-described problems has been increased more and more.

On the other hand, digitalized technique of electronically processing, accumulating and outputting image information using a computer has been popularized in recent years, and various new image outputting systems responding to the digitalized technique have been put into practical use. Correspondingly, attention has been drawn to a computer-to-plate (CTP) technique of carrying digitalized image information on highly converging radiation, for example, laser light and conducting scanning exposure of a lithographic printing plate precursor with the light thereby directly preparing a lithographic printing plate without using a lith film. Thus, it is one of important technical subjects to obtain a lithographic printing plate precursor adaptable to the technique described above.

As described above, the decrease in alkali concentration of developer and the simplification of processing step have been further strongly required from both aspects of the consideration for global environment and the adaptation for space saving and low running cost. However, since the development processing step ordinarily comprises three steps of developing with an aqueous alkali solution having pH of 10 or more, washing of the alkali agent with a water washing bath and then treating with a gum solution mainly comprising a hydrophilic resin as described above, an automatic developing machine per se requires a large space and problems of the environment and running cost, for example, disposal of the development waste liquid, water washing waste liquid and gum waste liquid still remain.

In response to the above situation, for instance, a developing method of processing with an aqueous solution having pH of 10 to 12.5 is proposed in Patent Document 1. However, since the developing method is required a water washing step and a treatment step with a gum solution, it does not resolve the problems of the environment and running cost.
Also, processing with a processing solution having pH of 11.9 to 12.1 and containing a water-soluble polymer compound is described in the example of Patent Document 2. However, since the printing plate obtained is left in the state that the alkali of pH 12 adheres on the surface thereof, a problem in view of safety of an operator arises and with the lapse of long time after the preparation of the printing plate until the initiation of printing, the image area gradually dissolves to result in deterioration in printing durability or ink-receptive property. Also, in Patent Document 3, one bath processing with a processing solution having pH of 3 to 9 and containing a water-soluble polymer compound is described. In Patent Document 4, development processing with a developer having pH of 8.5 to 11.5 and containing an alkali metal carbonate and an alkali metal hydrogen carbonate is described.

However, the decrease in alkali concentration and the simplification of step give a great load to the development processing step. For example, although a photosensitive layer could be readily dissolved and removed with an alkali developer, the photosensitive layer can not be removed with ease with a low-alkali developer. Thus, the photosensitive layer which could not be dissolved and remained may inevitably adhere again to the plate, thereby forming scum on the plate and causing problems of bad appearance and eventually stain at the printing. Also, in some instances, the remaining photosensitive layer may contaminate the inside of the processing machine and the time and labor required for the machine maintenance may be increased.

On the other hand, with the tendency toward the decrease in alkali concentration and the simplification of step, the processing machine used has been converted from a constitution of immersing in a developer to a type of supplying a developer with spraying in horizontal conveyance.
However, the horizontal conveyance constitution has a problem in that due to the spattering of developer the developer tends to scatter and the scattered developer may dry to form scum. Inherently, in the horizontal conveyance constitution, the developer may readily dry during the non-operation of the machine and a rubbing member (brush) and a roller may also dry to be contaminated, and the constitution can not avoid the problem of formation of scum due to the contamination. Therefore, the design of the horizontal conveyance constitution is extremely difficult and its technical hurdle is high.
Patent Document 1: JP-A-11-65126
Patent Document 2: European Patent 1868036
Patent Document 3: JP-T-2007-538279
Patent Document 4: JP-A-11-65126

### Disclosure of the Invention

### Problems that the Invention is to Solve

The invention has been made so as to overcome the above-described drawbacks of a horizontal conveyance type automatic developing apparatus, and an object of the invention is to provide an immersion type automatic developing apparatus and automatic developing method for preparing a lithographic printing plate capable of preparing a lithographic printing plate of high quality.

### Means for Solving the Problems

In order to solve the problems, the invention of an immersion type automatic developing apparatus for a lithographic printing plate described in Claim 1 is an immersion type automatic developing apparatus for a lithographic printing plate in which removal of a non-image area is conducted in a state where a lithographic printing plate precursor having on a support an image-recording layer exposed imagewise is immersed in a developing bath filled with an aqueous solution containing a carbonate ion, a hydrogen carbonate ion and a water-soluble polymer compound, wherein a developer composed of the aqueous solution is circulated between the immersion type developing bath forming a processing pass line and an external tank provided outside the processing path line so as to keep constant a liquid level of the immersion type developing bath.
The invention described in Claim 2 is the immersion type automatic developing apparatus as described in Claim 1, wherein pH of the developer is from 8.5 to 10.8.
The invention described in Claim 3 is the immersion type automatic developing apparatus as described in Claim 1, wherein respective blades are provided as kept in contact with a carry-in roller placed upstream in a transporting direction in the developing bath and a carry-out roller placed downstream in the transporting direction in the developing bath to form a closed structure inside the developing bath.
The invention described in Claim 4 is the immersion type automatic developing apparatus as described in any one of Claims 1 to 3, wherein at least one rubbing member is rotated in a state where at least a part of the rubbing member is kept immersed in the developer to conduct the removal of the non-image area of the lithographic printing plate precursor.
The invention described in Claim 5 is the immersion type automatic developing apparatus as described in Claim 4, wherein the removal action of the non-image area of the lithographic printing plate precursor by rotation of the rubbing member is performed at least 2 seconds after a part of the lithographic printing plate precursor to be subjected to the removal action is contacted with the developer.
The invention described in Claim 6 is the immersion type automatic developing apparatus as described in Claim 5, wherein the rubbing member is placed downstream than a center of distance of the developing bath for the developer in the transporting direction.
The invention described in Claim 7 is the immersion type automatic developing apparatus as described in Claim 6, wherein a spray for spraying the developer in the external tank is provided in a downstream vicinity of the carry-in roller or carry-out roller.
The invention described in Claim 8 is the immersion type automatic developing apparatus as described in any one of Claims 1 to 7, wherein a water washing unit, an oil-desensitizing treatment unit and a drying treatment unit are provided downstream of the developing bath.
The invention described in Claim 9 is the immersion type automatic developing apparatus as described in any one of Claims 1 to 8, wherein at least one of a heat treatment unit for heat treatment of the exposed lithographic printing plate precursor and a pre-water washing unit for removing a protective layer when the lithographic printing plate precursor has the protective layer on the photosensitive layer is provided upstream of the developing bath.
The invention of an automatic developing method for a lithographic printing plate described in Claim 10 is an immersion type automatic developing method for a lithographic printing plate in which removal of a non-image area is conducted in a state where a lithographic printing plate precursor having on a support an image-recording layer exposed imagewise is immersed in a developing bath filled with a developer, wherein the developer is circulated between the immersion type developing bath forming a processing pass line and an external tank provided outside the processing path line so as to keep constant a liquid level of the immersion type developing bath.

### Advantage of the Invention

According to the invention, a lithographic printing plate of constant quality can be manufactured without arising a problem of contamination inside the automatic developing apparatus and a problem of scum.
Also, since the liquid level of the developer is always kept constant, good processing can be consistently conducted, and since the developer is circulatedly used, due to the reduction in the replenishment amount of the developer and the reduction in the waste liquid amount the running cost is reduced and further, the automatic developing apparatus capable of producing a lithographic printing plate which is advantageous in view of the environment is obtained.
Moreover, since the development processing and the oil-desensitizing treatment can be simultaneously conducted with one bath treatment by incorporated a hydrophilic resin into the developer, the maintenance can be simplified.
Furthermore, since the developer has low-alkaline pH of 8.5 to 10.8, fatigue of the developer caused by carbon dioxide in the air hardly occurs and since the developer contains a carbonate ion and a hydrogen carbonate ion which have a buffer function, the decrease in pH can be prevented thereby increasing a processing ability. Further, due to the decrease in alkali concentration in the developer, a binder having an acid group can be actively used to improve the developing property.

### Brief Description of the Drawings

Fig. 1 is a constitutional view of an automatic developing apparatus according to a first embodiment of the invention.
Fig. 2 is a constitutional view of an automatic developing apparatus according to a second embodiment of the invention.
Fig. 3 is a constitutional view explaining the advantage in excellent resource saving where the apparatus of the invention can be produced by giving a slight refinement to a conventional automatic developing apparatus, and (a) is a constitutional view of the automatic developing apparatus according to the second embodiment and (b) is a constitutional view of the conventional apparatus.

### Description of Reference Numerals and Signs

- 2,2A: Automatic developing apparatus according to the invention
- 4: Photosensitive lithographic printing plate (PS plate)
- 6: Developing unit
- 10: Drying unit
- 12: Side plate
- 14: Insertion slot
- 16: Transport roller (carry-in roller)
- 18: Rubber blade
- 20: Developing bath
- 22: Transport roller
- 24: Brush roller
- 26: Squeeze roller
- 27: Plate detection sensor
- 28: Backup roller
- 36: Guide roller
- 38: Skewer roller
- 40: Discharge slot
- 46: Passage
- 50: Control device
- 51: Control ROM and RAM
- 52: Timekeeper
- 55: Developer storage tank
- 58: Developer
- 60: Shielding cover
- 62: Rubber blade
- 71: Developer circulation pump
- 73: Conductivity sensor
- 74: Developer supply pump
- 80: First circulation pipeline
- 90: Second circulation pipeline
- 98: Display device
- 99: Alarm device

### Best Mode for Carrying Out the Invention

Hereinafter, the best mode for carrying out the invention is described in detail with reference to the drawings.

### <First embodiment>

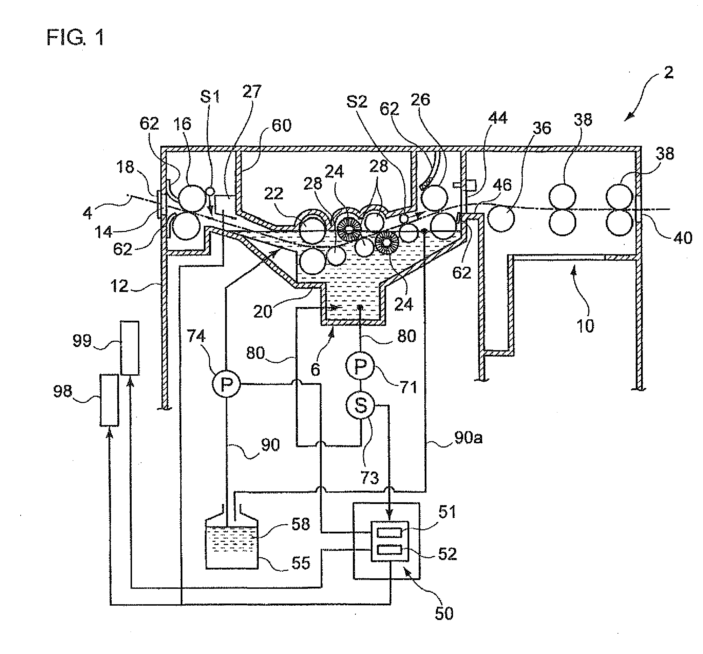

Fig. 1 is a constitutional view of an automatic developing apparatus according to the first embodiment of the invention.
As shown in Fig. 1, the automatic developing apparatus 2 comprises a development unit 6 for developing and further conducting gum treatment of a photosensitive lithographic printing plate (hereinafter referred to as a "PS plate") 4 and a drying unit 10 for drying the developed PS plate 4.
In the side plate 12 of the automatic developing apparatus 2, an insertion slot 14 is formed and the PS plate 4 inserted through the insertion slot 14 is transported into the developing unit 6 by transport rollers (carry-in rollers) 16. The insertion slot 14 is provided with a rubber blade 18 and when the PS plat 4 is not inserted therethrough, the insertion slot 14 is closed by the rubber blade 18.
Inside the developing bath 20 of the developing unit 6, transport rollers 22, brush rollers 24 and squeeze rollers 26 are provided in order from the upstream side in the transporting direction and backup rollers 28 are provided in appropriate positions therebetween. The PS plate 4 is immersed in the developer while being transported by transport rollers 22 and the non-image area of the PS plate 4 is removed by rotation of the brush rollers 24 to conduct the development processing. This is described in more detail hereinafter.
The PS plate 4 subjected to the development processing is transported into the next drying unit 10 by transport rollers (carry-out rollers) 16.

In the drying unit 10, a guide roller 35 and a pair of skewer rollers 38 are provided in order from the upstream side in the transporting direction. In the drying unit 10, drying means, for example, hot air supply means or heat generating means (not shown) is also provided. A discharge slot 40 is provided in the drying unit 10 and the PS plate 4 dried by the drying means is discharged through the discharge slot 40. Also, a shutter 44 is provided in a passage between the drying unit 10 and the developing unit 6 and when the PS plate 4 does not pass through the passage 46, the passage 46 is closed by the shutter 44.
The developing bath 20 is provided with a box-shaped shielding cover 60 as integrated with the bath wall. The bottom wall of the shielding cover 60 is continuously are-wise curved so as not to be in contact with the upper peripheral surfaces of the transport roller 22, the brush roller 24 and the backup roller 28, and not to interfere with the rollers.

Since the shielding cover 60 is box-shaped, an airtight space is formed above the developing bath 20 and the amount of air inside the developing unit 6 is kept as small as possible. In addition, since the shielding cover 60 is provided, the contact area between the developer and air is kept as small as possible.

In the automatic developing apparatus 2 having the constitution described above, a rubber blade 62 is provided at its inlet, as kept in contact with the carry-in roller 16 and thus the developing unit 6 is so designed as to be substantially airtight from the external atmosphere and the open air does not flow into it.
A rubber blade 62 is also provided at its outlet of the developing unit 6, as kept in contact with the carry-out roller 16 and thus the developing unit 6 is so designed as to be substantially airtight, and the air inside the drying unit 10 does not flow into the developing unit 6.
Therefore, although some air may flow into the developing unit 6 while the PS plate 4 pass through it, the developing unit 6 is substantially kept airtight, and has a closed constitution with little air flowing thereinto.
As well, 98 denotes a display device to visually show various necessary information and 99 denotes an alarm device to aurally tell them.

Now, the developing unit 6 is described in detail below.
To the developing bath 20, a first circulation pipeline 80 of developer is connected. The first circulation pipeline 80 has a developer circulation pump 71, a conductivity sensor 73 and a filter (not shown) provided therein. The developer circulation pump 71 acts to suck the developer in the developing bath 20 through a suction hole at the bottom of the developing bath 20 into the first circulation pipeline 80, and acts to make the developer pass through the first circulation pipeline 80 to be again ejected into the developing bath 20. The filter is to filtrate the developer passing through the first circulation pipeline 80. The conductivity sensor 73 is to measure conductivity of the developer passing through the first circulation line 80.

In the developing unit 6, a second circulation pipeline 90, a developer storage tank 55 connected to the second circulation pipeline 90 and a developer supply pump 74 placed in the second circulation pipeline 90 are provided, and the developer overflowed from the developing bath 20 is returned to the developer storage tank 55 via the second circulation pipeline 90.

More specifically, a pair of second circulation pipelines 90, 90a for replenishing the developer 58 is provided in a vicinity of the developing bath 20. The second circulation pipeline 90 for the developer 58 is connected to the external tank (developer storage tank) 55 at its one end (lower end in Fig. 1) and in the pipeline, the developer supply pump 74 is provided. The developer supply pump 74 measures and supplies the developer 58 from the external tank 55 into the developing bath 20. Specifically, the second circulation pipeline 90, the developer supply pump 74 and the external tank 55 constitute the developer circulation means.

The developer supply pump 74 is controlled by a control device 50 provided with control ROM and RAM 51 with memory of developer replenishment conditions and the like inputted therein and a timekeeper 52 based on a plate detection sensor 27 and the timekeeper 52. Specifically, based on the signal from the plate detection sensor 27 capable of detecting the presence or absence of plate transport and measuring the plate area and the like of the transported plate, the control device 50 controls the developer supply pump 74 to conduct the developer replenishment depending on the replenishment condition set in accordance with the actual running conditions of the automatic developing apparatus 2 memorized by the control ROM and RAM 51. Thus, the control unit 50 replenishes the developer 58 corresponding to the necessary amount for the replenishment condition from the developer storage tank 55, for example, for every processing of each one plate. The processing replenishment may not be designed to conduct for each one plate but may be designed to conduct after processing of plural plates.

In the automatic developing apparatus 2, the image-recording surface of the PS plate 4 passed through the transport roller pair 16 on the carry-in side is rubbed with a brush roller (rubbing member) 24 while the image-recording surface is immersed in the developer 58 to remove the unexposed area of the image-recording layer of the PS plate 4, thereby conducting development. Since the plate is rubbed while it is immersed in the developer 58 filled in the developing bath 20, scattering of the developer 58 hardly occurs. Thus, the contamination inside the developing apparatus due to the scattering of developer and the occurrence of scum are prevented. In particular, when the plate is rubbed with a rotating brush roller while immersed in the developer 58, the rubbing member is immersed in the developer 58 preferably to a degree of at least 1/3 of the diameter thereof, more preferably to a degree of at least 1/2 thereof, from the standpoint of preventing the developer from scattering.
To form the developing bath 20, the lithographic printing plate precursor is transported in a downward direction than the horizontal direction and immersed in the developer 58 to be transported in the developer 58.

The rubbing treatment with the rubbing member is more effectively conducted in case where the lithographic printing plate precursor is immersed in the developer, kept therein for a predetermined period of time and then rubbed. According to the development in the system, the developer 58 first penetrates into the photosensitive layer of the lithographic printing plate precursor, and then removal of the photosensitive layer in the non-image area is conducted in a simple manner. Accordingly, when the lithographic printing plate precursor is immersed in the developer 58 prior to the rubbing action, the photosensitive layer may be more effectively removed. According to the experiments, the lapse of time therefor before rubbing is at least 2 seconds after the part to be subjected to the removal action has been immersed in the developer or has been wetted with the developer by spraying, more preferably at least 5 seconds, and still more preferably at least 10 seconds. Since the development processing is ordinarily conducted within 60 seconds, the lapse of time is inevitably shorter than 50 seconds.

Using a spray tube S1 or the like, the photosensitive layer of the PS plate may be contacted with the developer 58 before immersed in the developer 58. In this case, the developer to be sprayed may be the developer in the external tank 55 or may be a fresh developer prepared in a separate tank. Since the time to be taken for the rubbing treatment conducted in the developer 58 in the developing bath 20 after the contact of the photosensitive layer with the developer 58 may be longer, the development may be performed more effectively. Also, by contacting the photosensitive layer with the developer 58, the time to be taken for rubbing the plate after immersed in the developer 58 may appropriately reduced. Further, in order to promote the penetration of developer, a method of vibrating the PS plate 4 while contacted with the developer 58 may also be appropriately employed.

Thus, when the time to be taken from the immersion of the PS plate 4 in the developer 58 to the leaving of the PS plate 4 from the developer 58 is represented by t sec, the rubbing treatment with the rubbing member 24 is preferably conducted after t/2 seconds or later. Therefore, it is desirable that the development is performed at the intermediate or in the latter part of the developing bath 20. Needless-to-say, in case where the length of the developing bath 20 is increased or the transportation speed is lowered to prolong the time for immersion in the developer 58, the rubbing treatment may be conducted in the former part of the developing bath. However, for the purpose of performing stable development processing all of the time, it is designed in the system that the rubbing treatment with the rubbing member 24 is conducted at the intermediate or in the latter part of the developing bath.

After the development processing using the rubbing member 24, the PS plate 4 is left from the developer 58. Although depending on the process condition, when the developer 58 is fatigued in this time, scum may readily adhere to the plate in some cases. Even in such a case, the developer 58 in the developer storage tank 55 that is less fatigued than the developer 58 used during the immersion treatment is directly ejected onto the PS plate 4 through a spray tube S2, whereby foreign materials, for example, the scum adhered onto the PS plate can be removed.

The removal of scum by the spraying is extremely effective when the degree of fatigue of the developer 58 in the developing bath 20 is high as described above. In the circulation system for ejecting through the spray tube S2, a filter especially having a small pore size can be appropriately used.
In such a case, a PS plate 4 free from contamination can be obtained only by the processing bath and the subsequent step after the processing bath may be appropriately omitted.

After the treatment with one bath in the manner as above, the drying unit 10 is provided, and the plate which has been simultaneously subjected to the development and the oil-desensitizing treatment in the first bath is then dried in the drying unit 10. When the processing is completed only in one bath as described above, the apparatus cost can be reduced and in addition, the space saving is possible. Moreover, since the developer 58 is circulated through the external tank, the liquid level of the developer can be always kept constant to stabilize the development processing.

Further, in a conventional apparatus, the developer which may still have a developing ability is partly discarded as waste liquid. In the invention, however, since the developer is circulated, the developing ability of the developer can be used 100% and the life of developer can be controlled.
In addition, the liquid level can be readily controlled by overflow.
Further, by incorporating a water-soluble resin into the developer, the constituting members of the existing automatic developing machine may be effectively used so that the large effect can be achieved by the small refinement.

In case of using an automatic developing machine, for example, any of a method where a developer 58 fed in a developing bath is sucked with a pump and sprayed through a spray nozzle (see Patent Document 3), a method of processing a PS plate precursor 4 by immersion transport through a bath filled with a developer 58 with a guide roll in liquid or the like, and a method of so-called disposable treatment where a substantially unused developer 58 is supplied in an amount necessary for every treatment each one plate is ordinarily employed. From the viewpoint of prevention of liquid scattering, the method of processing a PS plate precursor 4 by immersion transport in a developer is advantageous. Also, the PS plate 4 may be prepared by an apparatus comprising an exposing device and an automatic developing apparatus as integrated together.

In the exposing treatment in the exposing device, the PS plate precursor 4 may be exposed through a transparent original having a line image, a dot image or the like, or may be imagewise exposed by laser light scanning or the like based on digital data. The light source suitable for the exposure includes a carbon arc lamp, a mercury lamp, a xenon lamp, a metal halide lamp, a strobe, an ultraviolet ray, an infrared ray, a laser ray and the like. The laser ray is particularly preferred and includes a solid laser and semiconductor laser emitting an infrared ray having a wavelength of 760 to 1200 nm, an ultraviolet semiconductor laser emitting light having a wavelength of 250 to 420 nm, an argon ion laser and FD-YAG laser emitting visible light and the like. Among them, laser emitting an infrared ray or ultraviolet ray which enables operation under a white lamp or yellow lamp is preferred from the standpoint of the simplification of plate making.

The rubbing member for use in the invention may be any one capable of being used as a member for rubbing the image-recording surface of the PS plate precursor 4. In particular, a member capable of rotating around its rotation axis as the center thereof to rub the image-recording surface (for example, a known channel brush, a twisted brush, a planted brush, a carpet brush or a Moulton roller) is preferably used.

As the channel brush, brushes produced by spirally winding a long so-called channel brush (strip brush) around a surface of a roller body as described in JP-UM-A-62-167253, JP-UM-A-4-63447, JP-UM-A-4-64128 and JP-A-6-186751 are used.

As the twisted brush, brushes produced by inserting a twisted brush into a spiral groove formed on the surface of a shaft thereby spirally winding it around the shaft as described in JP-A-3-87832 are used.

As the planted brush, brushes produced according to a method of planting a brush material in small holes formed in a shaft roller are used.

As the carpet brush, brushes produced by winding a long and thin strip of textile woven with wool material around a peripheral surface of a shaft roller as described in JP-A-2001-5193 and JP-A-2001-66788 are used.

As the Moulton roller, brushes produced by covering a roller body with a sliding sleeve of a woven fibrous material and firmly tightening the sleeve on the mounted side thereof as described in JP-A-10-198044 are used.

In case where a rotating member is used as the rubbing member, the number of revolutions of the rubbing member is preferably as large as possible for improving the removability of the image-recording layer in the unexposed area of the PS plate precursor 4. However, from the standpoint of the durability and the production cost of the automatic developing apparatus and of prevention of scattering of the developer 58 and damage of the exposed area of the PS plate precursor 4, it is preferably from 30 to 1,000 rpm, and more preferably from 50 to 500 rpm.

In case where a brush is used as the rubbing member, the number of the brushes is at least one and plural brush rollers may also be used. In case where 2 or more brushes are used, at least one of them may be rotated in the direction opposite to the processing direction of the PS plate precursor 4. Further, in case of using a rotating rubbing member, the development processing may be conducted while the rubbing member is rocked in the rotary axis direction. By rocking the rubbing member in the rotary axis direction, the non-image area of the PS plate precursor 4 is removed more effectively and a PS plate 4 having better quality can be prepared.

As a material of the brush for the rubbing member, natural fibers, for example, horsehair or pig hair, artificial fibers, metal fibers and the like are known. In view of the chemical resistance thereof, artificial fibers are preferred. Examples of the artificial fiber usable include polyamides, for example, nylon 6, nylon 6.6, nylon 6.10, nylon 6.12 or nylon 12, polyesters, for example, polyethylene terephthalate or polybutylene terephthalate (PBT), polyacrylics, for example, polyacrylonitrile or alkyl poly(meth)acrylate, polyolefins, for example, polyethylene, polypropylene, polystyrene, polyvinyl chloride or polyvinylidene chloride, celluloses, for example, acetyl cellulose, polyurethanes, for example, polyurethane, polyphenylene sulfite and fluorine resins, for example, ethylene/tetrafluoroethylene copolymer or polyvinylidene fluoride. In consideration of the elasticity, rigidity, abrasion resistance, heat resistance, chemical resistance, water-supplying property and hygroscopic property thereof, nylon 6, nylon 6.6, nylon 6.10, nylon 6.12, nylon 12, polypropylene, polybutylene terephthalate and polyethylene terephtalate are preferred and nylon 6.6, nylon 6.10, nylon 6.12, nylon 12, polybutylene terephthalate (PBT) and polypropylene are more preferred. Of the polyesters, polybutylene terephthalate (PBT) is preferred. Of the polyolefins, polypropylene is particularly preferred.

A width of the bristle of the brush is not particularly restricted and is preferably from 0.01 to 1.0 mm, and more preferably from 0.1 to 0.5 mm. When the width of the bristle of the brush is smaller than 0.01 mm, the rubbing property may become poor and when it is larger than 1.0 mm, rubbing scratches may tend to be formed on the surface of the plate. A length of the bristle of the brush is also not particularly restricted and is ordinarily used in a range of 3 to 50 mm. When the length is shorter than 3 mm, the touch of the brush to the PS plate precursor 4 may become uneven and the brush may tend to give rubbing scratches to the surface of the plate. When it is longer than 50 mm, it does not give any more advantage of the length in the development processing and it is also economically disadvantageous. In case of the Moulton roller, since it has a sliding sleeve of a woven material, it is not necessary to define the width and the length of the bristle thereof

According to the first embodiment as described above, since the PS plate 4 simultaneously subjected to the development and oil-desensitizing treatment in the developing bath is dried in the drying unit 10, in case of completing the processing, the apparatus cost can be reduced and in addition, the space saving is possible. Moreover, since the development and rubbing treatment are conducted in the developer, the scattering of developer due to the spattering of developer can be avoided and thus, the problem in that the scattered developer may dry to form scum can be solved in comparison with a horizontal conveyance type automatic developing apparatus when conducted the same low-alkali processing. Moreover, since the developer 58 is circulated, the liquid level of the developer can be always kept constant to stabilize the development processing.

### <Second embodiment>

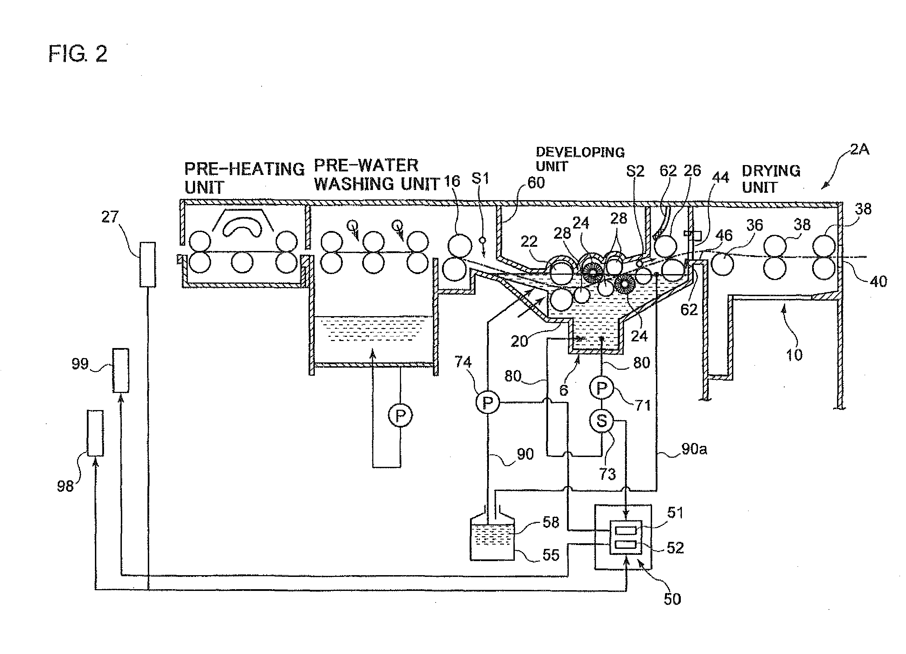

Fig. 2 is a constitutional view of an automatic developing apparatus according to the second embodiment of the invention.
In Fig. 2, 2" denotes the automatic developing apparatus according to the second embodiment of the invention. In the automatic developing apparatus 2", the reference numerals common to those in the automatic developing apparatus 2 (Fig. 1) according to the first embodiment of the invention have the same functions as in the apparatus 2, and any repetitive description thereof is omitted.

In Fig. 2, the development unit 6 has, in principle, the same constitution as in Fig. 1. The difference is that a pre-heating unit and a pre-water washing unit are provided upstream the developing unit 6.
The pre-heating unit is provided upstream the developing unit 6 in the transporting direction and has a function of maintaining a predetermined surface temperature of the PS plate for a predetermined period of time while the PS plate is transported.
The pre-water washing unit is provided upstream the developing unit 6 in the transporting direction and downstream the pre-heating unit in the transporting direction and has a function of washing and cooling the surface of the PS plate with washing water while the PS plate is transported. The PS plate passed through the pre-water washing unit is automatically transported into the next step of the developing unit 6 in the state of being washed.
Although the apparatus may be disadvantageous in that its size is enlarged as a whole by introducing the steps described above, the quality, for example, printing durability can be improved and the quality can be stabilized.
Both the two steps of the pre-heating unit and the pre-water washing unit may be introduced into the apparatus, but any one of them may also be introduced thereinto.

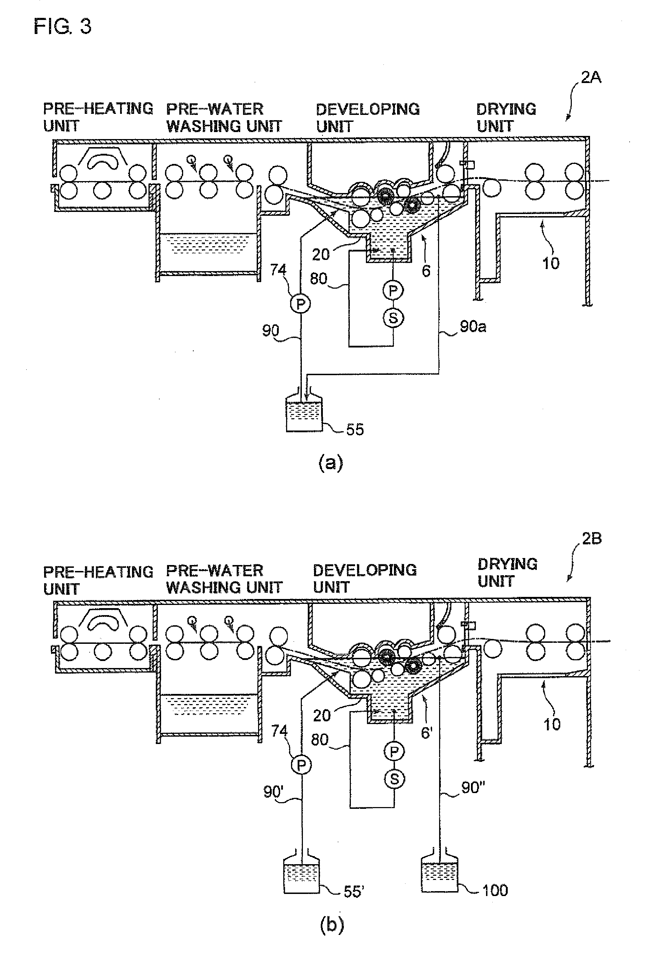

Fig. 3 is a constitutional view explaining the advantage in excellent resource saving according to the invention where the apparatus of the invention can be produced by giving a slight refinement to a conventional automatic developing apparatus, and (a) is a constitutional view of the automatic developing apparatus according to the second embodiment and (b) is a constitutional view of a conventional replenishment type automatic developing apparatus.
In Fig. 3(b), 2B is a conventional automatic developing apparatus and the developing processing step therewith comprises after a pre-heating unit and a pre-water washing unit, developing with an alkali developer in a developing unit 6, washing the alkali agent in a water washing unit, then treating with a gum solution mainly composed of a hydrophilic resin in a gumming unit, and drying in a drying unit.
The developer used in the developing unit 6' is an alkali developer having pH of 10 or higher and the alkali developer is supplied from a developer storage tank 55' to the developing bath 20 through a developer replenishment pipeline 90'.

On the other hand, the developer overflowed is discharged into a waste liquid tank 100 as a used developer (waste liquid) through a waste liquid pipeline 90". When the waste liquid tank 100 is fully filled with the waste liquid, the waste liquid tank 100 is taken out of the apparatus and after removing the waste liquid therein, it is again returned into the apparatus.

When the invention using a developer having pH of 8.5 to 10.5 is applied to the conventional automatic developing apparatus, the function of the invention can be imparted to the conventional automatic developing apparatus only by slight refinement and thus, it is advantageous in view of reduced waste part, resource saving and environment protection.

Fig. 3 (a) is the automatic developing apparatus described in the second embodiment and the differences from Fig. 3(b) are the following:
(1) As the second circulation pipeline 90a, the end of the waste liquid pipeline 90" in Fig. 3(b) is connected to the developer storage tank 55, not to the waste liquid tank 100.
(2) A developer having pH of 8.5 to 10.8 is supplied to the developer storage tank 55.
According to the above two operations, the constituting members of an existing automatic developing machine can be effectively utilized and the large effects are achieved by the small refinement.

### [Negative lithographic printing plate precursor]

With the negative lithographic printing plate precursor for use in the invention, the constitution thereof will be described in turn below.

### [Support]

At the beginning, a support for the lithographic printing plate precursor used in the invention is described.
Although any support having a hydrophilic surface may be used, a dimensionally stable plate-like material is preferably used for the support. The support includes, for example, paper, paper laminated with plastic (for example, polyethylene, polypropylene or polystyrene), a plate of metal (for example, aluminum (including an aluminum alloy), zinc or copper) or its alloy (for example, with silicon, copper, manganese, magnesium, chromium, zinc, lead, bismuth or nickel), a plastic film (for example, cellulose diacetate, cellulose triacetate, cellulose propionate, cellulose butyrate, cellulose acetate butyrate, cellulose nitrate, polyethylene terephthalate, polyethylene, polystyrene, polypropylene, polycarbonate or polyvinyl acetal) and paper or a plastic film having laminated with or vapor-deposited thereon the metal or alloy as described above. Of the supports, an aluminum plate is particularly preferred, because it has extremely dimensional stability and is inexpensive. Also, a composite sheet comprising a polyethylene terephthalate film having bonded thereon an aluminum sheet described in JP-B-48-18327 is preferred. Ordinarily, the thickness of the support is approximately from 0.05 to 1 mm.

In case of using a support having a metal surface, particularly, an aluminum surface, the support is preferably subjected to a surface treatment, for example, a graining treatment, an immersion treatment in an aqueous solution of sodium silicate, potassium fluorozirconate, a phosphate or the like, or anodizing treatment described below.

### [Graining treatment]

As a method for the graining treatment, an electrochemical graining method wherein surface graining is electrochemically conducted in an electrolytic solution of hydrochloric acid or nitric acid or a mechanical graining method, for example, a wire brush graining method wherein a surface of aluminum plate is scratched with a wire brush, a ball graining method wherein a surface of aluminum plate is grained with abrasive balls and an abrasive or a brush graining method wherein a surface of aluminum plate is grained with a nylon brush and an abrasive can be employed. The graining methods may be used individually or in combination of two or more thereof. For instance, a method of conducting mechanical graining, chemical etching and electrolytic graining is described in JP-A-56-28893.
Specifically, a method of forming useful surface roughness is an electrochemical graining method wherein surface graining is electrochemically conducted in an electrolytic solution of hydrochloric acid or nitric acid and suitable current density is in a range from 100 to 400 C/dm². More specifically, it is preferred to perform electrolysis in an electrolytic solution containing from 0.1 to 50% by weight of hydrochloric acid or nitric acid under the conditions of temperature from 20 to 100°C, time from one second to 30 minutes and current density from 100 to 400 C/dm².

The aluminum support subjected to the graining treatment is then chemically etched with an acid or an alkali. The method of using an acid as an etching agent takes time for destroying fine structures. Such a problem may be resolved by using an alkali as the etching agent.
Examples of the alkali agent preferably used include sodium hydroxide, sodium carbonate, sodium aluminate, sodium metasilicate, sodium phosphate, potassium hydroxide and lithium hydroxide. Preferable ranges of the concentration, and temperature are form 1 to 50% and 20 to 100°C, respectively. The conditions for providing a dissolution amount of aluminum in a range from 5 to 20 g/m³ are preferred.
After the etching procedure, the aluminum support is subjected to washing with an acid for removing stain (smut) remaining on the surface thereof. Examples of the acid for use in the acid-washing step include nitric acid, sulfuric acid, phosphoric acid, chromic acid, hydrofluoric acid and hydrofluoroboric acid. As the method for removing smut after the electrochemical graining treatment, a method of bringing the aluminum support into contact with a 15 to 65% by weight aqueous sulfuric acid solution having a temperature of 50 to 90°C as described in JP-A-53-12739 and a method of performing alkali etching as described in JP-B-48-28123 are preferred.
Surface roughness (Ra) of the aluminum support is preferably from 0.3 to 0.7 µm.

### [Anodizing treatment]

The aluminum support subjected to the graining treatment described above may further be subjected to anodizing treatment. The anodizing treatment can be conducted in a manner conventionally used in the field of art.
Specifically, it is performed by applying direct current or alternating current to the aluminum support in an aqueous solution or non-aqueous solution containing sulfuric acid, phosphoric acid, chromic acid, oxalic acid, sulfamic acid, benzenesulfonic acid, or a combination of two or more thereof to form an anodic oxide film on the surface of aluminum support.
The conditions of anodizing treatment cannot be determined generally, since they vary widely depending on the electrolytic solution to be used. However, it is ordinarily suitable that a concentration of the electrolytic solution is in a range from 1 to 80%, a temperature of the electrolytic solution is in a range from 5 to 70°C, a current density is in a range from 0.5 to 60 Ampere/dm², a voltage is in a range from 1 to 100 V, and a period of electrolysis is in a range from 10 to 100 seconds.
Of the anodizing treatments, a method of anodizing in a sulfuric acid solution with a high current density described in British Patent 1,412,768 and a method of anodizing using phosphoric acid as an electrolytic bath described in U.S. Patent 3,511,661 are particularly preferred.
The amount of anodic oxide film is preferably from 1 to 10 g/m². When the amount is less than 1 g/m², the printing plate is apt to be scratched. When the amount exceeds 10 g/m², a large quantity of electric power is necessary and thus it is economically disadvantageous. The amount of anodic oxide film is more preferably from 1.5 to 7 g/m², and still more preferably from 2 to 5 g/m².

The aluminum support may further be subjected to a sealing treatment of the anodic oxide film after the graining treatment and anodizing treatment. The sealing treatment is performed by immersing the aluminum support in hot water or a hot aqueous solution containing an inorganic salt or an organic salt, or in a water vapor bath. Moreover, the aluminum support may be subjected to a surface treatment, for example, silicate treatment with an alkali metal silicate or immersion treatment in an aqueous solution of potassium fluorozirconate, a phosphate or the like.

On a support (in case of an aluminum support, the aluminum support appropriately subjected to the surface treatment as described above is preferred), for example, an image-recording layer comprising a photopolymerizable photosensitive composition is coated and, if desired, a protective layer is coated on the image-recording layer to prepare a lithographic printing plate precursor. In advance of the coating of image-recording layer, an organic or inorganic undercoat layer may be provided on the support, if desired. A sol-gel treatment where a functional group capable of initiating an addition reaction upon a radical is covalently bonded on the surface of support as described in JP-A-7-159983 may be performed.

As a substance for forming the organic undercoat layer, for instance, a water-soluble resin, for example, polyvinylphosphonic acid, a polymer or copolymer having a sulfonic acid group in its side chain or polyacrylic acid, a yellow dye or an amine salt is exemplified.
Specifically, the organic compound used in the organic undercoat layer is selected form, for example, carboxymethyl cellulose, dextrin, gum arabic, a phosphonic acid having an amino group, for example, 2-aminoethylphosphonic acid, an organic phosphonic acid, for example, phenylphosphonic acid, naphthylphosphonic acid, alkylphosphonic acid, glycerophosphonic acid, polyvinylphosphonic acid, methylenediphosphonic acid or ethylenediphosphonic acid, each of which may have a substituent, an organic phosphoric acid, for example, phenylphosphoric acid, naphthylphosphoric acid, alkylphosphoric acid or glycerophosphoric acid, each of which may have a substituent, an organic phosphinic acid, for example, phenylplaosphinic acid, naphthylphosphinic acid, alkylphosphinic acid or glycerophosphinic acid, each of which may have a substituent, an amino acid, for example, glycine or β-alanine, and a hydrochloride of amine having a hydroxy group, for example, triethanolamine hydrochloride. The organic compounds may be used as a mixture of two or more thereof.

The organic undercoat layer can be provided by the following methods. Specifically, there are a method of dissolving the organic compound described above in water, an organic solvent, for example, methanol, ethanol or methyl ethyl ketone, or a mixed solvent thereof, coating the resulting solution on a support and drying it to provide the organic undercoat layer, and a method of dissolving the organic compound described above in water, an organic solvent, for example, methanol, ethanol or methyl ethyl ketone, or a mixed solvent thereof, immersing a support in the resulting solution to adsorb the organic compound, washing the support with water or the like, and drying it to provide the organic undercoat layer. In the former method, the solution containing the organic compound in a concentration of 0.005 to 10% by weight can be coated by various methods. Any method including, for example, bar coater coating, spin coating, spray coating or curtain coating may be used. In the latter method, the concentration of the organic compound in the solution is from 0.01 to 20% by weight, preferably from 0.05 to 5% by weight, the immersion temperature is from 20 to 90°C, preferably from 25 to 50°C, and the immersion time is from 0.1 second to 20 minutes, preferably from 2 seconds to 1 minute.
The solution used may also be used by adjusting its pH to a range from 1 to 12 with a basic substance, for example, ammonia, triethylamine or potassium hydroxide or an acidic substance, for example, hydrochloric acid or phosphoric acid. Moreover, a yellow dye may also be added to the solution in order to improve the tone reproducibility of the lithographic printing plate precursor.
The coverage of the organic undercoat layer after drying is suitably from 2 to 200 mg/m², and preferably from 5 to 100 mg/m². When the coverage of the organic undercoat layer is less than 2 mg/m², sufficient printing durability may not be obtained in some cases. When the coverage thereof is more than 200 mg/m², the same problem may also arise.

Examples of the substance used in the inorganic undercoat layer include an inorganic salt, for example, cobalt acetate, nickel acetate or potassium fluorotitanate. The method of providing the inorganic undercoat layer is similar to that of the organic undercoat layer described above.

From the standpoint of increase in printing durability, the undercoat layer preferably contains a polymer or copolymer having any one of a phosphoric acid group, a phosphoric acid group and a sulfonic acid group in its side chain. In case of the copolymer, it contains a polymerization component having such a group preferably from 10 to 90% by mole, and more preferably from 20 to 50% by mole. Further, the copolymer preferably contains an ethylenically unsaturated bond in its side chain. The copolymer contains a polymerization component having the ethylenically unsaturated bond preferably from 10 to 90% by mole, and more preferably from 15 to 40% by mole.

### [Image-recording layer]

The image-recording layer (hereinafter, also referred to as a photosensitive layer) of the lithographic printing plate precursor for use in the invention contains as the essential components, (i) a sensitizer, (ii) a photopolymerization initiator, (iii) an addition polymerizable compound having an ethylenically unsaturated double bond and (iv) a binder polymer.

### [Sensitizer]

The sensitizer for use in the invention is a dye capable of transmitting the energy of laser beam absorbed to a photopolymerization initiator with energy transfer or electron transfer.
An absorption wavelength of the sensitizer is not particularly restricted as long as the sensitizer has the above-described function. The sensitizer is appropriately selected depending on a wavelength of laser used for the exposure. In the invention, particularly, a sensitizer having an absorption maximum in a wavelength range of 360 to 450 nm or an infrared absorbing agent is preferably used.

### [Sensitizer having absorption maximum in wavelength range of 360 to 450 nm]

Such sensitizers include, for example, merocyanine dyes represented by formula (2) shown below, benzopyrans or coumarins represented by formula (3) shown below, aromatic ketones represented by formula (4) shown below and anthracenes represented by formula (5) shown below.

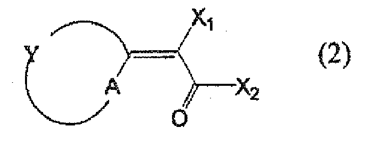

(in formula (2), A represents a sulfur atom or NR₆, R₆ represents a monovalent non-metallic atomic group, Y represents a non-metallic atomic group necessary for forming a basic nucleus of the dye together with adjacent A and the adjacent carbon atom, and X₁ and X₂ each independently represents a monovalent non-metallic atomic group or X₁ and X₂ may be combined with each other to form an acidic nucleus of the dye.)

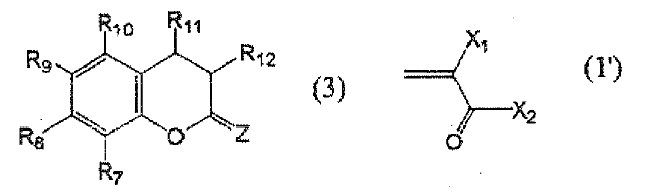

(in formula (3), =Z represents an oxo group, a thioxo group, an imino group or an alkylydene group represented by the partial structural formula (1') described above, X₁ and X₂ have the same meanings as defined in formula (2) respectively, and R₇ to R₁₂ each independently represents a monovalent non-metallic atomic group.)

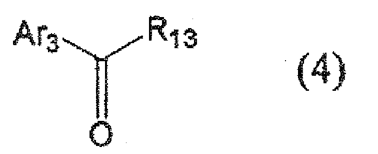

(in formula (4), Ar₃ represents an aromatic group which may have a substituent or a heteroaromatic group which may have a substituent, and R₁₃ represents a monovalent non-metallic atomic group. R₁₃ preferably represents an aromatic group or a heteroaromatic group. Ar₃ and R₁₃ may be combined with each other to form a ring.)

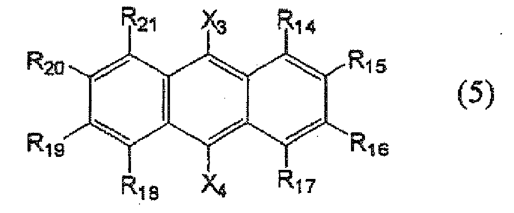

(in formula (5), X₃, X₄ and R₁₄ to R₂₁ each independently represents a monovalent non-metallic atomic group. Preferably, X₃ and X₄ each independently represents an electron-donating group having a negative Hammett substituent constant.)

In formulae (2) to (5), preferable examples of the monovalent non-metallic atomic group represented by any one of X₁ to X₄ and R₆ to R₂₁ include a hydrogen atom, an alkyl group (for example, a methyl group, an ethyl group, a propyl group, a butyl group, a pentyl group, a hexyl group, a heptyl group, an octyl group, a nonyl group, a decyl group, an undecyl group, a dodecyl group, a tridecyl group, a hexadecyl group, an octadecyl group, an eucosyl group, an isopropyl group, an isobutyl group, a see-butyl group, a tert-butyl group, an isopentyl group, a neopentyl group, a 1-methylbutyl groups, an isohexyl group, a 2-ethylhexyl group, a 2-methylhexyl group, a cyclohexyl group, a cyclopentyl group, a 2-norbomyl group, a chloromethyl group, a bromomethyl group, a 2-chloroethyl group, a trifluoromethyl group, a methoxymethyl group, a methoxyethoxyethyl group, an allyloxymethyl group, a phenoxymethyl group, a methylthiomethyl group, a tolylthiomethyl group, an ethylaminoethyl group, a diethylaminopropyl group, a morpholinopropyl group, an acetyloxymethyl group, a benzoyloxymethyl group, an N-cyclohexylcarbamoyloxyethyl group, an N-phenylcarbamoyloxyethyl group, an acetylaminoethyl group, an N-methylbenzoylaminopropyl group, a 2-oxoethyl group, a 2-oxopropyl group, a carboxypropyl group, a methoxycarbonylethyl group, an allyloxycarbonylbutyl group, a chlorophenoxycarbonylmethyl group, a carbamoylmethyl group, an N-methylcarbamoylethyl group, an N,N-dipropylcarbamoylmethyl group, an N-(methoxyphenyl)carbamoylethyl group, an N-mekyl-N-(sulfophenyl)carbamoylmethyl group, a sulfobutyl group, a sulfonatobutyl group, a sulfamoylbutyl group, an N-ethylsulfamoylmethyl group, an N,N-dipropylsulfamoylpropyl group, an N-tolylsulfamoylpropyl group, an N-methyl-N-(phosphonophenyl)sulfamoyloetyl group, a phosphonobutyl group, a phosphonatohexyl group, a diethylphosphonobutyl group, a diphenylphosphonopropyl group, a methylphosphonobutyl group, a methylphosphonatobutyl group, a tolylphosphonohexyl group, a tolylphosphonatohexyl group, a phosphonooxypropyl group, a phosphonatooxybutyl group, a benzyl group, a phenethyl group, an α-methylbenzyl group, a 1-methyl-1-phenylethyl group, a p-methylbenzyl group, a cinnamyl group, an allyl group, a 1-propenylmethyl group, a 2-butenyl group, a 2-methylallyl group, a 2-methylpropenylmethyl group, a 2-propynyl group, a 2-butynyl group or a 3-butynyl group), an aryl group (for example, a phenyl group, a biphenyl group, a naphthyl group, a tolyl group, a xylyl group, a mesityl group, a cumenyl group, a chlorophenyl group, a bromophenyl group, a chloromethylphenyl group, a hydroxyphenyl group, a methoxyphenyl group, an ethoxyphenyl group, a phenoxyphenyl group, an acetoxyphenyl group, a benzoyloxyphenyl group, a methylthiophenyl group, a phenylthiophenyl group, a methylaminophenyl group, a dimethylaminophenyl group, an acetylaminophenyl group, a carboxyphenyl group, a methoxycarbonylphenyl group, an ethoxycarbonylphenyl group, a phenoxycarbonylphenyl group, an N-phenylcarbamoylphenyl group, a nitrophenyl group, a cyanophenyl group, a sulfophenyl group, a sulfonatophenyl group, a phosphonophenyl group or a phosphonatophenyl group), a heteroaryl group (for example, a group derived from a heteroaryl ring, for example, thiophene, thiathrene, furan, pyran, isobenzofuran, chromene, xanthene, phenoxazine, pyrrole, pyrazole, isothiazole, isoxazole, pyrazine, pyrimidine, pyridazne, indolizine, isoindolizine, indole, indazole, purine, quinolizme, isoquinoline, phthalazine, naphthylidine, quinazoline, cinnoline, pteridine, carbazole, carboline, phenanthrine, acridine, perimidine, phenanthroline, phthalazine, phenarsazine, phenoxazine, furazane or phenoxazine), an alkenyl group (for example, a vinyl group, a 1-pxopenyl group, a 1-butenyl group, a cinnamyl group or a 2-chloro-1-ethenyl group), an alkynyl group (for example, an ethynyl group, a 1-propynyl group, a 1-butynyl group or a trimethylsilylethynyl group), a halogen atom (for example, -F, -Br, -Cl or -I), a hydroxy group, an alkoxy group, an aryloxy group, a mercapto group, an alkylthio group, an arylthio group, an alkyldithio group, an aryldithio group, an amino group, an N-alkylamino group, an N,N-dialkylamino group, an N-arylamino group, an N,N-diarylamino group, an N-alkyl-N-arylamino group, an acyloxy group, a carbamoyloxy group, an N-alkylearbamoyloxy group, an N-arylcarbamoyloxy group, an N,N-dialkylcarbamoyloxy group, an N,N-diarylcarbamoyloxy group, an N-alkyl-N-arylcarbamoyloxy group, an alkylsulfoxy group, an arylsulfoxy group, an acylthio group, an acylamino group, an N-alkylacylamino group, an N-arylacylamino group, a ureido group, an N'-alkylureido group, an N',N'-dialkylureido group, an N'-arylureido group, an N',N'-diarylureido group, an N'-alkyl-N'-arylureido group, an N-alkylureido group, an N-arylureido group, an N'-alkyl-N-alkylureido group, an N'-alkyl-N-arylureido group, an N',N'-dialkyl-N-alkylureido group, an N',N'-diaikyl-N-arylureido group, an N'-aryl-N-alkylureido group, an N'-aryl-N-arylureido group, an N',N'-diaryl-N-alkylureido group, an N',N'-diaryl-N-arylureido group, an N'-alkyl-N'-aryl-N-alkylureido group, an N'-alkyl-N'-aryl-N-arylureido group, an alkoxycarbonylamino group, an aryloxycarbonylamino group, an N-alkyl-N-alkoxycarbonylamino group, an N-alkyl-N-aryloxycarbonylamino group, an N-aryl-N-alkoxycarbonylamino group, an N-aryl-N-aryloxycarbonylamino group, a formyl group, an acyl group, a carboxyl group, an alkoxycarbonyl group, an aryloxycarbonyl group, a carbamoyl group, an N-alkylcarbamoyl group, an N,N-dialkylcarbamoyl group, an N-arylcarbamoyl group, an N,N-diarylcarbamoyl group, an N-alkyl-N-arylcarbamoyl group, an alkylsulfinyl group, an arylsulfinyl group, an alkylsulfonyl group, an arylsulfonyl group, a sulfo group (-SO₃H) and its conjugated base group (hereinafter referred to as a "sulfonato group"), an alkoxysulfonyl group, an aryloxysulfonyl group, a sulfinamoyl group, an N-alkylsulfinamoyl group, an N,N-dialkylsulfinamoyl group, an N-arylsulfinamoyl group, an N,N-diarylsulfinamoyl group, an N-alkyl-N-arylsulfinamoyl group, a sulfamoyl group, an N-alkylsulfamoyl group, an N,N-dialkylsulfamoyl group, an N-arylsulfamoyl group, an N,N-diarylsulfamoyl group, an N-alkyl-N-arylsulfamoyl group, a phosphono group (-PO₃H₂) and its conjugated base group (hereinafter referred to as a "phosphonato group"), a diarylphosphono group (-PO₃(alkyl)₂), a diarylphosphono group (-PO₃(aryl)₂), an alkylarylphosphono group (-PO₃(alkyl)(aryl)), a monoalkylphosphono group (-PO₃H(alkyl)) and its conjugated base group (hereinafter referred to as an "alkylphosphonato group"), a monoarylphosphono group (-PO₃H(aryl)) and its conjugated base group (hereinafter referred to as an "arylphosphonato group"), a phosphonooxy group (-OPO₃H₂) and its conjugated base group (hereinafter referred to as a "phosphonatooxy group"), a dialkylphosphonooxy group (-OPO₃(alkyl)₂), a diarylphosphonooxy group (-OPO₃(aryl)₂), an alkylarylphosphonooxy group (-OPO₃(alkyl)(aryl)), a monoalkylphosphonooxy group (-OPO₃H(alkyl)) and its conjugated base group (hereinafter referred to as an "alkylphosphonatooxy group"), a monoarylphosphonooxy group (-OPO₃H(aryl)) and its conjugated base group (hereinafter referred to as an "arylphosphonatooxy group"), a cyano group, a nitro group and the like. Among the above-described monovalent non-metallic atomic groups, a hydrogen atom, an alkyl group, an aryl group, a halogen atom, an alkoxy group and an acyl group are particularly preferred.

The basic nucleus of the dye formed by Y together with the adjacent A and the adjacent carbon atom in formula (2) includes, for example, a 5-membered, 6-membered or 7-membered, nitrogen-containing or sulfur-containing heterocyclic ring, and is preferably a 5-membered or 6-membered heterocyclic ring.

As the nitrogen-containing heterocyclic ring, for example, those which are known to constitute basic nuclei in merocyanine dyes described in L.G. Brooker et al, J. Am. Chem. Soc., Vol. 73, pp. 5326 to 5358 (1951) and references cited therein can be preferably used. Specific examples thereof include thiazoles (for example, thiazole, 4-methylthiazole, 4-phenylthiazole, 5-methylthiazole, 5-phenylthiazole, 4,5-dimethylthiazole, 4,5-diphenylthiazole, 4,5-di(p-methoxyphenyl)thiazole or 4-(2-thienyl)thiazole), benzothiazoles (for example, benzothiazole, 4-chlorobenzothiazole, 5-chlorobenzothiazole, 6-chlorobenzothiazole, 7-chiorobenzothiazole, 4-methylbenzothiazole, 5-methylbenzothiazole, 6-methylbenzothiazole, 5-bromobenzothiazole, 4-phenylbenzothiazole, 5-phenylbenzothiazole, 4-methoxybenzothiazole, 5-methoxybenzothiazole, 6-methoxybenzothiazole, 5-iodobenzothiazole, 6-iodobenzothiazole, 4-ethoxybenzothiazole, 5-ethoxybenzothiazole, tetrahydrobenzothiazole, 5,6-dimethoxybenzothiazole, 5,6-dioxymethylenebenzothiazole, 5-hydroxybenzothiazole, 6-hydroxybenzothiazole, 6-dimethylaminobenzothiazole or 5-ethoxycarbonylbenzothiazole), naphthothiazoles (for example, naphtho[1,2]thiazole, naphtho[2,1]thiazole, 5-methoxynaphtho[2,1]thiazole, 5-ethoxynaphtho[2,1]thiazole, 8-methoxynaphtho[1,2]thiazole or 7-methoxynaphtho[1,2]thiazole), thianaphtheno-7',6',4,5-thiazoles (for example, 4'-methoxythianaphtheno-7',6',4,5-thiazole), oxazoles (for example, 4-methyloxazole, 5-methyloxazole, 4-phenyloxazole, 4,5-diphenyloxazole, 4-ethyloxazole, 4,5-dimethyloxazole or 5-phenyloxazole), benzoxazoles (for example, benzoxazole, 5-chlorobenzoxazole, 5-methylbenzoxazole, 5-phenylbenzoxazole, 6-methylbenzoxazole, 5,6-dimethylbenzoxazole, 4,6-dimethylbenzoxazole, 6-methoxybenzoxazole, 5-methoxybenzoxazole, 4-ethoxybenzoxazole, 5-chlorobenzoxazole, 6-methoxybenzoxazole, 5-hydroxybenzoxazole or 6-hydroxybenzoxazole), naphthoxazoles (for example, naphth[1,2]oxazole or naphth[2,1]oxazole), selenazoles (for example, 4-methylselenazole or 4-phenylselenazole), benzoselenazoles (for example, benzoselenazole, 5-chlorobenzoselenazole, 5-methoxybenzoselenazole, 5-hydroxybenzoselenazole or tetrahydrobenzoselenazole), naphthoselenazoles (for example, naphtho[1,2]selenazole or naphtho[2,1]selenazole), thiazolines (for example, thiazoline or 4-methylthiazoline), quinolines (for example, quinoline, 3-methylquinoline, 5-methylquinoline, 7-methylquinoline, 8-methylquinoline, 6-chloroquinoline, 8-chloroquinoline, 6-methoxyquinoline, 6-ethoxyquinoline, 6-hydroxyquinoline or 8-hydroxyquinoline), isoquinolines (for example, isoquinoline or 3,4-dihydroisoquinoline), benzimidazoles (for example, 1,3-diethylbenzimidazole or 1-ethyl-3-phenylbenzimidazole), 3,3-dialkylindolenines (for example, 3,3-dimethylindolenine, 3,3,5-trimethylindolenine or 3,3,7-trimethylindolenine), pyridines (for example, pyridine or 5-methylpyridine) and the like.

Also, examples of the sulfur-containing heterocyclic ring include dithiol partial structures in dyes described in JP-A-3-296759.
Specific examples thereof include benzodithiols (for example, benzodithiol, 5-tert-butylbenzodithiol or 5-methylbenzodithiol), naphthodithiols (for example, naphtho[1,2]dithiol or naphtho[2,1]dithiol), dithiols (for example, 4,5-dimethyldithiol, 4-phenyldithiol, 4-methoxycarbonyldithiol, 4,5-dimethoxycarbonyldithiol, 4,5-ditrifluoromethyldithiol, 4,5-dicyanodithiol, 4-methoxycarbonylmethyldithiol or 4-carboxymethyldithiol) and the like.

In the description with respect to the heterocyclic ring above, for convenience and by convention, the names of heterocyclic mother skeletons are used. In the case of constituting the basic nucleus partial structure in the sensitizer, the heterocyclic ring is introduced in the form of a substituent of alkylydene type where a degree of unsaturation is decreased one step. For example, a benzothiazole skeleton is introduced as a 3-substituted-2(3H)-benzothiazolilydene group.

Of the sensitizers having an absorption maximum in a wavelength range of 350 to 450 man, more preferable sensitizers in view of high sensitivity are sensitizers represented by formula (1) shown below.

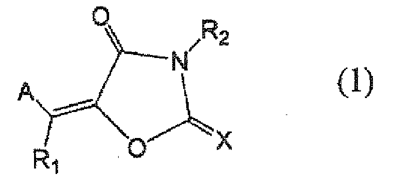

(in formula (1), A represents an aromatic ring which may have a substituent or a heterocyclic ring which may have a substituent, X represents an oxygen atom, a sulfur atom or N-(R₃), and R₁, R₂ and R₃ each independently represents a monovalent non-metallic atomic group, or A and R₁ or R₂ and R₃ may be combined with each other to form an aliphatic or aromatic ring.)

The formulae (1) will be described in more detail below. R₁, R₂ and R₃ each independently represents a monovalent non-metallic atomic group, preferably a substituted or unsubstituted alkyl group, a substituted or unsubstituted alkenyl group, a substituted or unsubstituted aryl group, a substituted or unsubstituted aromatic heterocyclic residue, a substituted or unsubstituted alkoxy group, a substituted or unsubstituted alkylthio group, a hydroxy group or a halogen atom.

Preferable examples of R₁, R₂ and R₃ will be specifically described below. Preferable examples of the alkyl group include a straight chain, branched or cyclic alkyl group having from 1 to 20 carbon atoms. Specific examples thereof include a methyl group, an ethyl group, a propyl group, a butyl group, a pentyl group, a hexyl group, a heptyl group, an octyl group, a nonyl group, a decyl group, an undecyl group, a dodecyl group, a tridecyl group, a hexadecyl group, an octadecyl group, an eucosyl group, an isopropyl group, an isobutyl group, a sec-butyl group, a tert-butyl group, an isopentyl group, a neopentyl group, a 1-methylbutyl group, an isohexyl group, a 2-ethylhexyl group, a 2-methylhexyl group, a cyclohexyl group, a cyclopentyl group and a 2-norbomyl group. Among them, a straight chain alkyl group having from 1 to 12 carbon atoms, a branched alkyl group having from 3 to 12 carbon atoms and a cyclic alkyl group having from 5 to 10 carbon atoms are more preferred.

As the substituent for the substituted alkyl group, a monovalent non-metallic atomic group exclusive of a hydrogen atom is used. Preferable examples thereof include a halogen atom (for example, -F, -Br, -Cl or -I), a hydroxy group, an alkoxy group, an aryloxy group, a mercapto group, an alkylthio group, an arylthio group, an alkyldithio group, an aryldithio group, an amino group, an N-alkylamino group, an N,N-dialkylamino group, an N-acylamino group, an N,N-diarylamino group, an N-alkyl-N-arylamino group, an acyloxy group, a carbamoyloxy group, an N-alkylcarbamoyloxy group, an N-arylcarbamoyloxy group, an N,N-dialkylcarbamoyloxy group, an N,N-diarylcarbamoyloxy group, an N-akyl-N-arylcarbanoyloxy group, an alkylsulfoxy group, an arylsulfoxy group, an acylthio group, an acylamino group, an N-alkylacylamino group, an N-arylacylamino group, a ureido group, an N'-alkylureido group, an N',N'-dialkylureido group,

an N'-arylureido group, an N',N'-diarylureido group, an N'-alkyl-N'-arylureido group, an N-alkylureido group, an N-arylureido group, an N'-alkyl-N-alkylureido group, an N'-alkyl-N-arylureido group, an N',N'-dialkyl-N-alkylureido group, an N',N'-dialkyl-N-arylureido group, an N'-aryl-N-alkylureido group, an N'-aryl-N-arylureido group, an N',N'-diaryl-N-alkylureido group, an N',N'-diaryl-N-arylureido group, an N'-alkyl-N'-aryl-N-alkylureido group, an N'-alkyl-N'-aryl-N-arylureido group, an alkoxycarbonylamino group, an aryloxycarbonylamino group, an N-alkyl-N-alkoxycarbonylamino group, an N-alkyl-N-aryloxycarbonylamino group, an N-aryl-N-alkoxycarbonylamino group, an N-aryl-N-aryloxycarbonylamino group, an acyl group, a carboxyl group,

an alkoxycarbonyl group, an aryloxycarbonyl group, a carbamoyl group, an N-alkylcarbamoyl group, an N,N-dialkylcarbamoyl group, an N-arylcarbamoyl group, an N,N-diarylcarbamoyl group, an N-alkyl-N-arylcarbamoyl group, an alkylsulfinyl group, an arylsulfinyl group, an alkylsulfonyl group, an arylsulfonyl group, a sulfo group (-SO₃H) and its conjugated base group (hereinafter referred to as a "sulfonato group"), an alkoxysulfonyl group, an aryloxysulfonyl group, a sulfinamoyl group, an N-alkylsulfinamoyl group, an N,N-dialkylsulfinamoyl group, an N-arylsulfinamoyl group, an N,N-diarylsulfinamoyl group, an N-alkyl-N-arylsulfinamoyl group, a sulfamoyl group, an N-alkylsulfamoyl group, an N,N-dialkylsulfamoyl group, an N-arylsulfamoyl group, an N,N-diarylsulfamoyl group, an N-alkyl-N-arylsulfamoyl group, a phosphono group (-PO₃H₂) and its conjugated base group (hereinafter referred to as a "phosphonato group"),

a dialkylphosphono group (-PO₃(akyl)₂), a diarylphosphono group (-PO₃(aryl)₂), an alkylarylphosphono group (-PO₃(alkyl)(aryl)), a monoalkylphosphono group (-PO₃H(alkyl)) and its conjugated base group (hereinafter referred to as an "alkylphosphonato group"), a monoarylphosphono group (-PO₃H(aryl)) and its conjugated base group (hereinafter referred to as an "arylphosphonato group"), a phosphonooxy group (-OPO₃H₂) and its conjugated base group (hereinafter referred to as a "phosphonatooxy group"), a dialkylphosphonooxy group (-OPO₃(alkyl)₂), a diarylphosphonooxy group (-OPO₃(aryl)₂), an alkylarylphosphonooxy group (-OPO₃(alkyl)(aryl)), a monoalkylphosphonooxy group (-OPO₃H(alkyl)) and its conjugated base group (hereinafter referred to as an "alkylphosphonatooxy group"), a monoarylphosphonooxy group (-OPO₃H(aryl)) and its conjugated base group (hereinafter referred to as an "arylphosphonatooxy group"), a cyano group, a nitro group, an aryl group, a heteroaryl group, an alkenyl group and an alkynyl group.

In the substituents, specific examples of the alkyl group include those described for the alkyl group above. Specific examples of the aryl group include a phenyl group, a biphenyl group, a naphthyl group, a tolyl group, a xylyl group, a mesityl group, a cumenyl group, a chlorophenyl group, a bromophenyl group, a chloromethylphenyl group, a hydroxyphenyl group, a methoxyphenyl group, an ethoxyphenyl group, a phenoxyphenyl group, an acetoxyphenyl group, a benzoyloxyphenyl group, a methylthiophenyl group, a phenylthiophenyl group, a methylaminophenyl group, a dimethylaminophenyl group, an acetylaminophenyl group, a carboxyphenyl group, a methoxycarbonylphenyl group, an ethoxycarbonylphenyl group, a phenoxycarbonylphenyl group, an N-phenylcarbamoylphenyl group, a nitrophenyl group, a cyanophenyl group, a sulfophenyl group, a sulfonatophenyl group, a phosphonophenyl group and a phosphonatophenyl group.

Examples of the heteroaryl group include a monocyclic or polycyclic aromatic cyclic group containing at least one of a nitrogen atom, an oxygen atom and a sulfur atom. Examples of especially preferable heteroaryl group include a group derived from a heteroaryl ring, for example, thiophene, thiathrene, furan, pyran, isobenzofuran, chromene, xanthene, phenoxazine, pyrrole, pyrazole, isothiazole, isoxazole, pyrazine, pyrimidine, pyridazine, indolizine, isoindolizine, indole, indazole, purine, quinolizine, isoquinoline, phthalazine, naphthylidine, quinazoline, cinnoline, pteridine, carbazole, carboline, phenanthrene, acridine, perimidine, phenanthroline, phthalazine, phenarsazine, phenoxazine, furazane or phenoxazine. These groups may be benzo-fused or may have a substituent.

Examples of the alkenyl group include a vinyl group, a 1-propenyl group, a 1-butenyl group, a cinnamyl group and a 2-chloro-1-ethenyl group. Examples of the alkynyl group include an ethynyl group, a 1-propynyl group, a 1-butynyl group and a trimethylsilylethynyl group. Examples of G₁ in the acyl group (G₁CO-) include a hydrogen atom and the above-described alkyl group and aryl group. Of the substituents, a halogen atom (for example, -F, -Br, -Cl or -I), an alkoxy group, an aryloxy group, an alkylthio group, an arylthio group, an N-alkylamino group, an N,N-dialkylamino group, an acyloxy group, an N-alkylcarbamoyloxy group, an N-arylcarbamoyloxy group, an acylamino group, a formyl group, an acyl group, a carboxyl group, an alkoxycarbonyl group, an aryloxycarbonyl group, a carbamoyl group, an N-alkylcarbamoyl group, an N,N-dialkylcarbamoyl group, an N-arylcarbamoyl group, an N-alkyl-N-arylcarbamoyl group, a sulfo group, a sulfonato group, a sulfamoyl group, an N-alkylsulfamoyl group, an N,N-dialkylsulfamoyl group, an N-arylsulfamoyl group, an N-alkyl-N-arylsulfamoyl group, a phosphono group, a phosphonato group, a dialkylphosphono group, a diarylphosphono group, a monoalkylphosphono group, an alkylphosphonato group, a monoarylphosphono group, an arylphosphonato group, a phosphonooxy group, a phosphonatooxy group, an aryl group and an alkenyl group are more preferable.

On the other hand, as an alkylene group in the substituted alkyl group, a divalent organic residue resulting from elimination of any one of hydrogen atoms on the above-described alkyl group having from 1 to 20 carbon atoms can be enumerated. Examples of preferable alkylene group include a straight chain alkylene group having from 1 to 12 carbon atoms, a branched alkylene group having from 3 to 12 carbon atoms and a cyclic alkylene group having from 5 to 10 carbon atoms.

Specific examples of the preferable substituted alkyl group represented by any one of R₁, R₂ and R₃, which is obtained by combining the above-described substituent with the alkylene group, include a chloromethyl group, a bromomethyl group, a 2-chloroethyl group, a trifluoromethyl group, a methoxymethyl group, a methoxyethoxyethyl group, an allyloxymethyl group, a phenoxymethyl group, a methylthiomethyl group, a tolylthiomethyl group, an ethylaminoethyl group, a diethylaminopropyl group, a morpholinopropyl group, an acetyloxymethyl group, a benzoyloxymethyl group, an N-cyclohexylcarbamoyloxyethyl group, an N-phenylcarbamoyloxyethyl group, an acetylaminoethyl group, an N-methylbenzoylaminopropyl group, a 2-oxoethyl group, a 2-oxopropyl group, a carboxypropyl group, a methoxycarbonylethyl group, an allyloxycarbonylbutyl group, a chlorophenoxycarbonylmethyl group, a carbamoylmethyl group, an N-methylcarbamoylethyl group, an N,N-dipropylcarbamoylmethyl group, an N-(methoxyphenyl)carbamoylethyl group, an N-methyl-N-(sulfophenyl)carbamoylmethyl group,

a sulfobutyl group, a sulfonatobutyl group, a sulfamoylbutyl group, an N-ethylsulfamoylmethyl group, an N,N-dipropylsulfamoylpropyl group, an N-tolylsulfamoylpropyl group, an N-methyl-N-(phosphonophenyl)sulfamoyloctyl group, a phosphonobutyl group, a phosphonatohexyl group, a diethylphosphonobutyl group, a diphenylphosphonopropyl group, a methylphosphonobutyl group, a methylphosphonatobutyl group, a tolylphosphonohexyl group, a tolylphosphonatohexyl group, a phosphonooxypropyl group, a phosphonatooxybutyl group, a benzyl group, a phenethyl group, an α-methylbenzyl group, a 1-methyl-1-phenylethyl group, a p-methylbenzyl group, a cinnamyl group, an allyl group, a 1-propenylmethyl group, a 2-butenyl group, a 2-methylallyl group, a 2-methylpropenylmethyl group, a 2-propynyl group, a 2-butynyl group and a 3-butynyl group.

Preferable examples of the aryl group represented by any one of R₁, R₂ and R₃ include a fused ring formed from one to three benzene rings and a fused ring formed from a benzene ring and a 5-membered unsaturated ring. Specific examples thereof include a phenyl group, a naphthyl group, an anthryl group, a phenanthryl group, an indenyl group, an acenaphthenyl group and a fluorenyl group. Among them, a phenyl group and a naphthyl group are more preferable.

Specific examples of the preferable substituted aryl group represented by any one of R₁, R₂ and R₃ include aryl groups having a monovalent non-metallic atomic group exclusive of a hydrogen atom as a substituent on the ring-forming carbon atom of the above-described aryl group. Preferable examples of the substituent include the above-described alkyl groups and substituted alkyl groups, and the substituents described for the above-described substituted alkyl group. Specific examples of the preferable substituted aryl group include a biphenyl group, a tolyl group, a xylyl group, a mesityl group, a cumenyl group, a chlorophenyl group, a bromophenyl group, a fluorophenyl group, a chloromethylphenyl group, a trifluoromethylphenyl group, a hydroxyphenyl group, a methoxyphenyl group, a methoxyethoxyphenyl group, an allyloxyphenyl group, a phenoxyphenyl group, a methylthiophenyl group, a tolylthiophenyl group, an ethylaminophenyl group, a diethylaminophenyl group, a morpholinophenyl group, an acetyloxyphenyl group, a benzoyloxyphenyl group, an N-cyclohexylcarbamoyloxyphenyl group, an N-phenylcarbamoyloxyphenyl group,

an acetylaminophenyl group, an N-methylbenzoylaminophenyl group, a carboxyphenyl group, a methoxycarbonylphenyl group, an allyloxycarbonylphenyl group, a chlorophenoxycarbonylphenyl group, a carbamoylphenyl group, an N-methylcarbamoylphenyl group, an N,N-dipropylcarbamoylphenyl group, an N-(methoxyphenyl)carbamoylphenyl group, an N-methyl-N-(sulfophenyl)carbamoylphenyl group, a sulfophenyl group, a sulfonatophenyl group, a sulfamoylphenyl group, an N-ethylsulfamoylphenyl group, an N,N-dipropylsulfamoylphenyl group, an N-tolylsulfamoylphenyl group, an N-methyl-N-(phosphonophenyl)sulfamoylphenyl group, a phosphonophenyl group, a phosphonatophenyl group, a diethylphosphonophenyl group, a diphenylphosphonophenyl group, a methylphosphonophenyl group, a methylphosphonatophenyl group, a tolylphosphonophenyl group, a tolylphosphonatophenyl group, an allylphenyl group, a 1-propenylmethylphenyl group, a 2-butenylphenyl group, a 2-methylallylphenyl group, a 2-methylpropenylphenyl group, a 2-propynylphenyl group, a 2-butynylphenyl group, a 3-butynylphenyl group and the like.

Examples of the preferable substituted or unsubstituted alkenyl group and the preferable substituted or unsubstituted aromatic heterocyclic residue represented by any one of R₁, R₂ and R₃ include those described with respect to the alkenyl group and heteroaryl group above, respectively.

Next, A in formula (1) will be described below. A represents an aromatic cyclic group which may have a substituent or heterocyclic group which may have a substituent. Specific examples of the aromatic cyclic group which may have a substituent and heterocyclic group which may have a substituent include those described with respect to the aryl group and heteroaryl group for any one of R₁, R₂ and R₃ in formula (1).

The sensitizer represented by formula (1) according to the invention is obtained by a condensation reaction of the above-described acidic nucleus or an active methylene group-containing acidic nucleus with a substituted or unsubstituted, aromatic ring or hetero ring. Specifically, it can be synthesized with reference to the description of JP-B-59-28329.

Preferable specific examples (D1) to (D42) of the compound represented by formula (1) are set forth below. Further, when isomers with respect to a double bond connecting an acidic nucleus and a basic nucleus are present in each of the compounds, the invention should not be construed as being limited to any one of the isomers.

Since the sensitizer has a different extinction coefficient depending on the structure thereof, the amount of the sensitizer added is varied according to the structure of the sensitizer used. The amount thereof is suitably an amount in that absorbance of the photosensitive layer at a laser emitting wavelength is 0.6 or less, preferably in a range from 0.05 to 0.55, more preferably in a range from 0.1 to 0.3, and still more preferably in a range form 0.1 to 0.45.

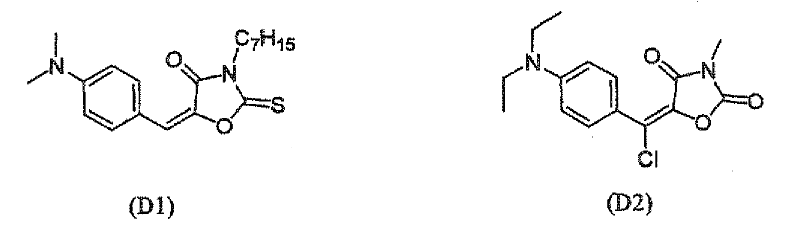

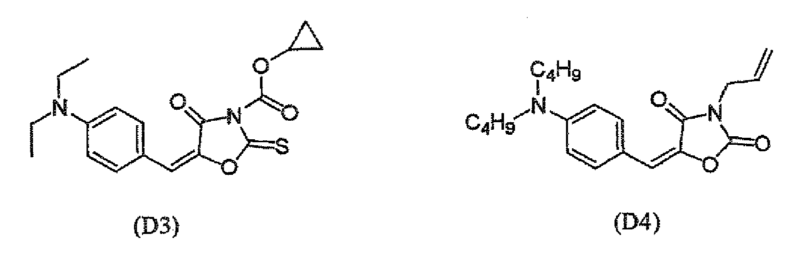

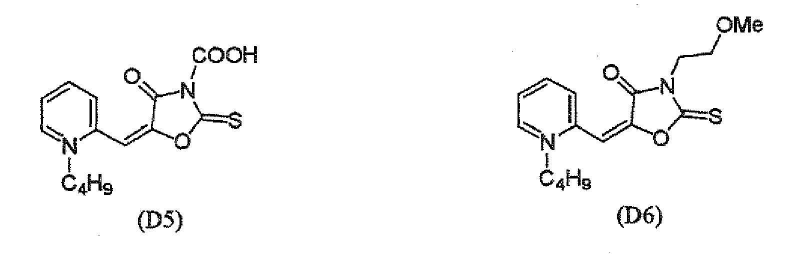

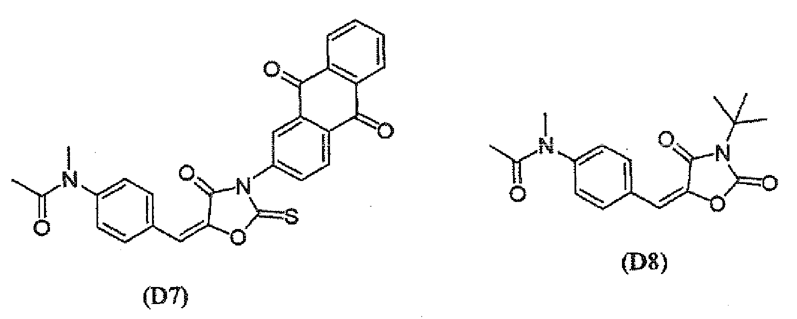

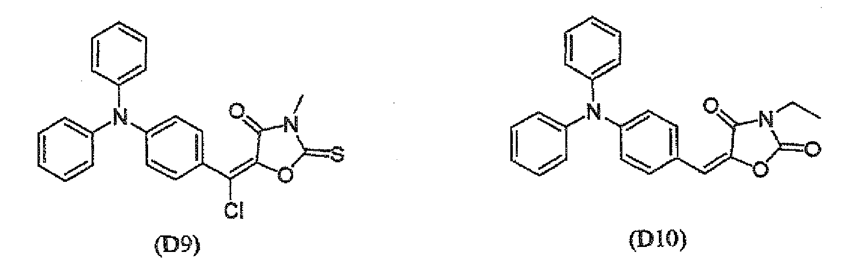

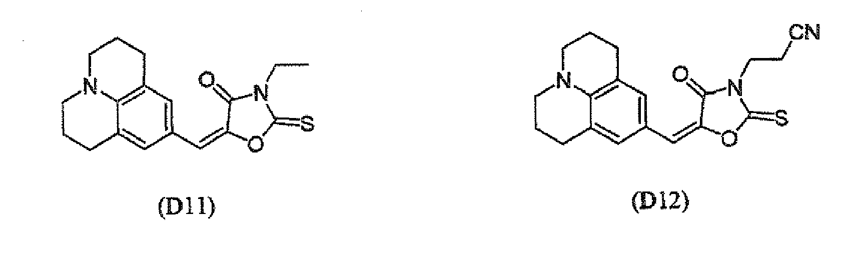

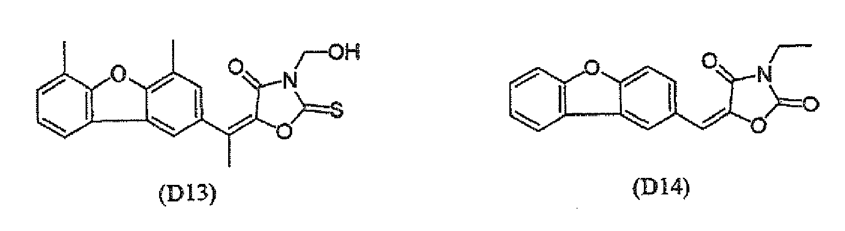

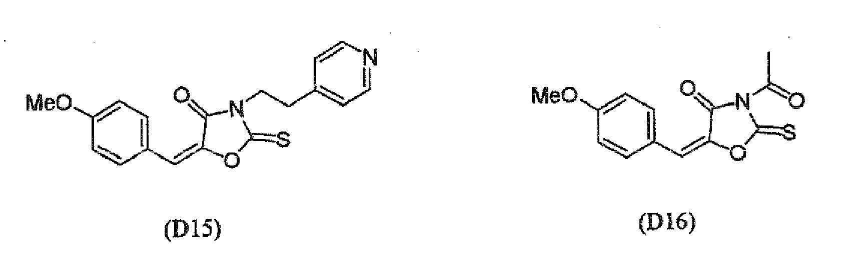

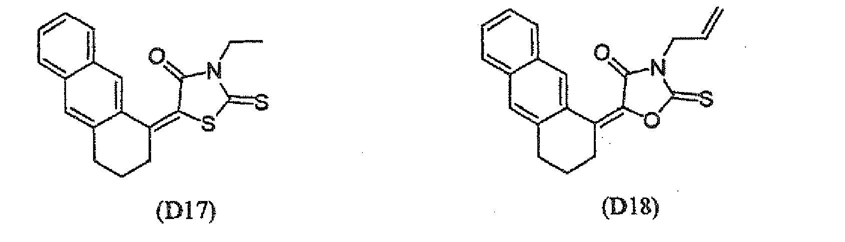

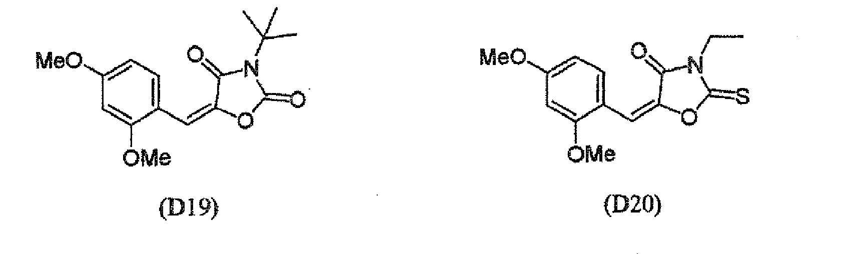

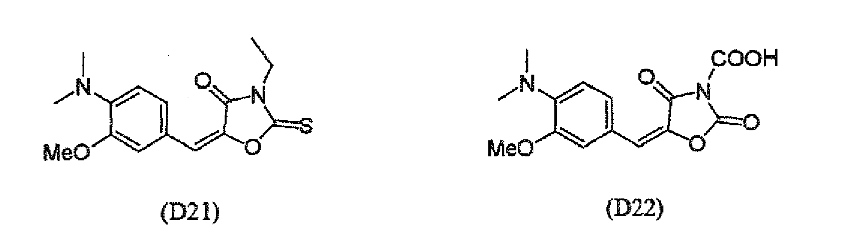

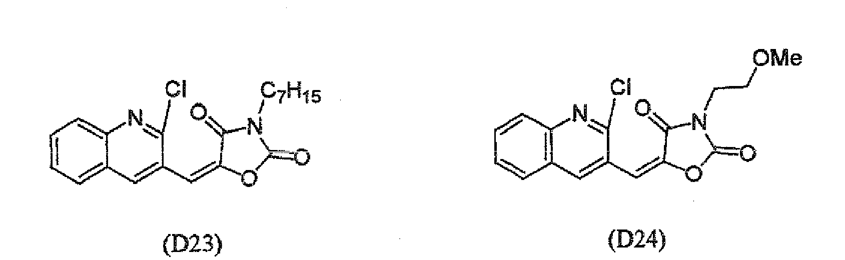

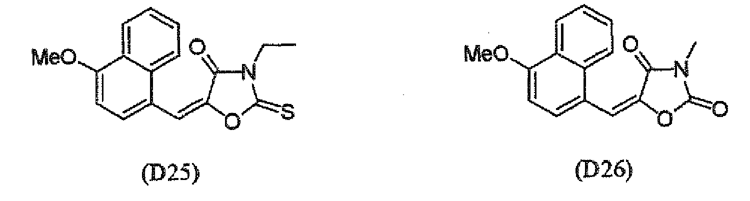

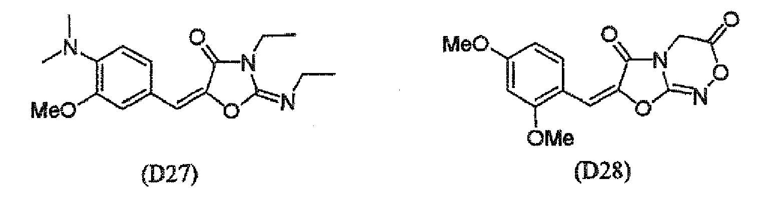

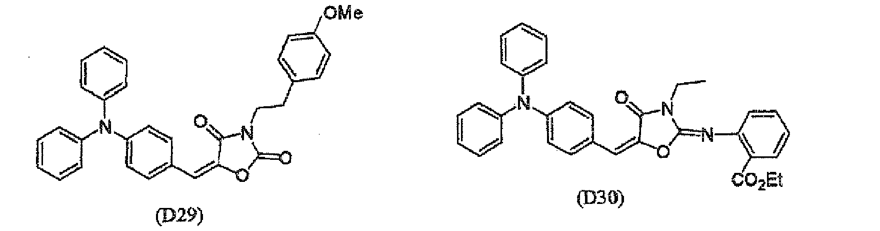

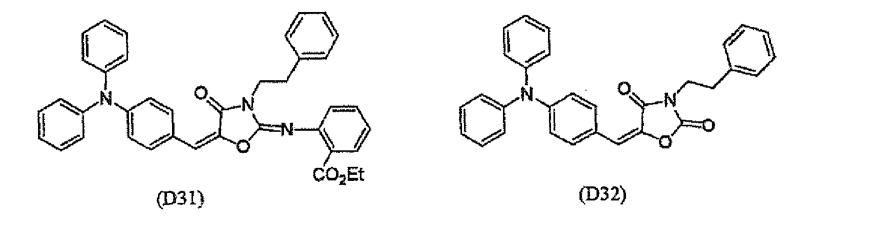

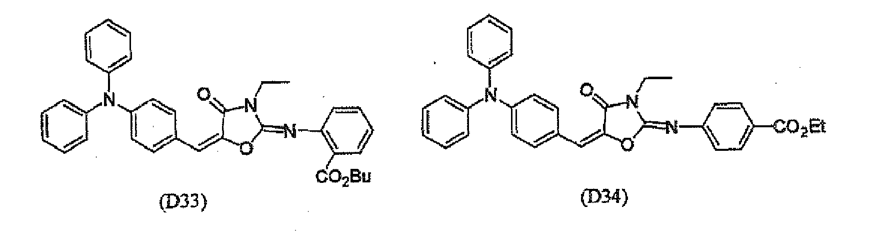

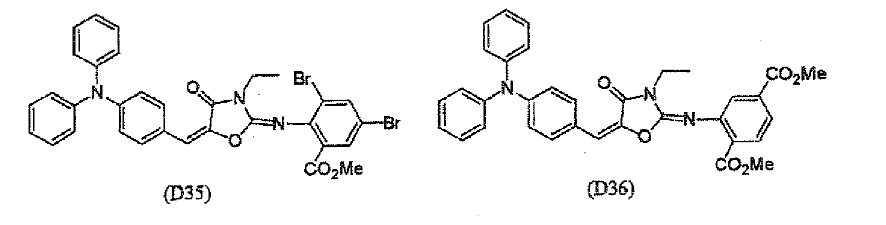

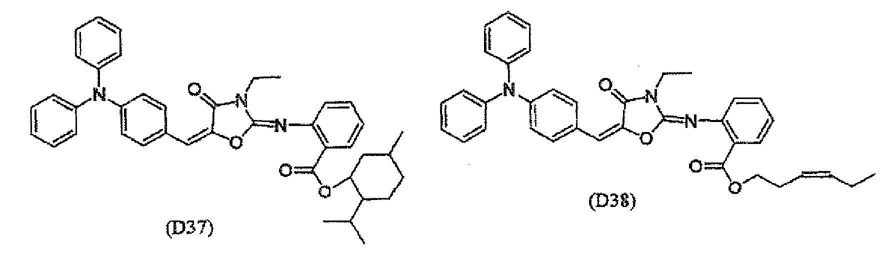

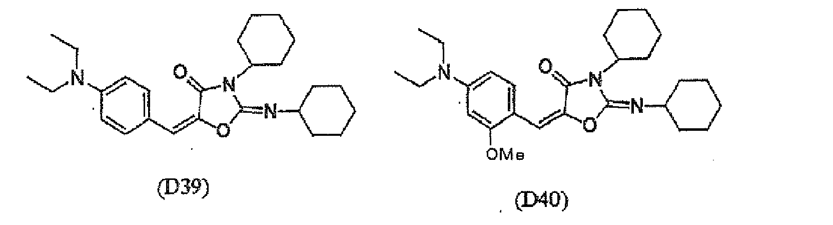

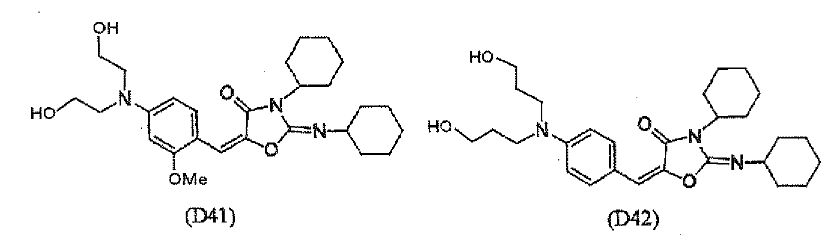

### [Infrared absorbing agent]

The infrared absorbing agent for use in the invention is a component used for increasing sensitivity to near-infrared to infrared laser. The infrared absorbing agent has a function of converting the infrared ray absorbed to heat and is also referred to as an infrared absorbing agent. However, a mechanism where the energy absorbed by the infrared absorbing agent is energy transferred to a polymerization initiator to initiate polymerization should not be excluded. The infrared absorbing agent for use in the invention is preferably a dye or pigment having an absorption maximum in a wavelength range of 760 to 1,200 nm.

As the dye absorbing (near)infrared ray, commercially available dyes and known dyes described in literatures, for example, Senryo Binran (Dye Handbook) compiled by The Society of Synthetic Organic Chemistry, Japan (1970) can be used. Specifically, the dyes includes azo dyes, metal complex azo dyes, pyrazolone azo dyes, naphthoquinone dyes, anthraquinone dyes, phthalocyanine dyes, carbonium dyes, quinoneimine dyes, methine dyes, cyanine dyes, squarylium dyes, pyrylium salts and metal thiolate complexes.

Preferable dyes include, for example, cyanine dyes described in JP-A-58-125246, JP-A-59-84356, JP-A-60-78787 and the like, methine dyes described in JP-A-58-173696, JP-A-58-181690, JP-A-58-194595 and the like, naphthoquinone dyes described in JP-A-58-112793, JP-A-58-224793, JP-A-59-48187, JP-A-59-73996, JP-A-60-52940, JP-A-60-63744 and the like, squarylium dyes described in JP-A-58-112792 and the like, and cyanine dyes described in British Patent 434,875.

Also, near infrared absorbing sensitizers described in U.S. Patent 5,156,938 are preferably used. Further, substituted arylbenzo(thio)pyrylium salts described in U.S. Patent 3,881,924, trimethinethiapyrylium salts described in JP-A-57-142645 (U.S. Patent 4,327,169), pyrylium compounds described in JP-A-58-181051, JP-A-58-220143, JP-A-59-41363, JP-A-59-84248, JP-A-59-84249, JP-A-59-146063 and JP-A-59-146061, cyanine dyes described in JP-A-59-216146, pentamethinethiopyrylium salts described in U.S. Patent 4,283,475, and pyrylium compounds described in JP-B-5-13514 and JP-B-5-19702 are also preferably used. Other preferred examples of the dye include near infrared absorbing dyes represented by formulae (I) and (II) in U.S. Patent 4,756,993.

Further, other preferable examples of the infrared absorbing agent include specific indolenine cyanine dyes described in JP-A-2002-278057 as illustrated below.

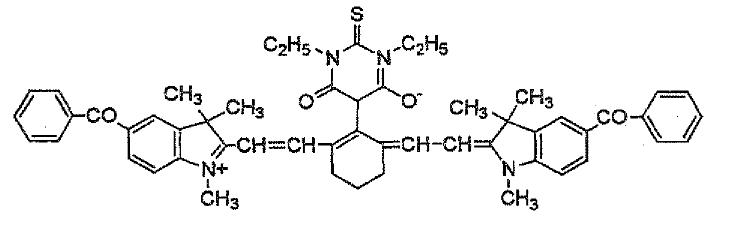

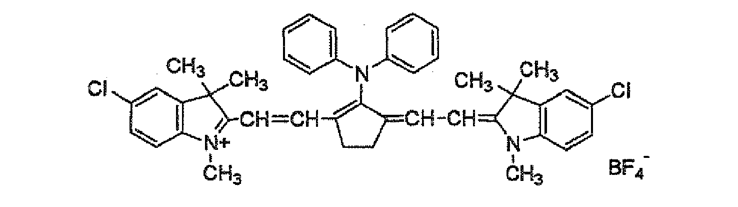

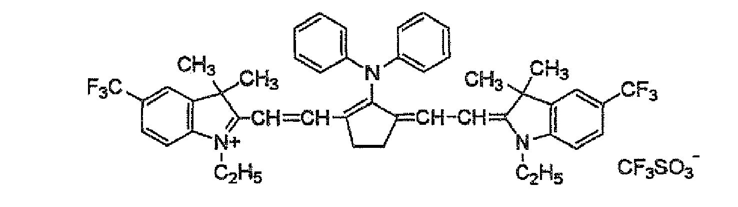

Of the dyes, cyanine dyes, squarylium dyes, pyrylium dyes, nickel thiolate complexes and indolenine cyanine dyes are particularly preferred. Further, cyanine dyes and indolenine cyanine dyes are more preferred. As a particularly preferable example of the dye, a cyanine dye represented by formula (A-I) shown below is exemplified.

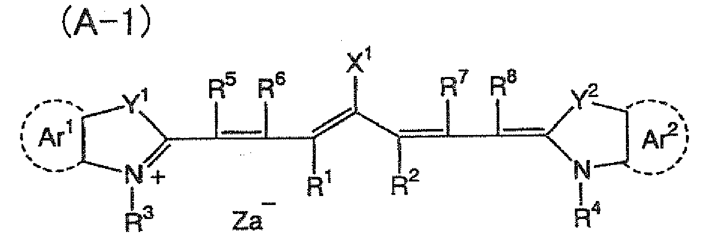

In formula (A-I), X¹ represents a hydrogen atom, a halogen atom, -NPh₂, X²-L¹ or a group represented by structural formula (A-Ia) shown below. X² represents an oxygen atom, N-R³ (R³ represents a hydrogen atom or a monovalent organic group) or a sulfur atom, L¹ represents a hydrocarbon group having from 1 to 12 carbon atoms, an aromatic ring group containing a hetero atom or a hydrocarbon group having from 1 to 12 carbon atoms and containing a hetero atom. The hetero atom indicates here a nitrogen atom, a sulfur atom, an oxygen atom, a halogen atom or a selenium atom. Xa⁻ has the same meaning as Za⁻ defined hereinafter. R^{a} represents a hydrogen atom, an alkyl group, an aryl group, an amino group and a halogen atom. Ph represents a phenyl group in the invention.

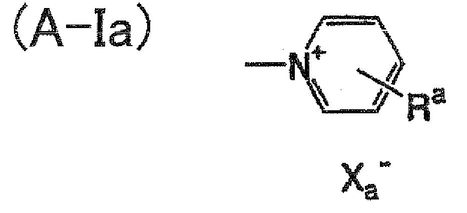

R¹ and R² each independently represents a hydrocarbon group having from 1 to 12 carbon atoms. In view of the preservation stability of a coating solution for photosensitive layer, it is preferred that R¹ and R² each represents a hydrocarbon group having two or more carbon atoms, and it is particularly preferred that R¹ and R² are combined with each other to form a 5-membered or 6-membered ring.

Ar¹ and Ar², which may be the same or different, each represents an aromatic hydrocarbon group. Preferable examples of the aromatic hydrocarbon group include a benzene ring group and a naphthalene ring group. Also, preferable examples of the substituent include a hydrocarbon group having 12 or less carbon atoms, a halogen atom and an alkoxy group having 12 or less carbon atoms. Y¹ and Y², which may be the same or different, each represents a sulfur atom or a dialkylmethylene group having 12 or less carbon atoms. R³ and R⁴, which may be the same or different, each represents a hydrocarbon group having 20 or less carbon atoms, which may have a substituent. Preferable examples of the substituent include an alkoxy group having 12 or less carbon atoms, a carboxyl group and a sulfo group. R⁵, R⁶, R⁷ and R⁸, which may be the same or different, each represents a hydrogen atom or a hydrocarbon group having 12 or less carbon atoms. In view of the availability of raw materials, a hydrogen atom is preferred. Za⁻ represents a counter anion. However, Za⁻ is not necessary when the cyanine dye represented by formula (A-I) has an anionic substituent in the structure thereof and neutralization of charge is not needed. Preferable examples of Za⁻ include a halide ion, a perchlorate ion, a tetrafluoroborate ion, a hexafluorophosphate ion and a sulfonate ion, and particularly preferable examples thereof include a perchlorate ion, a hexafluorophosphate ion and an arylsulfonate ion in view of the preservation stability of a coating solution for photosensitive layer.

Specific examples of the cyanine dye represented by formula (A-I), which can be preferably used in the invention, include those described in Paragraph Nos. [0017] to [0019] of JP-A-2001-133969.
Further, other particularly preferable examples include specific indolenine cyanine dyes described in JP-A-2002-278057 described above.

Examples of the pigment used for the function of light to heat conversion in the invention include commercially available pigments and pigments described in Colour Index (C.I.), Saishin Ganryo Binran (Handbook of the Newest Pigments) compiled by Pigment Technology Society of Japan (1977), Saishin Ganryo Oyou Gijutsu (Newest Application on Technologies for Pigments), CMC Publishing Co., Ltd. (1986) and Insatsu Ink Gijutsu (Printing Ink Technology), CMC Publishing Co., Ltd. (1984).

Examples of the kind of pigment include black pigments, yellow pigments, orange pigments, brown pigments, red pigments, purple pigments, blue pigments, green pigments, fluorescent pigments, metal powder pigments and polymer-bonded dyes. Specific examples of usable pigment include insoluble azo pigments, azo lake pigments, condensed azo pigments, chelated azo pigments, phthalocyanine pigments, anthraquinone pigments, perylene and perynone pigments, thioindigo pigments, quinacridone pigments, dioxazine pigments, isoindolinone pigments, roso pigments, nitro pigments, natural pigments, fluorescent pigments, inorganic pigments and carbon black. Of the pigments, carbon black is preferred.

The pigment may be used without undergoing surface treatment or may be used after the surface treatment. A method of the surface treatment includes a method of coating a resin or wax on the surface, a method of attaching a surfactant, a method of bonding a reactive substance (for example, a silane coupling agent, an epoxy compound or polyisocyanate) to the pigment surface and the like. The surface treatment methods are described in Kinzoku Sekken no Seishitsu to Oyo (Properties and Application of Metal Soap), Saiwai Shobo, Insatsu Ink Gijutsu (Printing Ink Technology), CMC Publishing Co., Ltd. (1984) and Saislain Ganryo Oyo Gijutsu (Newest Application on Technologies for Pigments), CMC Publishing Co., Ltd. (1986).

The particle size of the pigment is preferably in a range from 0.01 to 10 µm, more preferably in a range from 0.05 to 1 µm, and still more preferably in a range from 0.1 to 1 µm. In the range described above, good stability and good uniformity of the pigment dispersion in the photosensitive layer can be obtained.

As a method of dispersing the pigment, known dispersion techniques for use in the production of ink or toner may be used. The dispersing machine includes an ultrasonic dispersing machine, a sand mill, an attritor, a pearl mill, a super-mill, a ball mill, an impeller, a disperser, a KD mill, a colloid mill, a dynatron, a three roll mill, a pressure kneader and the like. The dispersing machines are described in detail in Saishin Ganryo Oyo Gijutsu (Newest Application on Technologies for Pigments), CMC Publishing Co., Ltd. (1986). The infrared absorbing agent may be added by being incorporated into a microcapsule.

With respect to the amount of the infrared absorbing agent added, the amount is so controlled that absorbance of the photosensitive layer at the maximum absorption wavelength in the wavelength region of 760 to 1,200 nm measured by reflection measurement is preferably in a range of 0.1 to 1.5, more preferably in a range of 0.2 to 1.2, still more preferably in a range of 0.3 to 1.0. In the range described above, the polymerization reaction proceeds uniformly in the thickness direction of the photosensitive layer and good film strength of the image area and good adhesion property of the image area to a support are achieved.
The absorbance of the photosensitive layer can be controlled depending on the amount of the infrared absorbing agent added to the photosensitive layer and the thickness of the photosensitive layer. The measurement of the absorbance can be carried out in a conventional manner. The method for measurement includes, for example, a method of forming a photosensitive layer having a thickness determined appropriately in the range necessary for the lithographic printing plate on a reflective support, for example, an aluminum plate, and measuring reflection density of the photosensitive layer by an optical densitometer or a spectrophotometer according to a reflection method using an integrating sphere.

### <Polymerization initiator>

The polymerization initiator for use in the photosensitive layer according to the invention is a light- or heat-polymerization initiator which generates a radical with light or heat energy and a compound which initiates or accelerates polymerization of an ethylenically unsaturated compound. The polymerization initiator is appropriately selected to use from known radical polymerization initiators, compounds containing a bond having small bond dissociation energy and the like.
The polymerization initiators include, for example, organic halogen compounds, carbonyl compounds, organic peroxides, azo compounds, azide compounds, metallocene compounds, hexaarylbiimidazole compounds, organic boron compounds, disulfone compounds, oxime ester compounds and onium salt compounds.

The organic halogen compounds described above specifically include compounds described in Wakabayashi et al., Bull. Chem. Soc. Japan, 42, 2924 (1969), U.S. Patent 3,905,815, JP-B-46-4605, JP-A-48-36281, JP-A-53-133428, JP-A-55-32070, JP-A-60-239736, JP-A-61-169835, JP-A-61-169837, JP-A-62-58241, JP-A-62-212401, JP-A-63-70243, JP-A-63-298339 and M. P. Hutt, Journal of Heterocyclic Chemistry, 1, No. 3 (1970). Among them, oxazole compounds and s-triazine compounds each substituted with a trihalomethyl group are preferred.

More preferably, s-triazine derivatives in which at least one mono-, di- or tri-halogen substituted methyl group is connected to the s-triazine ring and oxazole derivatives in which at least one mono-, di- or tri-halogen substituted methyl group is connected to the oxazole ring are exemplified. Specific examples thereof include 2,4,6-tris(monochloromethyl)-s-triazine, 2,4,6-tris(dichloromethyl)-s-triazine, 2,4,6-tris(trichloromethyl)-s-triazine, 2-methyl-4,6-bis(trichloromethyl)-s-triazine, 2-n-propyl-4,6-bis(trichloromethyl)-s-triazine, 2-(α,α,β-trichloroethyl)-4,6-bis(trichloromethyl)-s-triazine, 2-(3,4-epoxyphenyl)-4,6-bis(trichloromethyl)-s-triazine, 2-[1-(p-methoxyphenyl)-2,4-butadienyl]-4,6-bis(trichloromethyl)-s-triazine, 2-styryl-4,6-bis(trichloromethyl)-s-triazine, 2-(p-methoxystyryl-4,6-bis(trichloromethyl)-s-triazine, 2-(p-isopropyloxystyryl-4,6-bis(trichloromethyl)-s-triazine, 2-(p-tolyl)-4,6-bis(trichloromethyl)-s-triazine, 2-(4-methoxynaphthyl)-4,6-bis(trichloromethyl)-s-triazine, 2-phenylthio-4,6-bis(trichloromethyl)-s-triazine, 2-benzylthio-4,6-bis(trichloromethyl)-s-triazine, 2,4,6-tris(dibromomethyl)-s-triazine, 2,4,6-tris(tribromomethyl)-s-triazine, 2-methyl-4,6-bis(tribromomethyl)-s-triazine, 2-methoxy-4,6-bis(tribromomethyl)-s-triazine and compounds shown below.

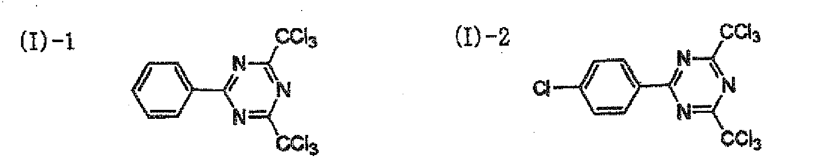

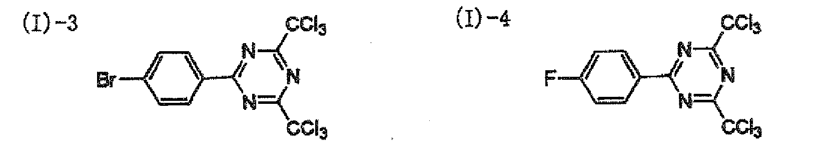

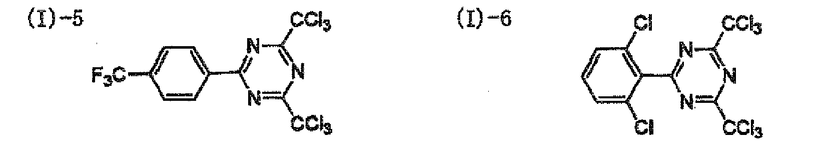

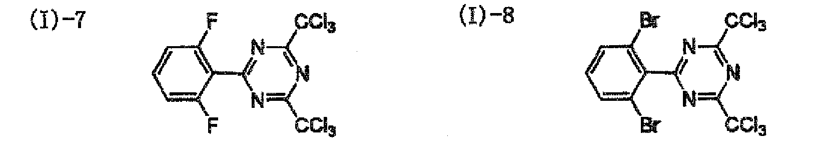

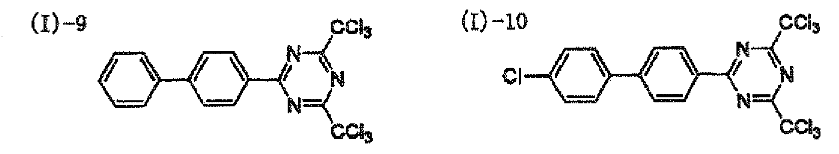

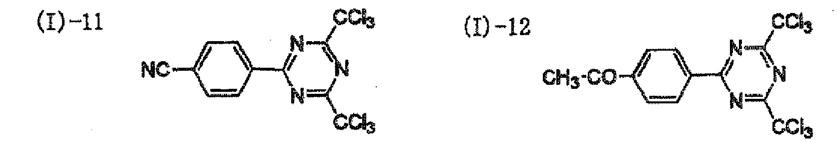

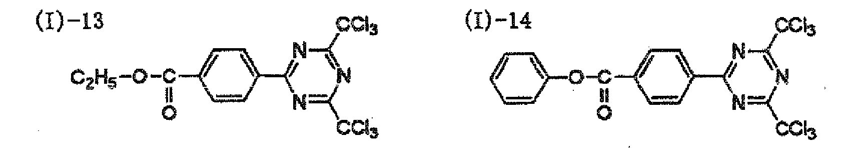

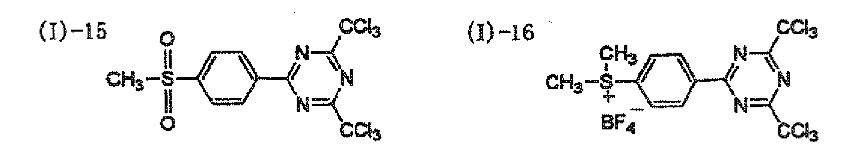

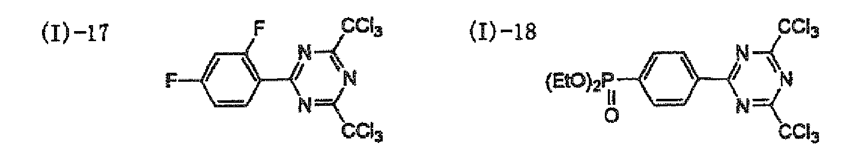

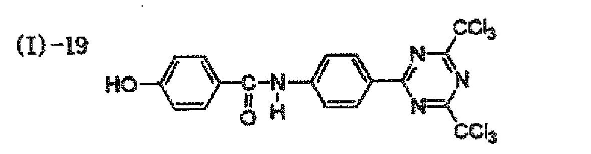

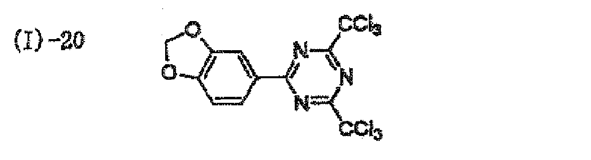

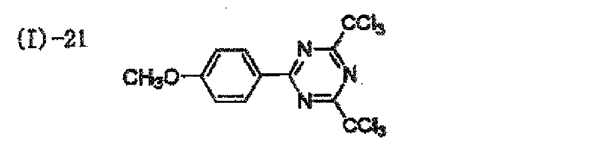

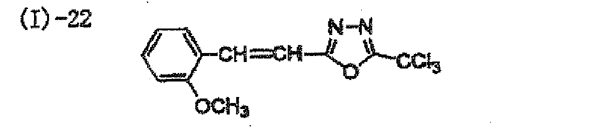

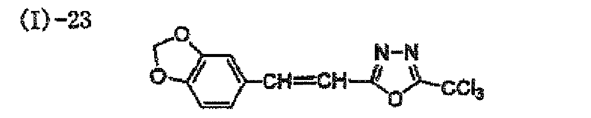

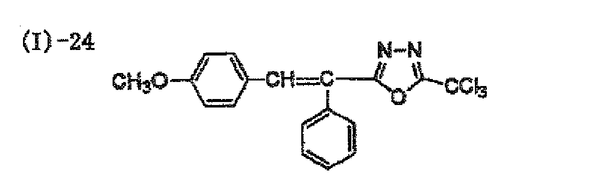

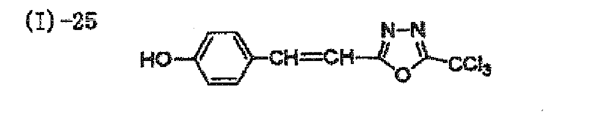

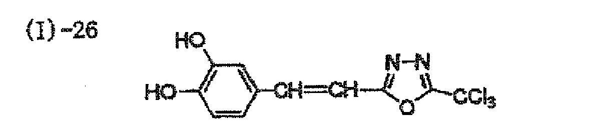

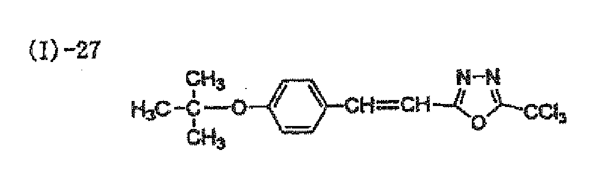

The carbonyl compounds described above include benzophenone derivatives, e.g., benzophenone, Michler's ketone, 2-methylbenzophenone, 3-methylbenzophenone, 4-methylbenzophenone, 2-chlorobeszophenone, 4-bromobenzophenone or 2-carboxybenzophenone, acetophenone derivatives, e.g., 2,2-dimethoxy-2-phenylacetophenone, 2,2-diethoxyacetophenone, 1-hydroxycyclohexylphenylketone, α-hydroxy-2-methylphenylpropane, 1-hydroxy-1-methylethyl-(p-isopropylphenyl)ketone, 1-hydroxy-1-(p-dodecylphenyl)ketone, 2-methyt-(4'-(methylthio)phenyl)-2-morpholino-1-propane or 1,1,1,-trichloromethyl-(p-butylphenyl)ketone, thioxantone derivatives, e.g., thioxantone, 2-ethylthioxantone, 2-isopropylthioxantone, 2-chlorothioxantone, 2,4-dimetylthioxantone, 2,4-dietylthioxantone or 2,4-diisopropylthioxantone, benzoic acid ester derivatives, e.g., ethyl p-dimethylaminobenzoate or ethyl p-diethylaminobenzoate and the like.

As the azo compounds described above, for example, azo compounds described in JP-A-8-108621 and the like are used.

The azide compounds are aromatic azide compounds wherein an azido group is connected directly or through a carbonyl group or a sulfonyl group to an aromatic ring. In the azide compounds, the azido group is decomposed with light to form nitrene which causes various reactions to be insolubilized.
Preferable aromatic azide compounds include compounds having one or more groups such as azidophenyl, azidostyryl, azidobenzal, azidobenzoyl or azidocinnamoyl, for example, 4,4'-diazidocalcon, 4-azido-4'-(4-azidobenzoylethoxy)calcon, N,N-bis-p-azidobenzal-p-phenylenediamine, 1,2,6-tri(4'-azidobenzoxy)hexane, 2-azido-3-chlorobenzoquinone, 2,4-diazido-4'-ethoxyazobenzene, 2,6-di(4'-azidobenzal)-4-methylcyclohexanone, 4,4'-diazidobenzophenone, 2,5-diazido-3,6-dichlorobenzoquinone, 2,5-bis(4-azidostyryl)-1,3,4-oxadiazole, 2-(4-azidocinnamoyl)thiophene, 2,5-di(4'-azido-benzal)cyclohexanone, 4,4'-diazidodiphenylmethane, 1-(4-azidophenyl)-5-furyl-2-penta-2,4-diene-1-one, 1-(4-azidophenyl-5-(4-methoxyphenyl)penta-1,4-diene-3-one, 1-(4-azidophenyl)-3-(1-naphthyl)propene-1-one, 1-(4-azidophenyl)-3-(4-dimethylaminophenyl)propane-1-one, 1-(4-azidophenyl)-5-phenyl-1,4-pentadiene-3-one, 1-(4-azidophenyl)-3-(4-nitrophenyl)-2-propene-1-one, 1-(4-azidophenyl)-3-(2-furyl)-2-propene-1-one, 1,2,6-tri(4'-azidobenzoxy)hexane, 2,6-bis-(4-azidobenzylidine-p-tert-butyl)cyclohexanone, 4,4'-diazidodibenzalacetone, 4,4'-diazidostilbene-2,2'-disulfonic acid, 4'-azidobenzalacetophenone-2-sulfonic acid, 4,4'-diazidostilbene-α-carboxylic acid, di-(4-azido-2'-hydroxybenzal)acetone-2-sulfonic acid, 4-azidobenzalacetophenone-2-sulfonic acid, 2-azido-1,4-dibenzenesulfonylaminonaphthalene, 4,4'-diazidostilbene-2,2'-disulfonic acid anilide and the like.
In addition to these low-molecular weight aromatic azide compounds, azido group-containing polymers described in JP-B-44-9047, JP-B-44-31837, JP-B-45-9613, JP-B-45-24915, JP-B-45-25713, JP-A-50-5102, JP-A-50-84302, JP-A-50-84303 and JP-A-53-12984 are also preferred.

The organic peroxides described above include, for example, trimethylcyclohexanone peroxide, acetylacetone peroxide, 1,1-bis(tert-butylperoxy)-3,3,5-trimethylcyclohexane,1,1-bis(tert-butylperoxy)cyclohexane, 2,2-bis(tert-butylperaxy)butane, tert-butylhydroperoxide, cumene hydroperoxide, diisopropylbenzene hydroperoxide, 2,5-dimethylhexane-2,5-dihydroperoxide, 1,1,3,3-tetramethylbutyl hydroperoxide, tert-butylcumyl peroxide, dicumyl peroxide, 2,5-dimethyl-2,5-di(tert-butylperoxy)hexane, 2,5-oxanoyl peroxide, peroxy succinic acid, benzoyl peroxide, 2,4-dichlorobenzoyl peroxide, diisopropylperoxy dicarbonate, di-2-ethylhexylperoxy dicarbonate, di-2-ethoxyethylperoxy dicarbonate, dimethoxyisopropylperoxy carbonate, di(3-methyl-3-methoxybutyl)peroxy dicarbonate, tert-butylperoxy acetate, tert-butylperoxy pivalate, tert-butylperoxy neodecanoate, tert-butylperoxy octanoate, tert-butylperoxy laurate, 3,3',4,4'-tetra(tert-butylperoxycarbonyl)benzophenone, 3,3',4,4'-tetra(tert-hexylperoxycarbonyl)benzophenone, 3,3',4,4'-tetra(p-isopropylcumylperoxycarbonyl)benzophenone, carbonyl di(tert-butylperoxydihydrogen diphthalate), carbonyl di(tert-hexylperoxydihydrogen diphthalate) and the like.

The metallocene compounds described above include various titanocene compounds described in JP-A-59-152396, JP-A-61-151197, JP-A-63-41484, JP-A-2-249, JP-A-2-4705 and JP-A-5-83588, for example, dicyclopentadienyl-Ti-bisphenyl, dicyclopentadienyl-Ti-bis-2,6-difluorophen-1-yl, dicyclopentadienyl-Ti-bis-2,4-difluorophen-1-yl, dicyclopentadienyl-Ti-bis-2,4,6-trifluorophen-1-yl, dicyclopentadienyl-Ti-bis-2,3,5,6-tetrafluorophen-1-yl, dicyclopentadienyl-Ti-bis-2,3,4,5,6-pentafluorophen-1-yl, dimethylcyclopentadienyl-Ti-bis-2,6-difluorophen-1-yl, dimethylcyclopentadienyl-Ti-bis-2,4,6-trifluorophen-1-yl, dimethylcyclopentadienyl-Ti-bis-2,3,5,6-tetrafluorophen-1-yl, dimethylcyclopentadienyl-Ti-bis-2,3,4,5,6-pentafluorophen-1-yl, or bis(cyclopentadienyl)-bis(2,6-difluoro-3-(pyr-1-yl)phenyl) titanium, iron-arene complexes described in JP-A-1-304453 and JP-A-1-152109 and the like.

The hexaarylbiimidazole compounds described above include various compounds described in JP-B-6-29285 and U.S. Patents 3,479,185, 4,311,783 and 4,622,286, specifically, for example, 2,2'-bis(o-chlorophenyl)-4,4',5,5'-tetraphenylbiimidazole, 2,2'-bis(o-bromophenyl))4,4',5,5,-tetraphenylbiimidazole, 2,2'-bis(o,p-dichlorophenyl)-4,4',5,5'-tetraphenylbiimidazole, 2,2'-bis(o-chlorophenyl)-4,4',5,5'-tetra(m-methoxyphenyl)biimidazole, 2,2'-bis(o,o'-dichlorophenyl)-4,4',5,5'-tetraphenylbiimidazole, 2,2'-bis(o-nitrophenyl)-4,4',5,5'-tetraphenylbiimidazole, 2,2'-bis(o-methylphenyl)-4,4',5,5'-tetraphenylbiimidazole, 2,2'-bis(o-trifluorophenyl)-4,4',5,5'-tetraphenylbiimidazole and the like.

The organic boron compounds described above include, for example, organic boric acid salts described in JP-A-62-143044, JP-A-62-150242, JP-A-9-188685, JP-A-9-188686, JP-A-9-188710, JP-A-2000-131837, JP-A-2002-107916, Japanese Patent 2764769, JP-A-2002-116539, Martin Kunz, Rad Tech '98, Proceeding, April 19-22 (1998), Chicago and the like, organic boron sulfonium complexes or organic boron oxosulfonium complexes described in JP-A-6-157623, JP-A-6-175564 and JP-A-6-175561, organic boron iodonium complexes described in JP-A-6-175554 and JP-A-6-175553, organic boron phosphonium complexes described in JP-A-9-188710, organic boron transition metal coordination complexes described in JP-A-6-348011, JP-A-7-128785, JP-A-7-140589, JP-A-7-306527 and JP-A-7-292014 and the like.

The disulfone compounds described above include compounds described in JP-A-61-166544 and JP-A-2003-328465.

The oxime ester compounds described above include compounds described in J. C. S. Perkin II, 1653-1660 (1979), J. C. S. Perkin II, 156-162 (1979), Journal of Photopolymer Science and Technology, 202-232 (1995), JP-A-2000-66385 and JP-A-2000-80068. Specific examples thereof include compounds represented by the structural formulae shown below.

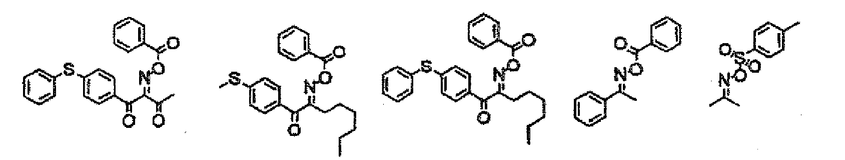

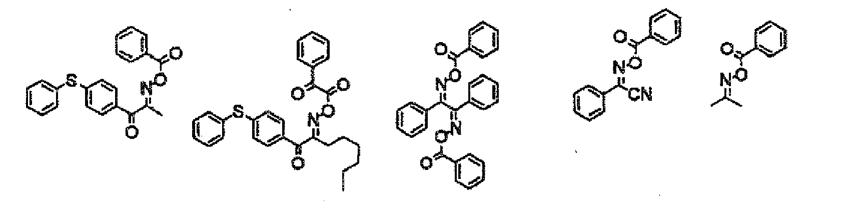

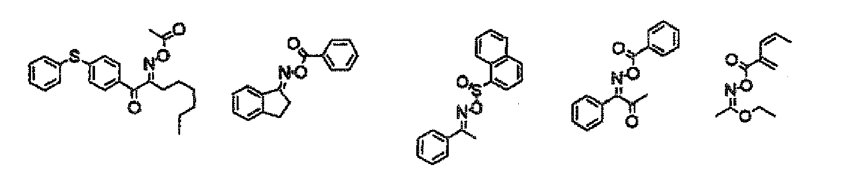

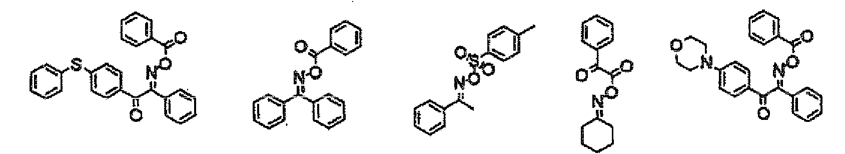

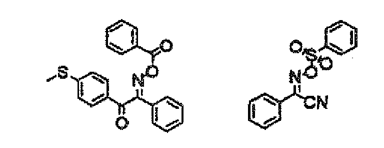

The onium salt compounds described above include, for example, diazonium salts described in S. I. Schlesinger, Photogr. Sci. Eng., 18, 387 (1974) and T. S. Bal et al., Polymer, 21, 423 (1980), ammonium salts described in U.S. Patent 4,069,055 and JP-A-4-365049, phosphonium salts described in U.S. Patents 4,069,055 and 4,069,056, iodonium salts described in European Patent 104,143, U.S. Patents 339,049 and 410,201, sulfonium salts described in 580 and 3,604,581, selenonium salts described in J.V. Crivello et al., Macromolecules, 10 (6), 1307 (1977) and J.V. Crivello et al., J. Polymer Sci., Polymer Chem. Ed., 17, 1047 (1979), and arsonium salts described in C.S. Wen et al., Teh, Proc. Conf. Rad. Curing ASIA, p. 478, Tokyo, Oct. (1988).
In the invention, the onium salt compound functions as an ionic radical polymerization initiator, not as an acid generator.

The onium salt compounds preferably used include onium salts represented by formulae (RI-I) to (RI-III) shown below.

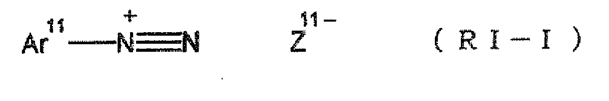

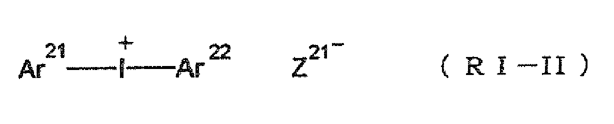

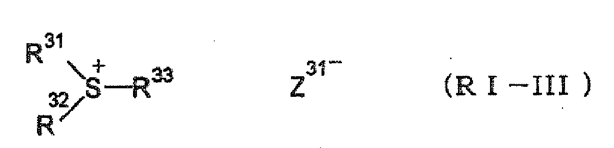

In formula (RI-I), Ar¹¹ represents an aryl group having 20 or less carbon atoms, which may have 1 to 6 substituents. Preferable examples of the substituent include an alkyl group having 12 or less carbon atoms, an alkenyl group having 12 or less carbon atoms, an alkynyl group having 12 or less carbon atoms, an aryl group having 12 or less carbon atoms, an alkoxy group having 12 or less carbon atoms, an aryloxy group having 12 or less carbon atoms, a halogen atom, an alkylamino group having 12 or less carbon atoms, a dialkylimino group having 12 or less carbon atoms, an alkylamido group or arylamido group having 12 or less carbon atoms, a carbonyl group, a carboxyl group, a cyano group, a sulfonyl group, an thioalkyl group having 12 or less carbon atoms and an thioaryl group having 12 or less carbon atoms. Z¹¹⁻ represents a monovalent anion and specifically includes a halide ion, a perchlorate ion, a hexafluorophosphate ion, a tetrafluoroborate ion, a sulfonate ion, a sulfinate ion, a thiosulfonate ion and a sulfate ion. Among them, a perchlorate ion, a hexafluorophosphate ion, a tetrafluoroborate ion, a sulfonate ion and a sulfinate ion are preferred in view of stability.

In the formula (RI-II), Ar²¹ and Ar²² each independently represents an aryl group having 20 or less carbon atoms, which may have 1 to 6 substituents. Preferable examples of the substituent include an alkyl group having 12 or less carbon atoms, an alkenyl group having 12 or less carbon atoms, an alkynyl group having 12 or less carbon atoms, an aryl group having 12 or less carbon atoms, an alkoxy group having 12 or less carbon atoms, an aryloxy group having 12 or less carbon atoms, a halogen atom, an alkylamino group having 12 or less carbon atoms, a dialkylimino group having 12 or less carbon atoms, an alkylamido group or arylamido group having 12 or less carbon atoms, a carbonyl group, a carboxyl group, a cyano group, a sulfonyl group, an thioalkyl group having 12 or less carbon atoms and an thioaryl group having 12 or less carbon atoms. Z²¹⁻ represents a monovalent anion. Specific examples of the monovalent anion include a halide ion, a perchlorate ion, a hexafluorophosphate ion, a tetrafluoroborate ion, a sulfonate ion, a sulfinate ion, a thiosulfonate ion, a sulfate ion and a carboxylate ion. Among them, a perchlorate ion, a hexafluorophosphate ion, a tetrafluoroborate ion, a sulfonate ion, a sulfinate ion and a carboxylate ion are preferred in view of stability and reactivity.

In the formula (RI-III), R³¹, R³² and R³³ each independently represents an aryl group having 20 or less carbon atoms, which may have 1 to 6 substituents, an alkyl group, an alkenyl group or an alkynyl group. Among them, the aryl group is preferred in view of reactivity and stability. Preferable examples of the substituent include an alkyl group having 12 or less carbon atoms, an alkenyl group having 12 or less carbon atoms, an alkynyl group having 12 or less carbon atoms, an aryl group having 12 or less carbon atoms, an alkoxy group having 12 or less carbon atoms, an aryloxy group having 12 or less carbon atoms, a halogen atom, an alkylamino group having 12 or less carbon atoms, a dialkylimino group having 12 or less carbon atoms, an alkylamido group or arylamido group having 12 or less carbon atoms, a carbonyl group, a carboxyl group, a cyano group, a sulfonyl group, an thioalkyl group having 12 or less carbon atoms and an thioaryl group having 12 or less carbon atoms. Z³¹⁻ represents a monovalent anion. Specific examples of the monovalent anion include a halide ion, a perchlorate ion, a hexafluorophosphate ion, a tetrafluoroborate ion, a sulfonate ion, a sulfinate ion, a thiosulfonate ion, a sulfate ion and a carboxylate ion. Among them, a perchlorate ion, a hexafluorophosphate ion, a tetrafluoroborate ion, a sulfonate ion, a sulfinate ion and a carboxylate ion are preferred in view of stability and reactivity. Carboxylate ions described in JP-A-2001-343742 are more preferred, and carboxylate ions described in JP-A-2002-148790 are particularly preferred.
Specific examples of the onium salt represented by any on of formulae (RI-I) to (RI-III) are set forth below, but the invention should not be construed as being limited thereto.

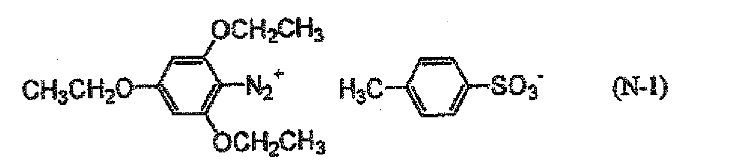

**PF₆⁻** **(N-2)**

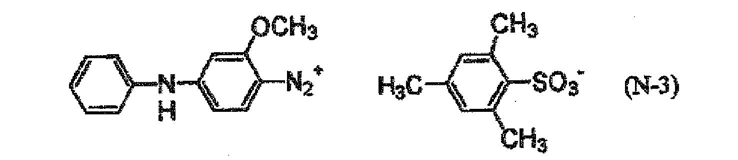

**ClO₄⁻** **(N-4)**

**PF₆⁻** **(N-5)**

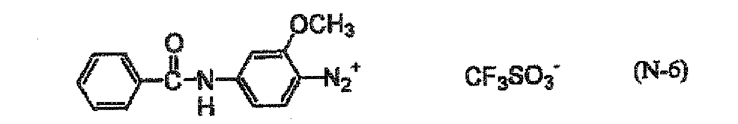

**BF₄⁻** **(N-7)**

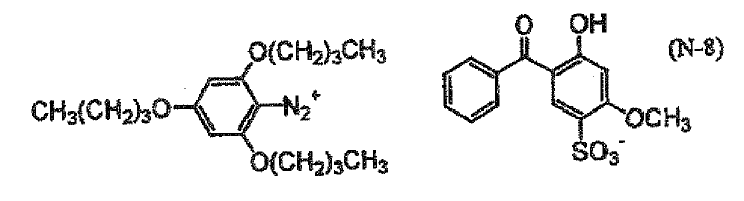

**ClO₄⁻** **(N-9)**

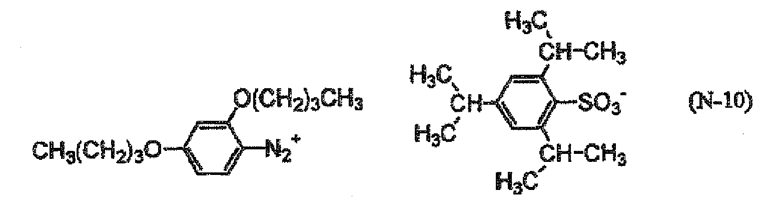

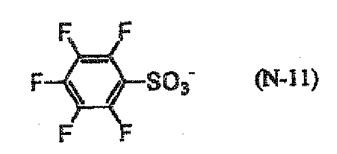

**PF₆⁻** **(N-12)**

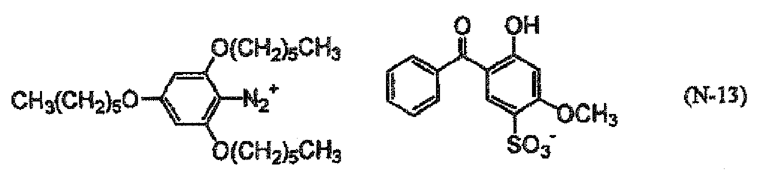

**ClO₄⁻** **(N-14)**

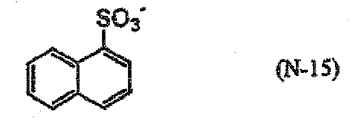

**PF₆⁻** **(N-16)**

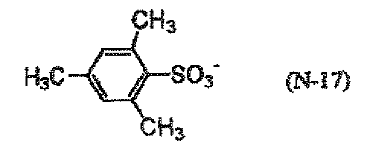

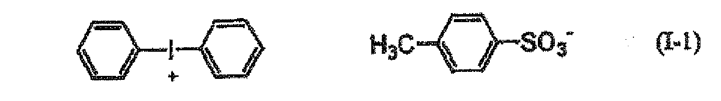

**PF₆⁻** **(I-12)**

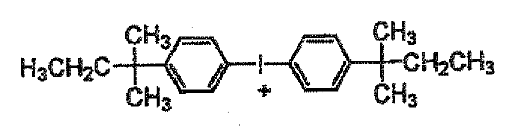

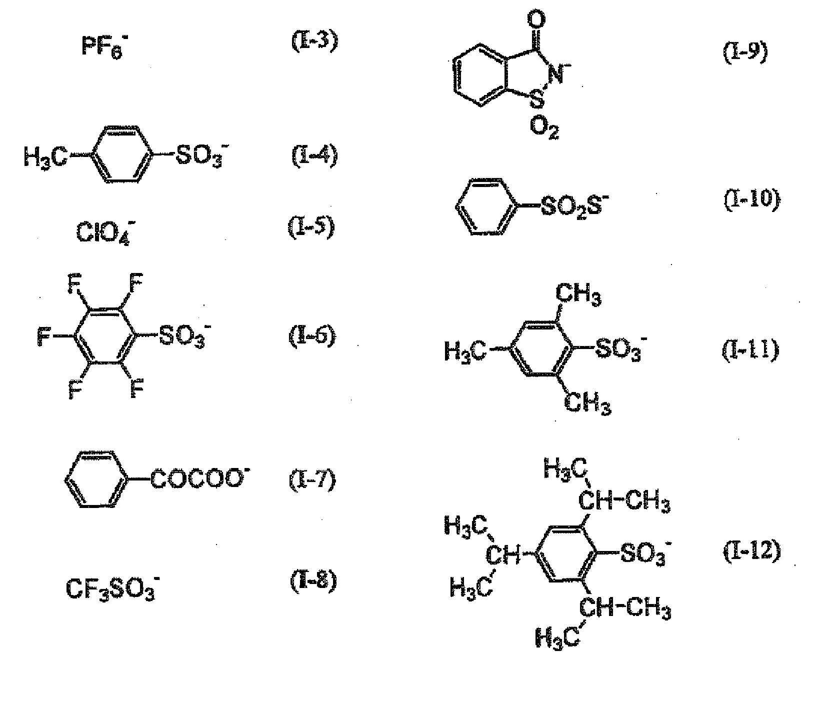

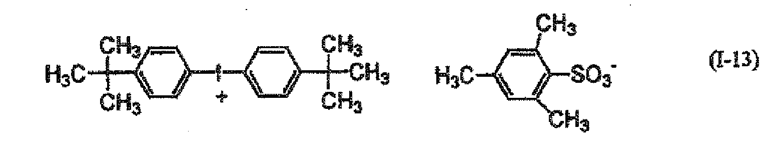

**ClO₄⁻** **(I-14)**

**PF₆⁻** **(I-15)**

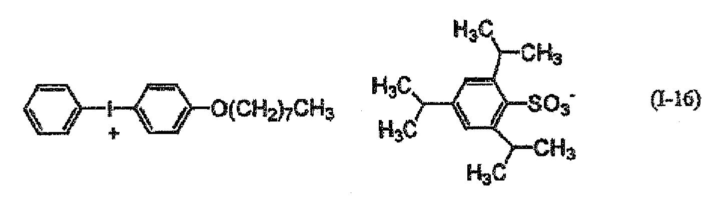

**CF₃COO⁻** **(I-17)**

**CF₃SO₃⁻** **(I-18)**

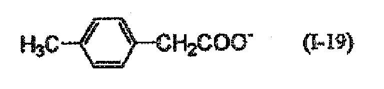

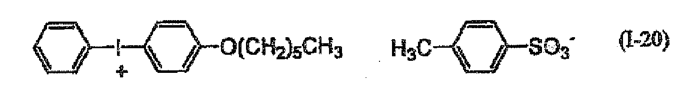

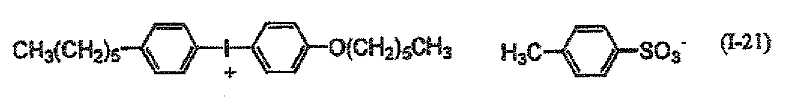

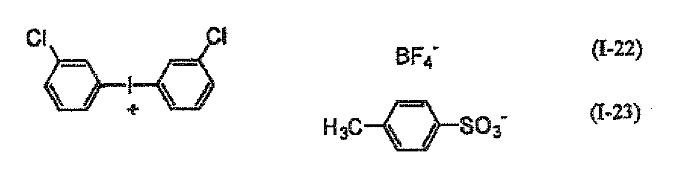

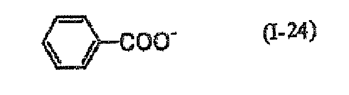

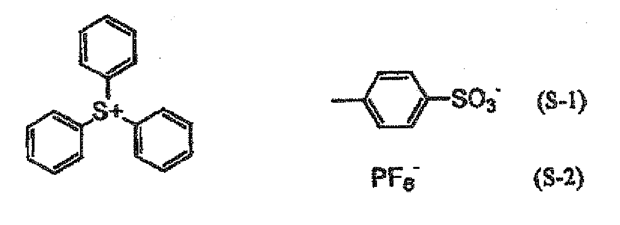

**ClO₄⁻** **(S-3)**

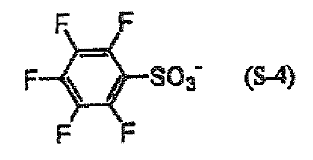

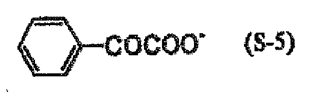

**CF₃SO₃⁻** **(S-6)**

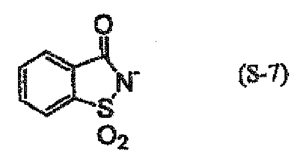

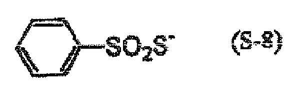

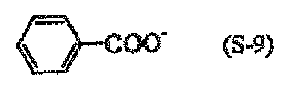

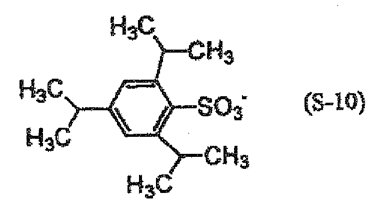

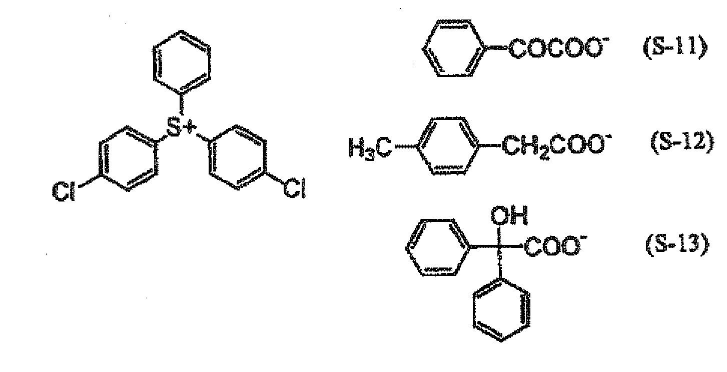

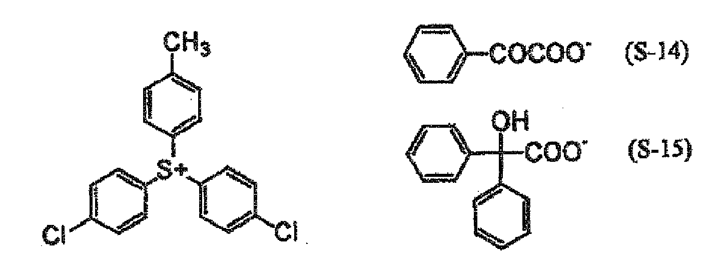

**BF₄⁻** **(S-16)**

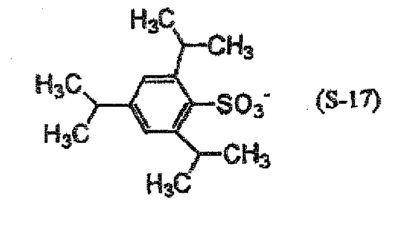

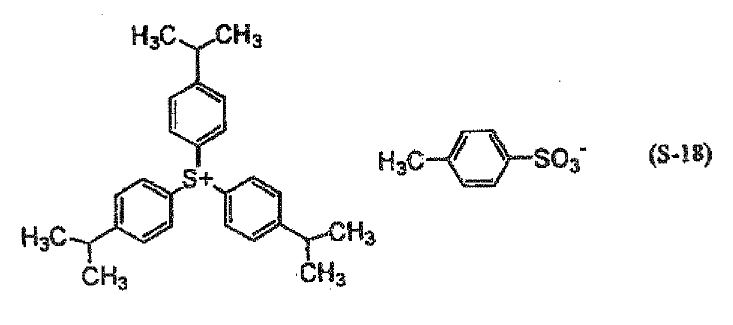

As the polymerization initiator, particularly, from the standpoint of reactivity and stability, the organic halogen compounds, metallocene compounds, hexaarylbiimidazole compounds, organic boron compounds, oxime ester compounds and onium salt compounds are preferred, and organic halogen compounds, metallocene compounds, hexaarylbiimidazole compounds and onium salt compounds are more preferred.
The polymerization initiators may be used individually or in combination of two or more thereof. The content of the polymerization initiator is preferably from 0.1 to 50% by weight, more preferably from 0.5 to 30% by weight, still more preferably from 0.8 to 20% by weight, based on the total solid content of the photosensitive layer.

### <Co-sensitizer>

A co-sensitizer can be used in the photosensitive layer. The co-sensitizer is an additive which can further increase the sensitivity of the photosensitive layer when added to the photosensitive layer. The operation mechanism of the co-sensitizer is not quite clear but may be considered to be mostly based on the following chemical process. Specifically, the co-sensitizer reacts with various intermediate active species (a radical, a peroxide, an oxidizing agent, a reducing agent or the like) generated during the process of photo-reaction initiated by light absorption of the polymerization initiator and subsequent addition-polymerization reaction to produce new active radicals. The co-sensitizers are roughly classified into (a) a compound which is reduced to produce an active radical, (b) a compound which is oxidized to produce an active radical and (c) a compound which reacts with a radical having low activity to convert it into a more highly active radical or acts as a chain transfer agent. However, in many cases, a common view about that an individual compound belongs to which type is not present.

### (a) Compound which is reduced to produce an active radical

### Compound having carbon-halogen bond:

An active radical is considered to be generated by the reductive cleavage of the carbon-halogen bond. Specifically, for example, a trihalomethyl-s-triazine or a trihalomethyloxadiazole is preferably used.

### Compound having nitrogen-nitrogen bond:

An active radical is considered to be generated by the reductive cleavage of the nitrogen-nitrogen bond. Specifically, a hexaarylbiimidazole or the like is preferably used.

### Compound having oxygen-oxygen bond:

An active radical is considered to be generated by the reductive cleavage of the oxygen-oxygen bond. Specifically, for example, an organic peroxide is preferably used. Onium compound:

An active radical is considered to be generated by the reductive cleavage of a carbon-hetero bond or oxygen-nitrogen bond. Specifically, for example, a diaryliodonium salt, a triarylsulfonium salt or an N-alkoxypyridinium (azinium) salt is preferably used.

### (b) Compound which is oxidized to produce an active radical

### Alkylate complex:

An active radical is considered to be generated by the oxidative cleavage of a carbon-hetero bond. Specifically, for example, a triaryl alkyl borate is preferably used. Alkylamine compound:
An active radical is considered to be generated by the oxidative cleavage of a C-X bond on the carbon adjacent to nitrogen, wherein X is preferably a hydrogen atom, a carboxyl group, a trimethylsilyl group, a benzyl group or the like. Specifically, for example, an ethanolamine, an N-phenylglycine or an N-trimethylsilylmethylaniline is preferably used.

### Sulfur-containing or tin-containing compound:

A compound in which the nitrogen atom of the above-described amine is replaced by a sulfur atom or a tin atom is considered to generate an active radical in the same manner. Also, a compound having an S-S bond is known to effect sensitization by the cleavage of the S-S bond.

### α-Substituted methylcarbonyl compound:

An active radical can be generated by the oxidative cleavage of carbonyl-α-carbon bond. The compound in which the carbonyl is converted into an oxime ether also shows the similar function. Specifically, an 2-alkyl-1-[4-(alkylthio)phenyl]-2-morpholinopropanone-1 and an oxime ether obtained by a reaction of the 2-alkyl-1-[4-(alkylthio)phenyl]-2-morpholinopropanone-1 with a hydroxyamine and subsequent etherification of the N-OH and an oxime ester obtained by subsequent esterification of the N-OH are exemplified.

### Sulfinic acid salt:

An active radical can be reductively generated. Specifically, sodium arylsulfinate is exemplified.

### (c) Compound which reacts with a radical to convert it into a more highly active radical or acts as a chain transfer agent:

As the compound which reacts with a radical to convert it into a more highly active radical or acts as a chain transfer agent, for example, a compound having SH, PH, SiH or GeH in its molecule is used. The compound donates hydrogen to a low active radical species to generate a radical or is oxidized and deprotonized to generate a radical. Specifically, for example, a 2-mercaptobenzimidazole is exemplified.

The chain transfer agent contributes to improvements in the sensitivity and preservation stability.
A thiol compound (for example, a 2-mercaptobenzimidazole) is preferably used as the chain transfer agent. Among them, a thiol compound represented by formula (T) shown below is particularly preferably used. By using the thiol compound as the chain transfer agent, a problem of the odor and decrease in sensitivity due to evaporation of the compound from the photosensitive layer or diffusion thereof into other layers are avoided and a lithographic printing plate precursor which is excellent in preservation stability and exhibits high sensitivity and a lithographic printing plate of high printing durability are obtained.

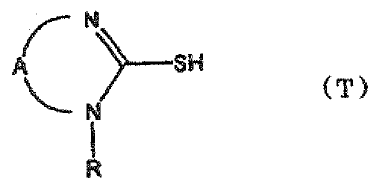

In formula (T), R represents an alkyl group or an aryl group, A represents an atomic group necessary for forming a 5-membered or 6-membered hetero ring containing a carbon atom together with the N=C-N linkage, and A may have a substituent.
Compounds represented by formula (TA) or (TB) shown below are more preferably used.

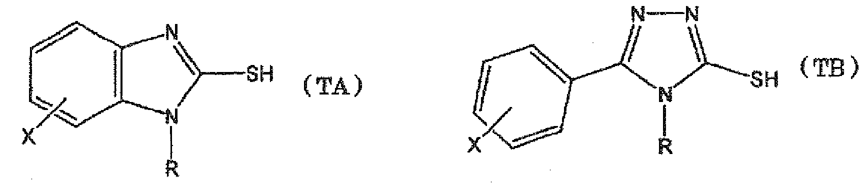

In formulae (TA) and (TB), R represents an alkyl group or an aryl group, and X represents a hydrogen atom, a halogen atom, an alkoxy group, an alkyl group or an aryl group.

Specific examples of the compound represented by formula (T) are set forth below, but the invention should not be construed as being limited thereto.

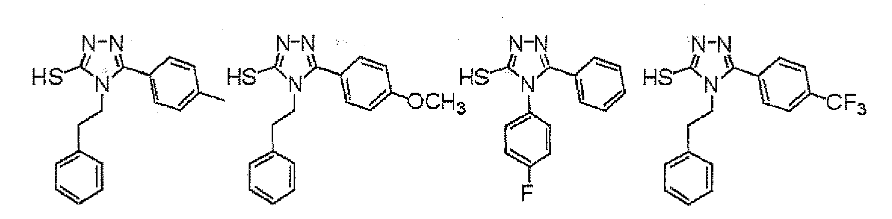

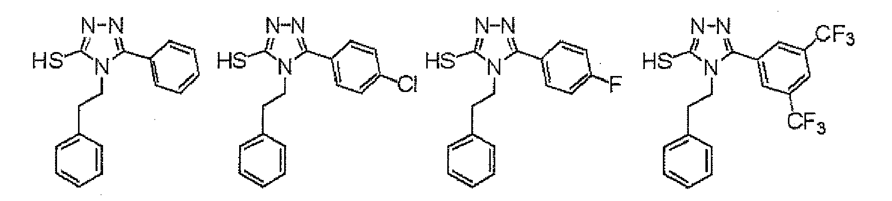

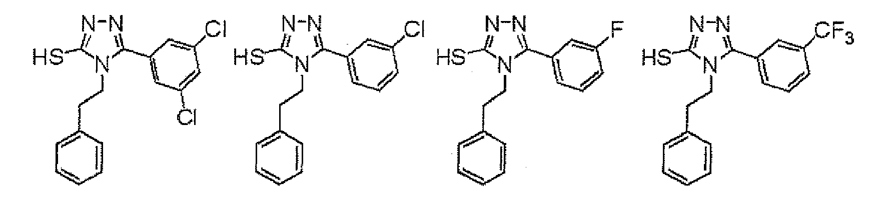

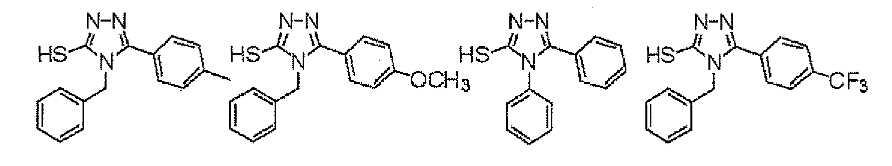

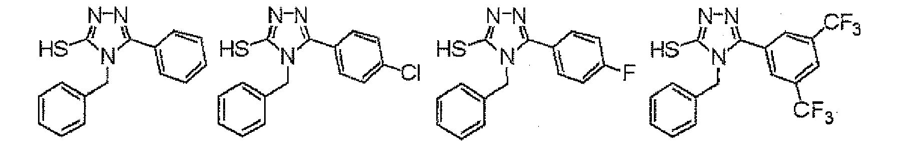

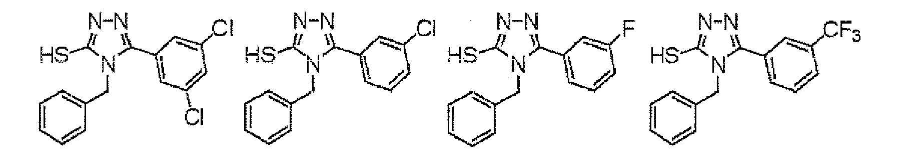

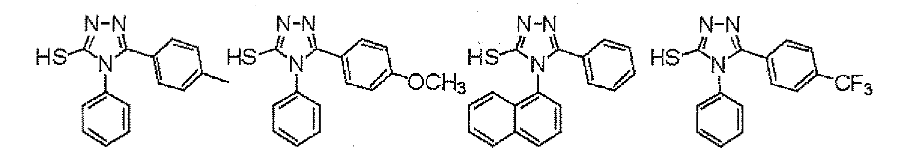

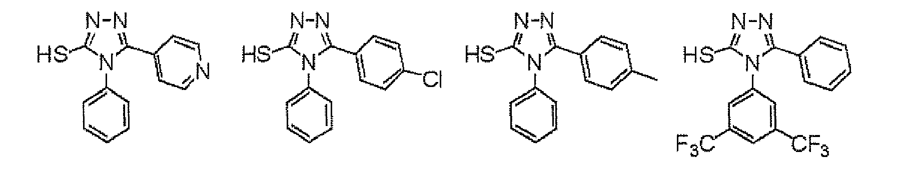

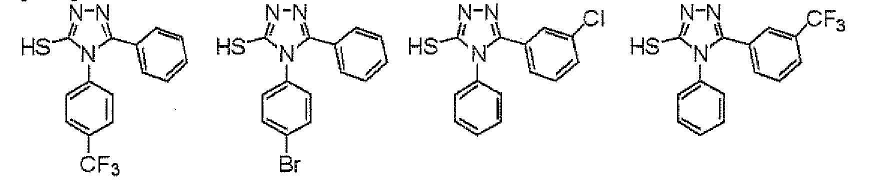

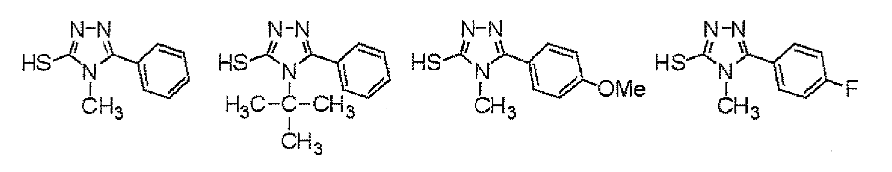

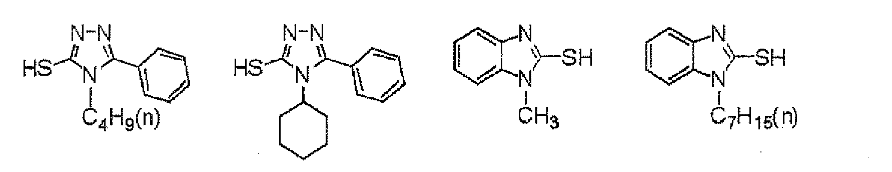

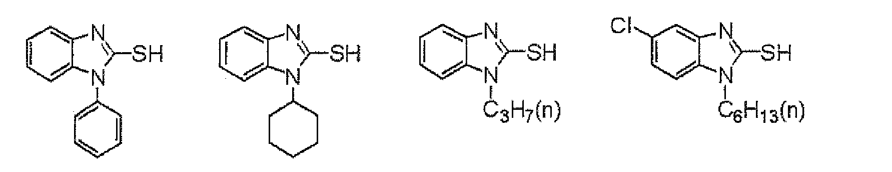

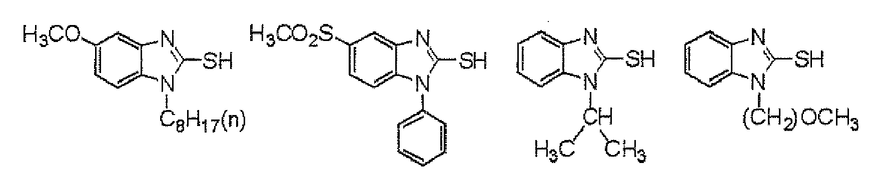

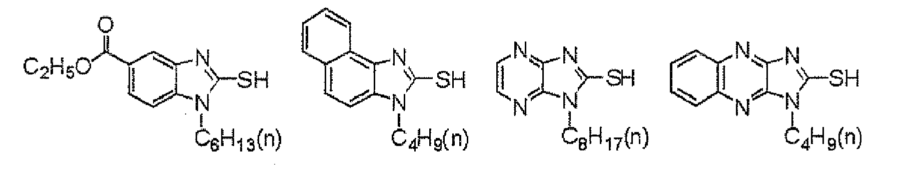

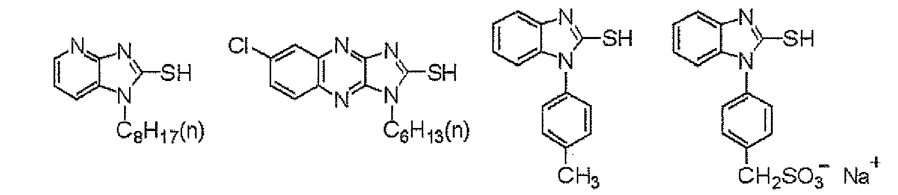

The amount of the chain transfer agent used is preferably from 0.01 to 20% by weight, more preferably from 0.1 to 15% by weight, still more preferably from 1.0 to 10% by weight, based on the total solid content of the photosensitive layer.

### [Addition polymerizable compound having ethylenically unsaturated double bond]

The addition polymerizable compound having an ethylenically unsaturated double bond for use in the invention can be appropriately selected from compounds having at least one, preferably two or more ethylenically unsaturated double bond groups. The compound has a chemical form, for example, a monomer, a prepolymer, specifically, a dimmer, a trimer or an oligomer, a copolymer thereof or a mixture thereof. Examples of the monomer include an ester between an unsaturated carboxylic acid (for example, acrylic acid, methacrylic acid, itaconic acid, crotonic acid, isocrotonic acid or maleic acid) and an aliphatic polyhydric alcohol compound and an amide between an unsaturated carboxylic acid and an aliphatic polyvalent amine compound.

Specific examples of the monomer of the ester between an aliphatic polyhydric alcohol compound and an unsaturated carboxylic acid include as an acrylate, ethylene glycol diacrylate, triethylene glycol diacrylate, 1,3-butanediol diacrylate, tetramethylene glycol diacrylate, propylene glycol diacrylate, neopentyl glycol diacrylate, trimethylolpropane triacrylate, trimethylolpropane tri(acryloyloxypropyl) ether, trimethylolethane triacrylate, hexanediol diacrylate, 1,4-cyclohexanediol diacrylate, tetraethylene glycol diacrylate, pentaerythritol diacrylate, pentaerythritol triacrylate, pentaerythritol tetraacrylate, dipentaerythritol diacrylate, dipentaerythritol pentaacrylate, dipentaerythritol hexaacrylate, sorbitol triacrylate, sorbitol tetraacrylate, sorbitol pentaacrylate, sorbitol hexaacrylate, tri(acryloyloxyethyl) isocyanurate, polyester acrylate oligomer and the like.

As a methacrylate, tetramethylene glycol dimethacrylate, triethylene glycol dimethacrylate, neopentyl glycol dimethacrylate, trimethylolpropane trimethacrylate, trimethylolethane trimethacrylate, ethylene glycol dimethacrylate, 1,3-butanediol dimethacrylate, hexanediol dimethacrylate, pentaerythritol dimethacrylate, pentaerythritol trimethacrylate, pentaerythritol tetramethacrylate, dipentaerythritol dimethacrylate, dipentaerythritol hexamethacrylate, dipentaerythritol pentamethacrylate, sorbitol trimethacrylate, sorbitol tetramethacrylate, bis[p-(3-methacryloxy-2-hydroxypropoxy)phenyl]dimethylmethane, bis-[p-(metbacryloxyethoxy)phenyl]dimethylmethane and the like are exemplified.

As an itaconate, ethylene glydcol diitaconate, propylene glycol diitaconate, 1,3-butanediol diitaconate, 1,4-butanediol diitaconate, tetramethylene glycol diitaconate, pentaerythritol diitaconate, sorbitol tetraitaconate and the like are exemplified.

As a crotonatate, ethylene glycol dicrotonate, tetramethylene glycol dicrotonate, pentaerythritol dicrotonate, sorbitol tetradicrotonate and the like are exemplified.
As an isocrotonate, ethylene glycol diisocrotonate, pentaerythritol diisocrotonate, sorbitol tetraisocrotonate and the like are exemplified.

As a maleate, ethylene glycol dimaleate, triethylene glycol dimaleate, pentaerythritol dimaleate, sorbitol tetramaleate and the like are exemplified.

Specific examples of the monomer of the amide between an aliphatic polyvalent amine compound and an unsaturated carboxylic acid include methylenebisacrylamide, methylenebismethacrylamide, 1,6-hexamethylenebisacrylamide, 1,6-hexamethylenebismethacrylamide, diethylenetriaminetrisacrylamide, xylylenebisacrylamide and xylylenebismethacrylamide.

Also, urethane acrylates as described in JP-A-51-37193, polyester acrylates as described in JP-A-48-64183, JP-B-49-43191 and JP-B-52-30490, and polyfunctional acrylates or methacrylates, for example, epoxy acrylates obtained by reacting an epoxy resin with (meth)acrylic acid are exemplified. Further, photo-curable monomers and oligomers described in Nippon Secchaku Kyokaishi (Journal of Japan Adhesion Society), Vol. 20, No. 7, pages 300 to 308 (1984) can also be used.
Specific examples of the urethane (meth)acrylate include NK OLIGO U-4HA, NK OLIGO U-4H, NK OLIGO U-6HA, NK OLIGO U-6ELH, NK OLIGO U-108A, NK OLIGO U-1084A, NK OLIGO U-200AX, NK OLIGO U-122A, NK OLIGO U-340A, NK OLIGO UA-324A and NK OLIGO UA-100 (produced by Shin-Nakamura Chemical Co., Ltd.), UA-306H, AI-600, UA-101T, UA-101I, UA-306T and UA-306I (produced by Kyoeisha Chemical Co., Ltd.), ART RESIN UN-9200A, ART RESIN UN-3320HA, ART RESIN UN-3320HB, ART RESIN UN-3320HC, ART RESIN SH-380G, ART RESIN SH-500 and ART RESIN SH-9832 (produced by Negami Chemical Industrial Co., Ltd.) and PLEX 6661-O (produced by Degussa AG, Germany).
The amount of the addition polymerizable compound having an ethylenically unsaturated double bond used is preferably in a range of 5 to 90% by weight, more preferably in a range of 20 to 75% by weight, based on the total solid content of the photosensitive layer.

### [Binder polymer]

The binder polymer for use in the invention is not particularly restricted and from the standpoint of solubility in an aqueous week alkali solution and developing property, an organic polymer having an acid group is preferred and an organic polymer having a carboxylic acid is more preferred. Such organic polymers include addition polymers having a carboxylic acid group in their side chains, for example, polymers described in JP-A-59-44615, JP-B-54-34327, JP-B-58-12577, JP-B-54-25957, JP-A-54-92723, JP-A-59-53836 and JP-A-59-71048, specifically, methacrylic acid copolymers, acrylic acid copolymers, itaconic acid copolymers, crotonic acid copolymers, maleic acid copolymers, partially esterified maleic acid copolymers and the like.
Also, an acidic cellulose derivative having a carboxylic acid group in its side chain, a product obtained by adding a cyclic acid anhydride to an addition polymer having a hydroxy group and the like are exemplified.
Further, polyurethane resins described in JP-B-7-120040, JP-B-7-120041, JP-B-7-120042, JP-B-8-12424, JP-A-63-287944, JP-A-63-287947, JP-A-1-271741 and JP-A-11-352691 are also useful as a binder polymer soluble or swellable in an aqueous weak alkali solution.
As the binder polymer, an acrylic resin, a methacrylic resin or a urethane resin is preferably used.

One preferable example of the binder polymer for use in the invention is a copolymer having (a) a repeating unit containing a carboxylic acid and (b) a repeating unit imparting a radical crosslinking property.
Specific examples of the repeating unit (a) containing a carboxylic acid (hereinafter, also referred to as repeating unit (a)) include the structures represented by (a-1) to (a-12) set forth below, but the invention should not be construed as being limited thereto.

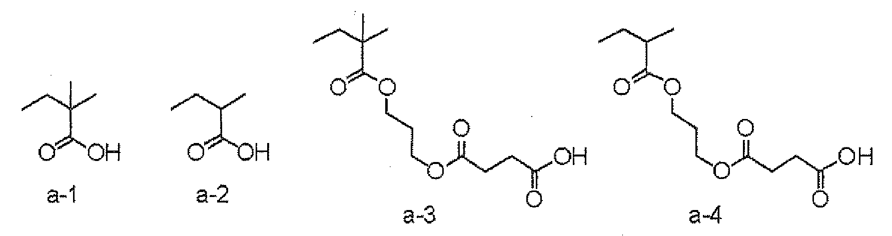

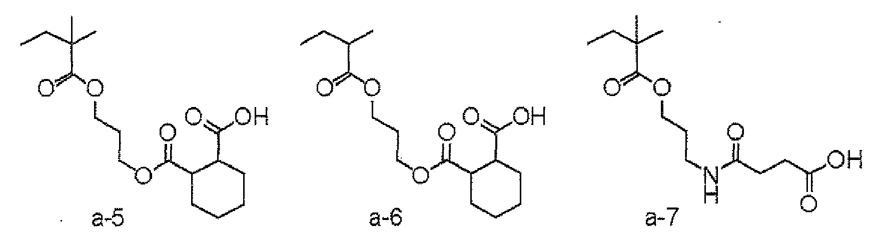

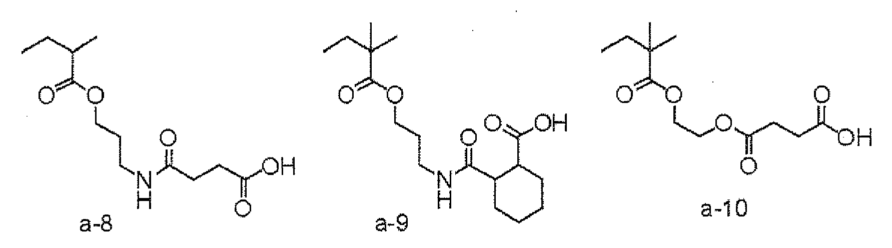

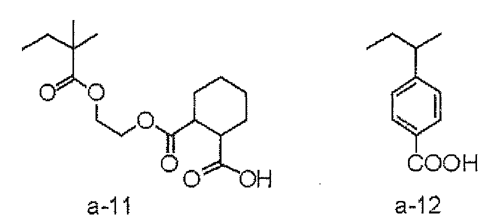

The content of the repeating unit (a) is ordinarily from 5 to 50, preferably from 5 to 25, more preferably from 5 to 15, taking the number of the total repeating units as 100.
Specific examples of the repeating unit (b) imparting a radical crosslinking property (hereinafter, also referred to as repeating unit (b)) include the structures represented by (b-1) to (b-11) set forth below, but the invention should not be construed as being limited thereto.

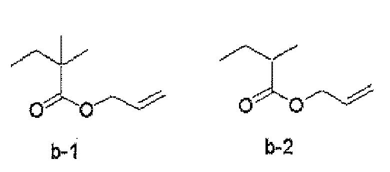

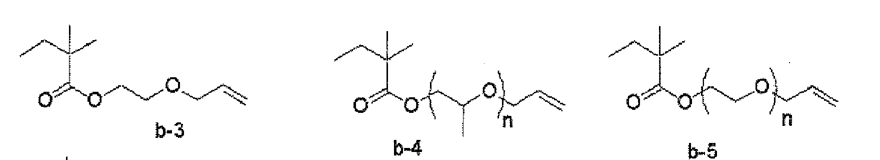

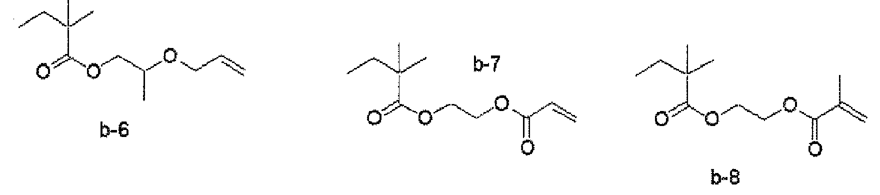

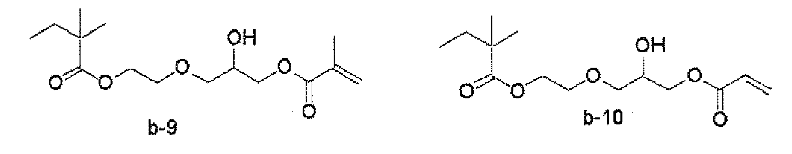

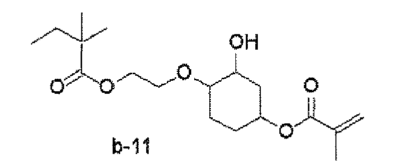

The content of the repeating unit (b) is ordinarily from 5 to 90, preferably from 20 to 85, more preferably from 40 to 80, taking the number of the total repeating units as 100.

The binder polymer for use in the invention may have a repeating unit (hereinafter, also referred to as repeating unit (1)) represented by formula (1) shown below.

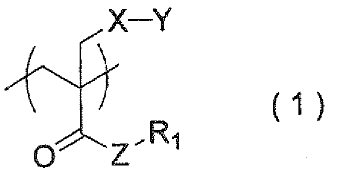

In formula (1), X represents an oxygen atom, a sulfur atom or a -NH- group, Y represents a hydrogen atom, an alkyl group having from 1 to 12 carbon atoms, a alicyclic alkyl group having from 5 to 12 carbon atoms or a group including an aromatic ring having from 6 to 20 carbon atoms, Z represents an oxygen atom, a sulfur atom or a -NH- group, and R₁ represents an alkyl group having from 1 to 18 carbon atoms, an alkyl group including an alicyclic structure having from 5 to 20 carbon atoms or a group containing an aromatic ring having from 6 to 20 carbon atoms.
Specific examples of the repeating unit (1) include the structures represented by (1-1) to (1-9) set forth below, but the invention should not be construed as being limited thereto.

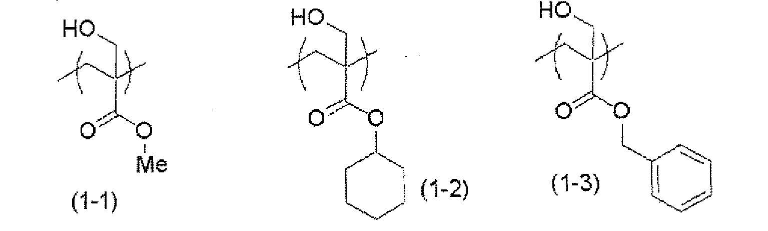

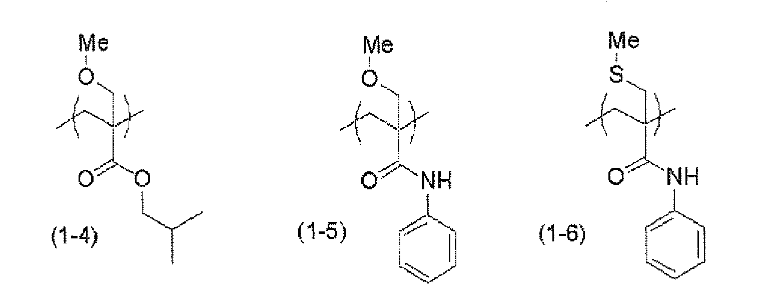

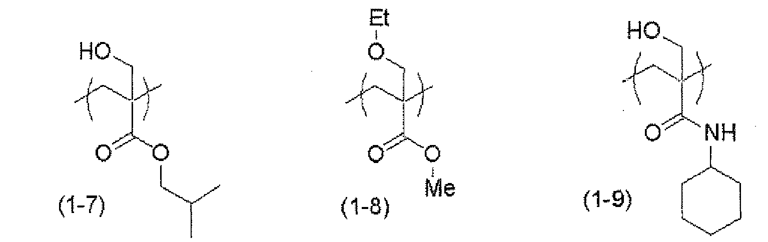

The content of the repeating unit (1) is ordinarily from 1 to 40, preferably from 3 to 25, more preferably from 5 to 15, taking the number of the total repeating units as 100.

Specific examples of preferable combination of the repeating units (a), (b) and (1) include Nos. (PP-1) to (PP-11) shown in Table 1 below, but the invention should not be construed as being limited thereto.

**TABLE 1**

| Specific Example No. | Repeating Unit (1) | Repeating Unit (a) | Repeating Unit (b) |
|---|---|---|---|
| PP-1 | 1-3 | a-1 | b-1 |
| PP-2 | 1-3 | a-1 | b-8 |
| PP-3 | 1-2 | a-1 | b-1 |
| PP-4 | 1-2 | a-1 | b-8 |
| PP-5 | 1-2 | a-1 | b-11 |
| PP-6 | 1-9 | a-5 | b-1 |
| PP-7 | 1-5 | a-3 | b-1 |
| PP-8 | 1-5 | a-3 | b-8 |
| PP-9 | 1-1 | a-3 | b-1 |
| PP-10 | 1-1 | a-5 | b-8 |
| PP-11 | 1-9 | a-3 | b-1 |

It is preferred that a urethane resin used as the binder polymer in the invention contains a crosslinkable group. The term "crosslinkable group" as used herein means a group capable of crosslinking the binder polymer in the process of a radical polymerization reaction which is caused in the image-recording layer, when the lithographic printing plate precursor is exposed to light. The crosslinkable group is not particularly restricted as long as it has such a function and includes, for example, an ethylenically unsaturated bonding group, an amino group or an epoxy group as a functional group capable of undergoing an addition polymerization reaction. Also, a functional group capable of forming a radical upon irradiation with light may be used and such a crosslinkable group includes, for example, a thiol group, a halogen atom and an onium salt structure. Among them, the ethylenically unsaturated bonding group is preferred, and functional groups represented by formulae (1A) to (3A) shown below are particularly preferred.

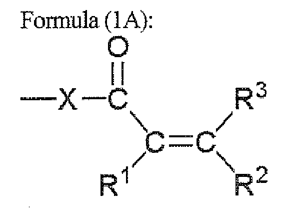

In formula (1A), R¹ to R³ each independently represents a hydrogen atom or a monovalent organic group. R¹ preferably includes a hydrogen atom, an alkyl group which may have a substituent or the like. Among them, a hydrogen atom or a methyl group is preferred because of high radical reactivity. R² and R³ each independently preferably includes a hydrogen atom, a halogen atom, an amino group, a carboxyl group, an alkoxycarbonyl group, a sulfo group, a nitro group, a cyano group, an alkyl group which may have a substituent, an aryl group which may have a substituent, an alkoxy group which may have a substituent, an aryloxy group which may have a substituent, an alkylamino group which may have a substituent, an arylamino group which may have a substituent, an alkylsulfonyl group which may have a substituent, an arylsulfonyl group which may have a substituent and the like. Among them, a hydrogen atom, a carboxyl group, an alkoxycarbonyl group, an alkyl group which may have a substituent or an aryl group which may have a substituent is preferred because of high radical reactivity.

X represents an oxygen atom, a sulfur atom or -N(R¹²)-, and R¹² represents a hydrogen atom or a monovalent organic group. The monovalent organic group represented by R₁₂ includes an alkyl group which may have a substituent and the like. Among them, R₁₂ is preferably a hydrogen atom, a methyl group, an ethyl group or an isopropyl group because of high radical reactivity.

Examples of the substituent which can be introduced include an alkyl group, an alkenyl group, an alkynyl group, an aryl group, an alkoxy group, an aryloxy group, a halogen atom, an amino group, an alkylamino group, an arylamino group, a carboxyl group, an alkoxycarbonyl group, a sulfo group, a nitro group, a cyano group, an amido group, an alkylsulfonyl group and an arylsulfonyl group.

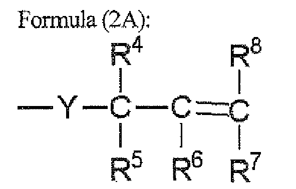

In formula (2A), R⁴ to R⁸ each independently represents a hydrogen atom or a monovalent organic group. R⁴ to R⁸ each independently preferably includes a hydrogen atom, a halogen atom, an amino group, a dialkylamino group, a carboxyl group, an alkoxycarbonyl group, a sulfo group, a nitro group, a cyano group, an alkyl group which may have a substituent, an aryl group which may have a substituent, an alkoxy group which may have a substituent, an aryloxy group which may have a substituent, an alkylamino group which may have a substituent, an arylamino group which may have a substituent, an alkylsulfonyl group which may have a substituent, an arylsulfonyl group which may have a substituent and the like. Among them, a hydrogen atom, a carboxyl group, an alkoxycarbonyl group, an allyl group which may have a substituent or an aryl group which may have a substituent is preferred.

Examples of the substituent which can be introduced include those described in formula (1A). Y represents an oxygen atom, a sulfur atom or -N(R¹²)-, and R¹² has the same meaning as R¹² defined in formula (1A). Preferable examples for R¹² are also same as those described in formula (1A).

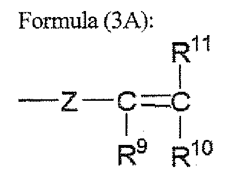

In formula (3A), R⁹ to R¹¹ each independently represents a hydrogen atom or a monovalent organic group. R⁹ preferably includes a hydrogen atom, an alkyl group which may have a substituent and the like. Among them, a hydrogen atom or a methyl group is preferred because of high radical reactivity. R¹⁰ and R¹¹ each independently represents a hydrogen atom, a halogen atom, an amino group, a dialkylamino group, a carboxyl group, an alkoxycarbonyl group, a sulfo group, a nitro group, a cyano group, an alkyl group which may have a substituent, an aryl group which may have a substituent, an alkoxy group which may have a substituent, an aryloxy group which may have a substituent, an alkylamino group which may have a substituent, an arylamino group which may have a substituent, an alkylsulfonyl group which may have a substituent, an arylsulfonyl group which may have a substituent and the like. Among them, a hydrogen atom, a carboxyl group, an alkoxycarbonyl group, an alkyl group which may have a substituent or an aryl group which may have a substituent is preferred because of high radical reactivity.

Examples of the substituent introduced include those described in Formula (1A). Z represents an oxygen atom, a sulfur atom, -N(R¹²)- or a phenylene group which may have a substituent. R¹² has the same meaning as R¹² defined in formula (1A). Preferable examples for R¹² are also same as those described in formula (1A).

The polyurethane resin for use in the invention preferably contains in its side chain an aqueous week alkali-soluble group, for example, a carboxyl group as well as the crosslinkable group. The polyurethane resin is preferred in view of satisfying both good stain property and high printing durability because the development damage in the exposed area can be prevented without accompanying with deterioration of the developing property in the unexposed area, even when the acid value of the image-recording layer is low.

The polyurethane resin preferably used in the invention is a resin obtained by a polyaddition reaction of (i) a diisocyanate compound, (ii) a diol compound having a carboxyl group, (iii) a diisocyanate compound having a crosslinkable group and, if desired, (iv) a diol compound containing no carboxyl group.
The diisocyanate compound and diol compound which are starting materials of the polyurethane resin will be described below.

### (i) Diisocyanate compound

The diisocyanate compound includes a diisocyanate compound represented by formula (4) shown below.

OCN-L-NCO (4)

In formula (4), L represents a divalent aliphatic or aromatic hydrocarbon group which may have a substituent. If desired, L may contain other functional group which does not react with the isocyanate group, for example, a carbonyl group, an ester group, a urethane group, an amido group or a ureido group. More specifically, L represents a single bond or a divalent aliphatic or aromatic hydrocarbon group which may have a substituent (preferably, for example, an alkyl group, an aralkyl group, an aryl group, an alkoxy group or a halogen atom), preferably an alkylene group having from 1 to 20 carbon atoms or an arylene group having from 6 to 15 carbon atoms, more preferably an alkylene group having from 1 to 8 carbon atoms. Also, if desired, L may contain other functional group which does not react with the isocyanate group, for example, a carbonyl group, an ester group, a urethane group, an amido group, a ureido group or an ether group.
Specifically, those set forth below are exemplified. Specifically, an aromatic diisocyanate compound, for example, 2,4-tolylene diisocyanate, dimer of 2,4-tolylene diisocyanate, 2,6-tolylene diisocyanate, p-xylylene diisocyanate, m-xylylene diisocyanate, 4,4'-diphenylmethane diisocyanate, 1,5-naphthalene diisocyanate or 3,3'-dimethylbiphenyl-4,4'-diisocyanate; an aliphatic diisocyanate compound, for example, hexamethylene diisocyanate, trimethylhexamethylene diisocyanate, lysine diisocyanate or dimeric acid diisocyanate; an alicyclic diisocyanate compound, for example, isophorone diisocyanate, 4,4'-methylenebis(cyclohexyl isocyanate), methylcyclohexane-2,4(or 2,6)-diisocyanate or 1,3-(isocyanatomethyl)cyclohexane; and a diisocyanate compound obtained by a reaction of diol with diisocyanate, for example, an adduct of 1 mole of 1,3-butylene glycol with 2 moles of tolylene diisocyanate are exemplified.
The diisocyanate compounds may be used individually or in combination of two or more thereof. In view of the balance between printing durability and stain resistance, it is preferred to use two or more of the diisocyanate compounds in combination, and it is particularly preferred to use at least one of the aromatic diisocyanate compounds (L represents an aromatic group) and at least one of the aliphatic diisocyanate compounds (L represents an aliphatic group).
With respect to the amount of the diisocyanate compound used, a molar ration of the diisocyanate compound to the diol compound is preferably from 0.8 to 1.2, and more preferably from 0.9 to 1.1. In the case where an isocyanate group remains at a polymer terminal because of using an excess amount of the diisocyanate compound to the diol compound, it is preferred to treat the compound after the urethanization reaction with an alcohol or an amine to finally synthesize a compound having no residual isocyanate group at the terminal.

### (ii) Diol compound having at least one carboxyl group

The diol compound having at least one carboxyl group includes diol compounds represented by formulae (5), (6) and (7) shown below and/or a compound obtained by ring opening of a tetracarboxylic acid dianhydride with a diol compound.

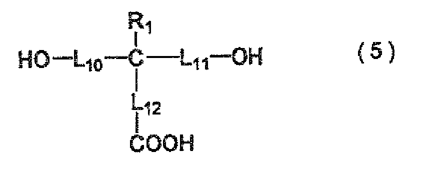

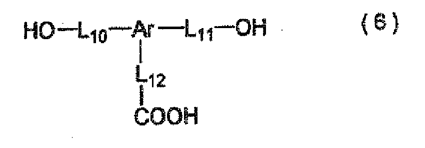

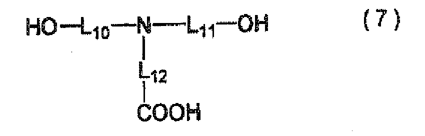

R₁ represents a hydrogen atom, an alkyl group, an aralkyl group, an aryl group, an alkoxy group or an aryloxy group, each of which may have a substituent (for example, a cyano group, a nitro group, a halogen atom (e.g., -F, -Cl, -Br or -I), -CONH₂, -COOR₁₁₃, -OR₁₁₃, -NHCONHR₁₁₃, -NHCOOR₁₁₃, -NHCOR₁₁₃ or -OCONHR₁₁₃ (wherein R₁₁₃ represents an alkyl group having from 1 to 10 carbon atoms or an aralkyl group having from 7 to 15 carbon atoms)), preferably a hydrogen atom, an alkyl group having from 1 to 8 carbon atoms or an aryl group having from 6 to 15 carbon atoms. L₁₀, L₁₁ and L₁₂, which may be the same or different, each represents a single bond or a divalent aliphatic or aromatic hydrocarbon group which may have a substituent (preferably, for example, an alkyl group, an aralkyl group, an aryl group, an alkoxy group or a halogen atom), preferably an alkylene group having from 1 to 20 carbon atoms or an arylene group having from 6 to 15 carbon atoms, more preferably an alkylene group having from 1 to 8 carbon atoms. Also, if desired, L₁₀, L₁₁ and L₁₂ each may contain other functional group which does not react with the isocyanate group, for example, a carbonyl group, an ester group, a urethane group, an amido group, a ureido group or an ether group. Further, two or three of R₁, L₁₀, L₁₁ and L₁₂ may be taken together to form a ring. Ar represents a trivalent aromatic hydrocarbon group which may have substituent, preferably an aromatic group having from 6 to 15 carbon atoms.

The diol compound having a carboxyl group represented by formula (5), (6) or (7) specifically includes the following compounds.

Specifically, 3,5-dihydroxybenzoic acid, 2,2-bis(hydroxymethyl)propionic acid, 2,2-bis(2-hydroxyethyl)propionic acid, 2,2-bis(3-hydroxypropyl)propionic acid, bis(hydroxymethyl) acetic acid, bis(4-hydroxyphenyl)acetic acid, 2,2-bis(hydroxymethyl)butyric acid, 4,4-bis(4-hydroxyphenyl)pentanoic acid, tartaric acid, N,N-dihydroxyethylglycine and N,N-bis(2-hydroxyethyl)-3-carboxypropionamide are exemplified.

Preferable examples of the tetracarboxylic acid dihydrate, which is used in the preparation of the diol compound having at least one carboxy group, include compounds represented by formulae (8), (9) and (10) shown below.

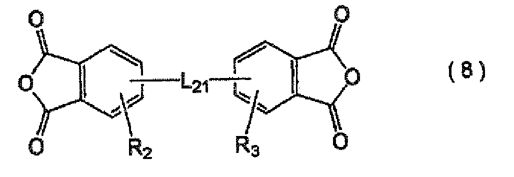

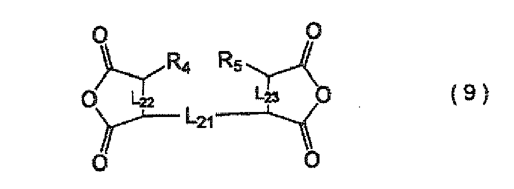

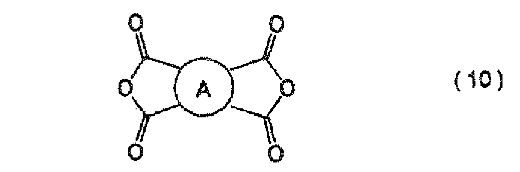

In the formulae, L₂₁ represents a single bond, a divalent aliphatic or aromatic hydrocarbon group which may have a substituent (preferably, for example, an alkyl group, an aralkyl group, an aryl group, an alkoxy group, a halogen atom, an ester group or an amido group), -CO-, -SO-, -SO₂-, -O- or -S-, preferably a single bond, a divalent aliphatic hydrocarbon group having from 1 to 15 carbon atoms, -CO-, -SO₂-, -O- or -S-. R₂ and R₃, which may be the same or different, each represents a hydrogen atom, an alkyl group, an aralkyl group, an aryl group, an alkoxy group or a halogen atom, preferably a hydrogen atom, an alkyl group having from 1 to 8 carbon atoms, an aryl group having from 6 to 15 carbon atoms, an alkoxy group having from 1 to 8 carbon atoms or a halogen atom. Alternatively, two of L₂₁, R₂ and R₃ may be combined with each other to forum a ring. R₄ and R₅, which may be the same or different, each represents a hydrogen atom, an alkyl group, an aralkyl group, an aryl group or a halogen atom, preferably a hydrogen atom, an alkyl group having from 1 to 8 carbon atoms or an aryl group having from 6 to 15 carbon atoms. Alternatively, two of L₂₁, R₄ and R₅ may be combined with each other to form a ring. L₂₂ and L₂₃, which may be the same or different, each represents a single bond, a double bond or a divalent aliphatic hydrocarbon group, preferably a single bond, a double bond or a methylene group. A represents a monocyclic or polycyclic aromatic ring, preferably an aromatic ring having from 6 to 18 carbon atoms.

The compound represented by formula (8), (9) or (10) specifically includes the compounds shown below.

Specifically, an aromatic tetracarboxylic acid dihydride, for example, pyromellitic acid dihydride, 3,3',4,4'-benzophenonetetracarboxylic acid dihydride, 3,3',4,4'-diphenyltetracarboxylic acid dihydride, 2,3,6,7-naphthalenetetracarboxylic acid dihydride, 1,4,5,8-naphthalenetetracarboxylic acid dihydride, 4,4'-sulfonyldiphthalic acid dihydride, 2,2-bis(3,4-dicarboxyphenyl)propane dihydride, bis(3,4-dicarboxyphenyl)ether dihydride, 4,4'-[3,3'-(alkylphosphoryldiphenylene)-bis(iminocarbonyl)]diphthalic acid dihydride, adduct of hydroquinonediacetate and trimellitic acid anhydride or adduct of diacetyldiamine and trimellitic acid anhydride; an alicyclic tetracarboxylic acid dihydride, for example, 5-(2,5-dioxotetrahydrofuryl)-3-methyl-3-cyclohexene-1,2-dicarboxylic acid dihydride (EPICRON B-4400, produced by Dainippon Ink & Chemicals, Inc.), 1,2,3,4-cyclopentanetetracarboxylic acid dihydride, 1,2,4,5-cyclohexanetetracarboxylic acid dihydride or tetrahydrofurantetracarboxylic acid dihydride; and an aliphatic tetracarboxylic acid dihydride, for example, 1,2,3,4-butanetetracarboxylic acid dihydride or 1,2,4,5-pentanetetracarboxylic acid dihydride are exemplified.

By ring-opening of the tetracarboxylic acid dianhydride with a diol compound, (ii) the diol compound having at least one carboxyl group can be synthesized. It is also possible that a reaction between the diol compound and (i) the diisocyanate compound is initially conducted and the resulting reaction product is reacted with the tetracarboxylic acid dianhydride to synthesize the polyurethane resin according to the invention. This method is also included in the concept of the invention. Specifically, the method of introducing a structural unit resulting from the tetracarboxylic acid dianhydride and the diol compound into the polyurethane resin includes the following methods:

### a) Method wherein an alcohol-terminated compound obtained by ring-opening of the tetracarboxylic acid dianhydride with a diol compound is reacted with the diisocyanate compound and

### b) Method wherein an alcohol-terminated urethane compound obtained by reacting the diisocyanate compound under excess of the diol compound is reacted with the tetracarboxylic acid dianhydride.

Of the diol compounds having at least one carboxyl group, the compounds represented by formula (5) are more preferable because of high solvent solubility and ease of synthesis. Also, the diol compound having at least one carboxyl group is introduced into the polyurethane resin binder in an amount so that the polyurethane resin binder contains ordinarily from 0.2 to 4.0 meq/g, preferably from 0.3 to 3.0 meq/g, more preferably from 0.4 to 2.0 meq/g, particularly preferably from 0.5 to 1.5 meq/g, most preferably from 0.6 to 1.2 meq/g, of the carboxyl group. Therefore, although the content of the structure derived from the diol compound having at least one carboxylic group in the polyurethane resin binder can be appropriately determined after considering a number of the carboxyl group in the diol compound, other diol compound used in combination, an acid value or a molecular weight of the resulting polyurethane resin binder, a composition or pH of developer and the like, it is, for example, ordinarily from 5 to 45% by mole, preferably from 10 to 40% by mole, and more preferably from 15 to 35% by mole.

### (iii) Diisocyanate compound having crosslinkable group

The diisocyanate compound having a crosslinkable group includes, for example, a reaction product obtained by an addition reaction of a triisocyanate compound with one equivalent of a monofunctional alcohol or monofunctional amine compound having a crosslinkable group.
As the triisocyanate compound, for example, the compounds set fourth below are exemplified, but the invention should not be construed as being limited thereto.

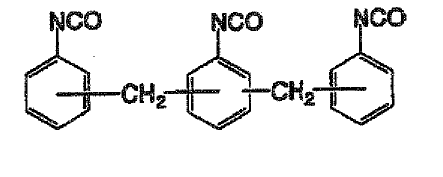

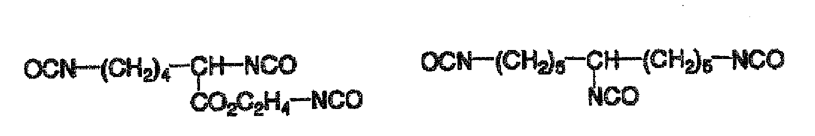

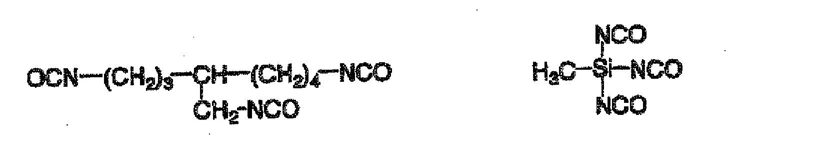

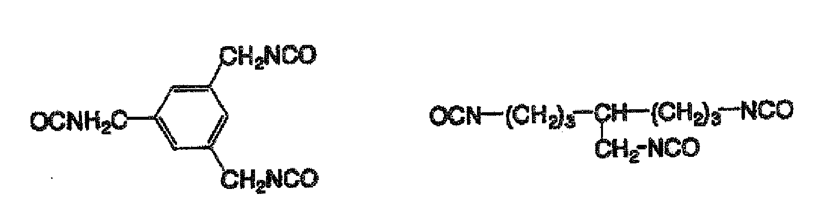

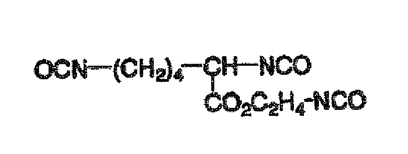

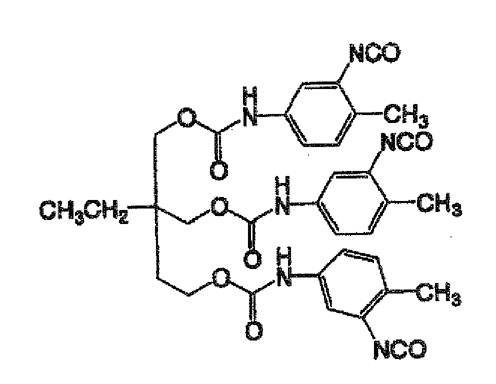

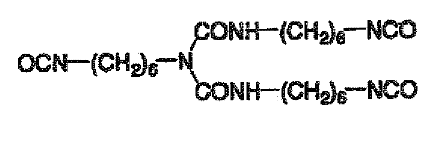

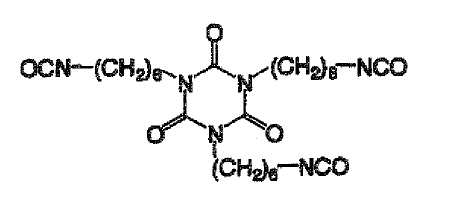

As the monofunctional alcohol or monofunctional amine compound having a crosslinkable group, for example, the compounds set forth below are exemplified, but the invention should not be construed as being limited thereto.

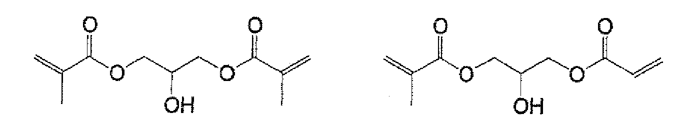

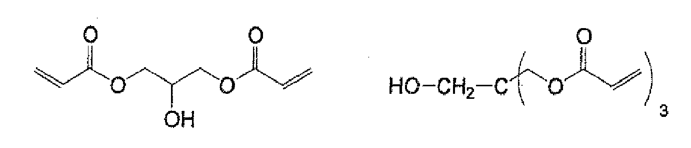

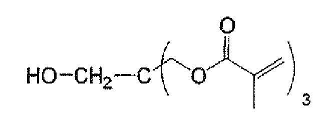

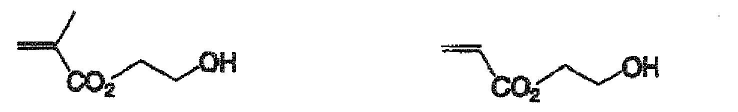

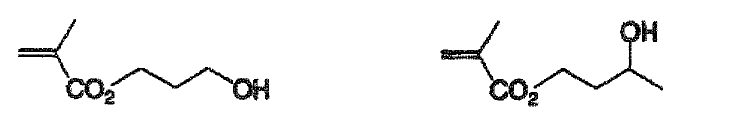

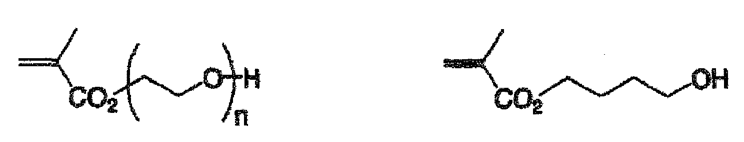

**n is an integer of 2 to 10.**

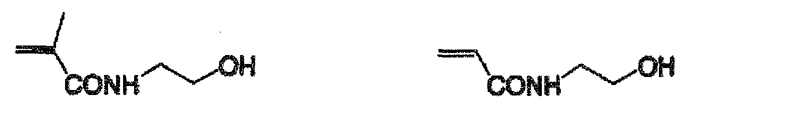

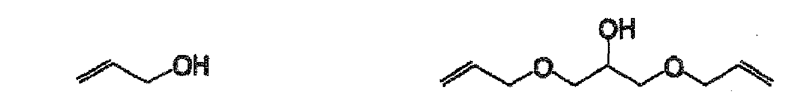

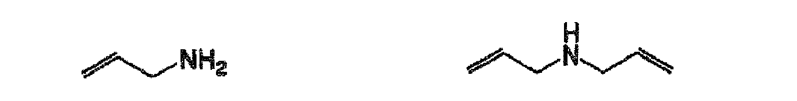

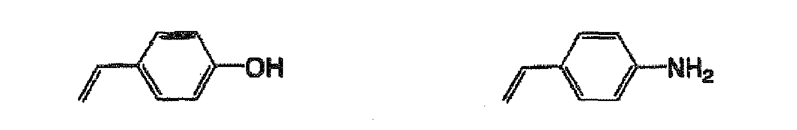

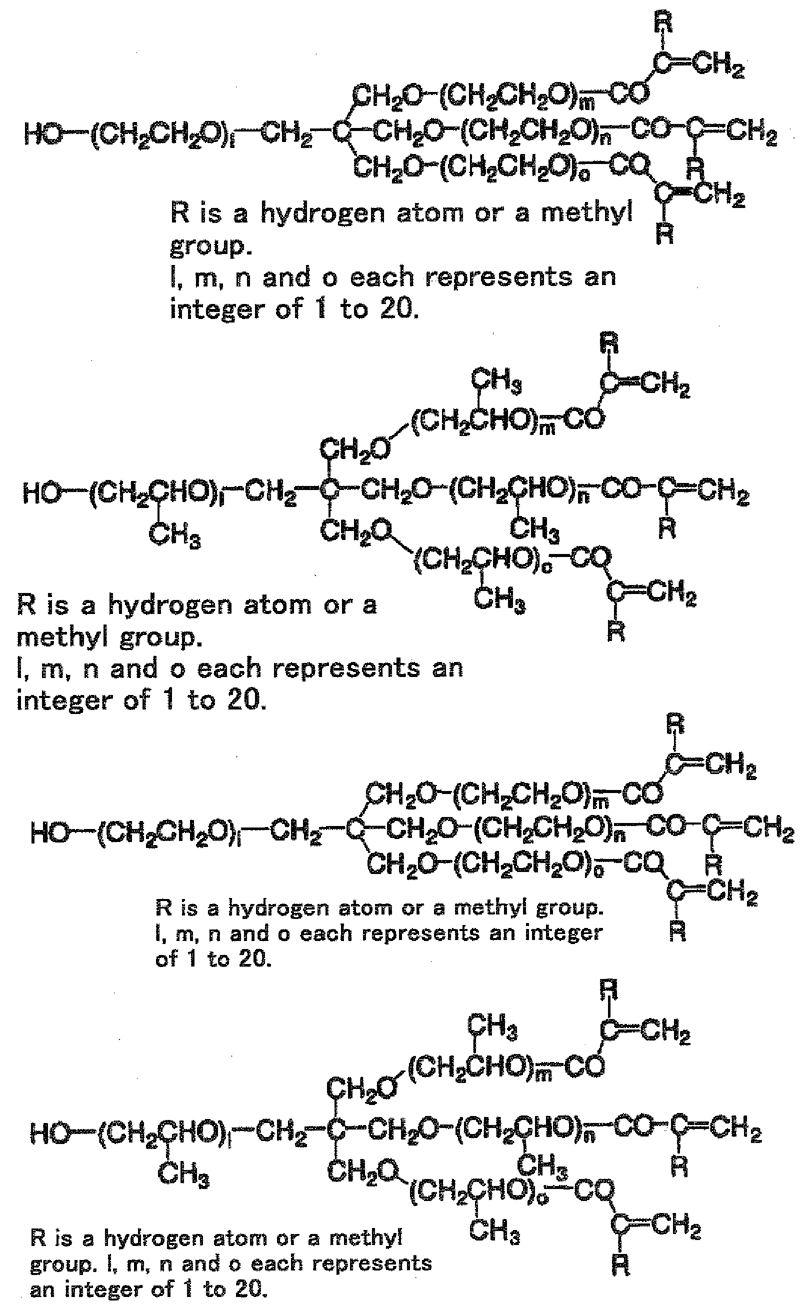

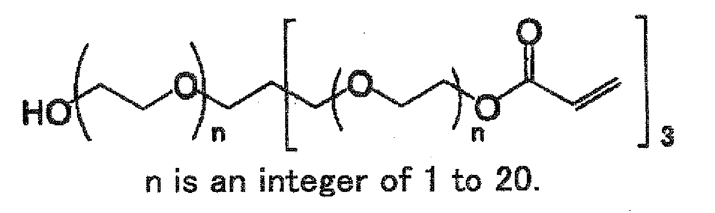

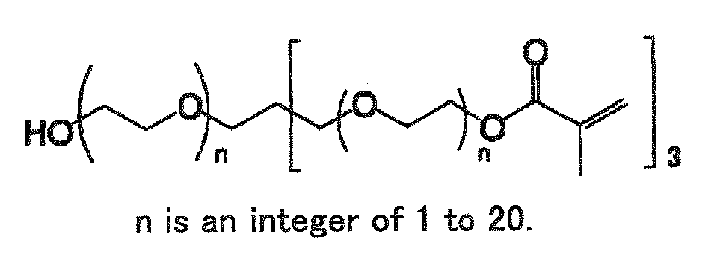

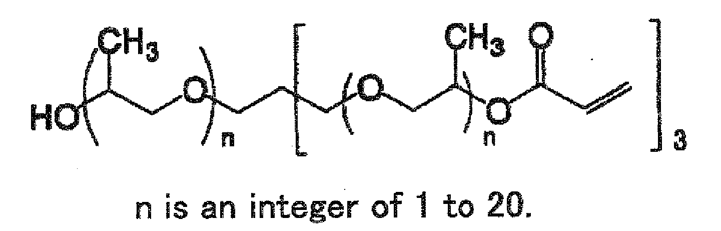

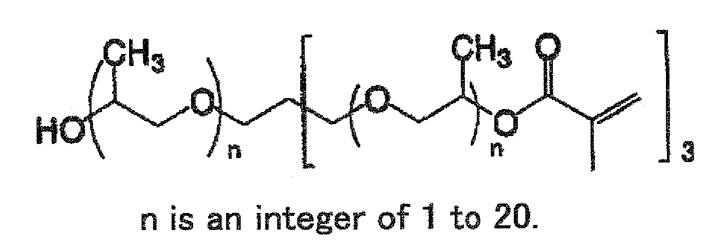

As a method for introducing a crosslinkable group into the side chain of the polyurethane resin, a method of using as a raw material for the production of polyurethane resin, the diisocyanate compound having the crosslinkable group in its side chain is preferred. As the diisocyanate compound having a crosslinkable group in its side chain obtained by an addition reaction of a triisocyanate compound with one equivalent of a monofunctional alcohol or monofunctional amine compound having the crosslinkable group, the compounds set forth below re exemplified, but the invention should not be construed as being limited thereto.

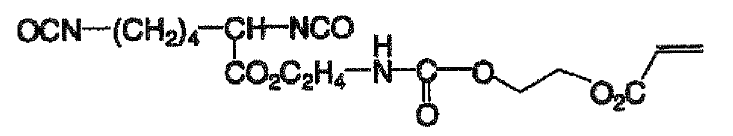

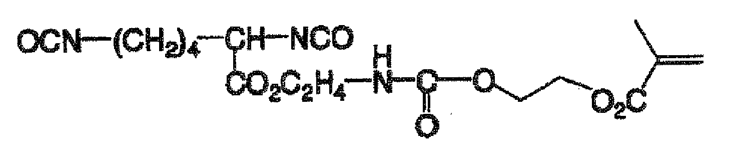

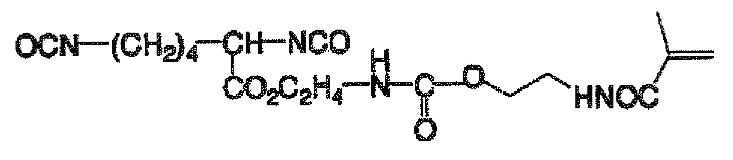

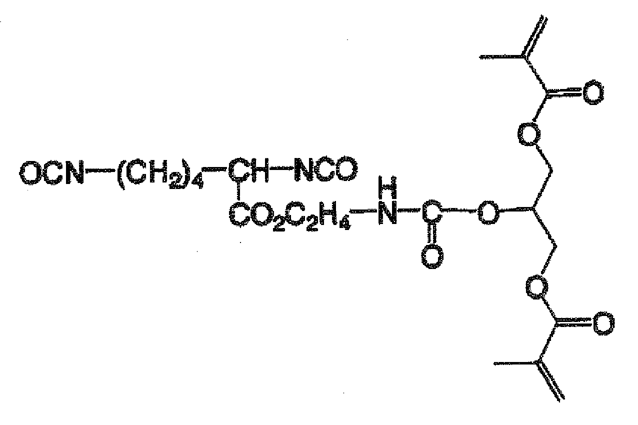

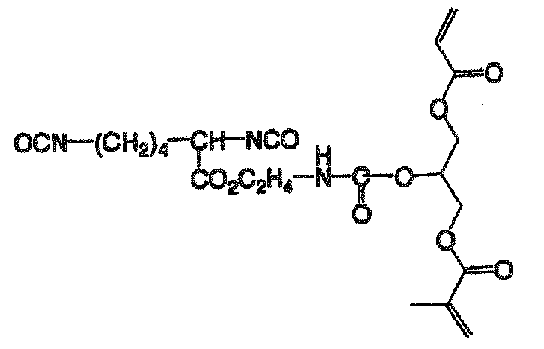

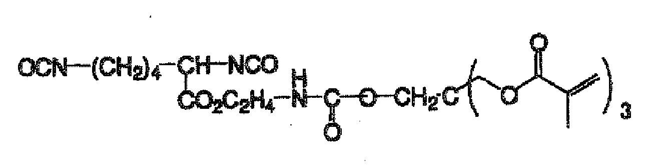

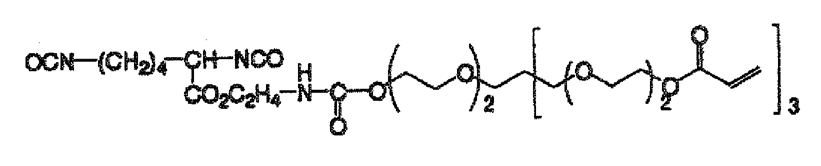

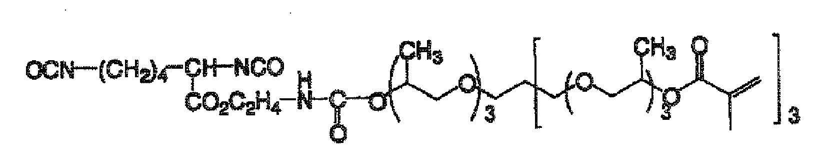

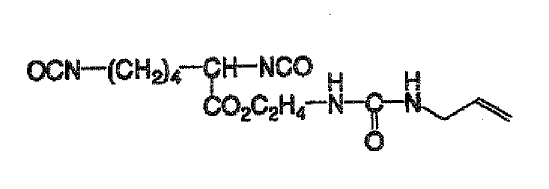

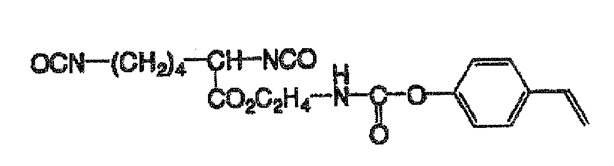

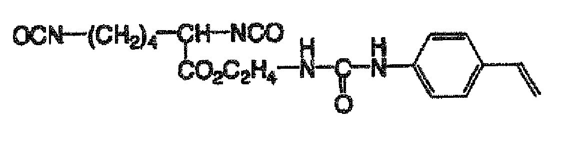

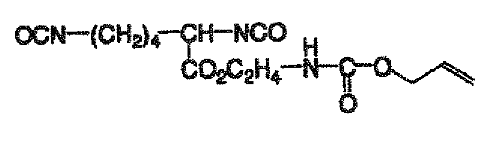

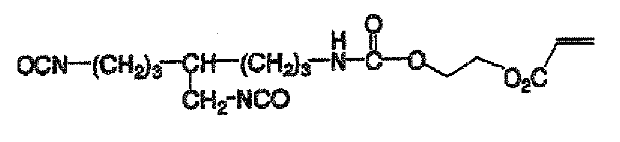

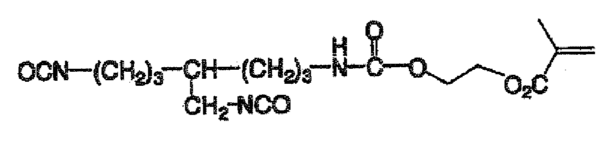

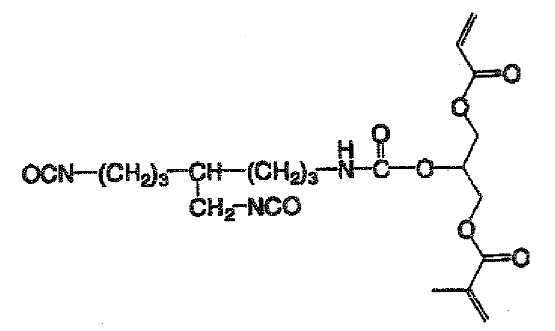

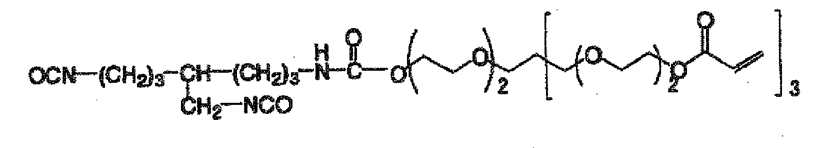

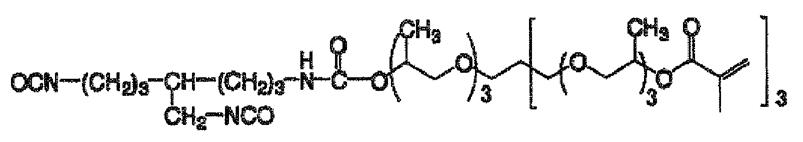

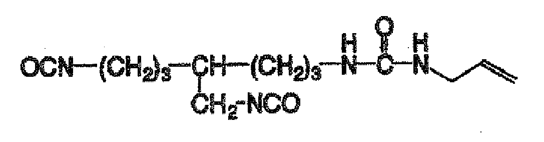

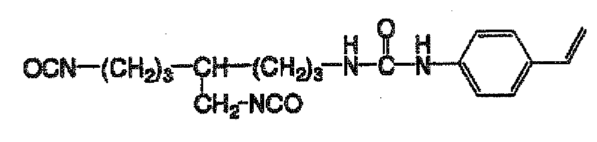

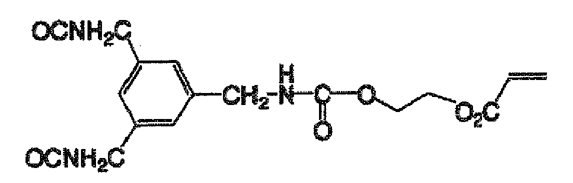

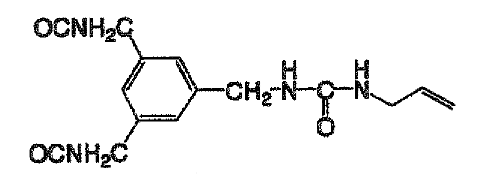

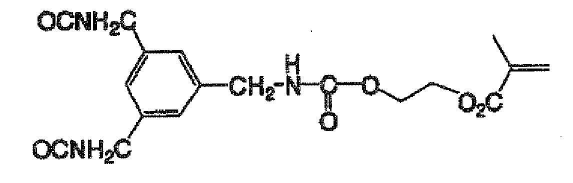

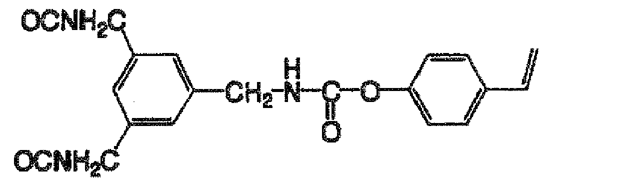

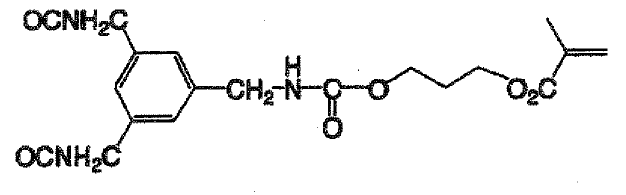

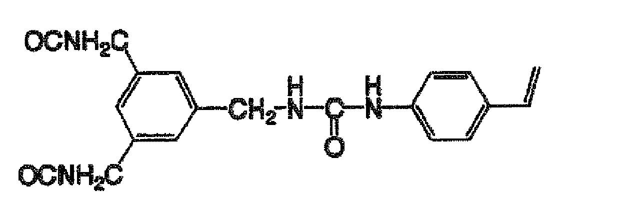

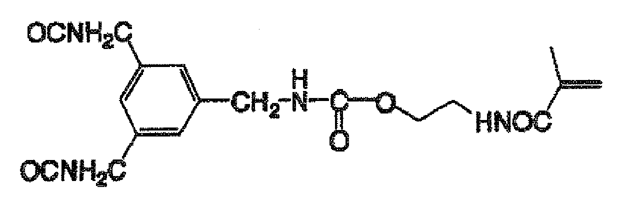

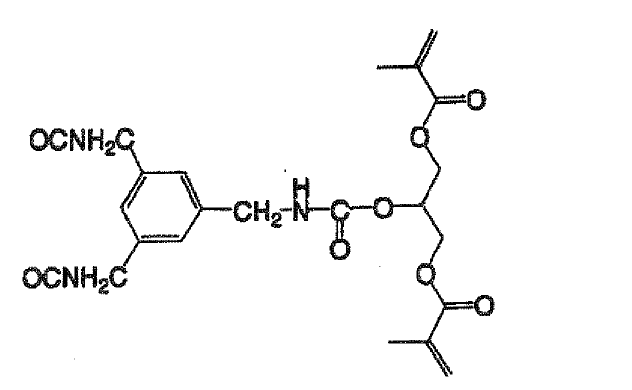

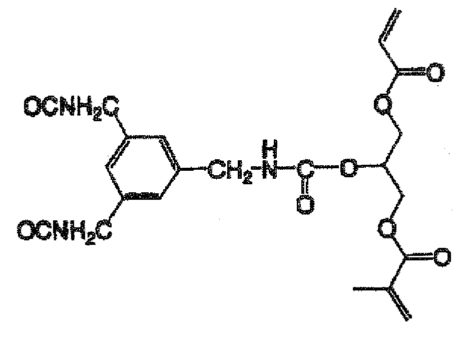

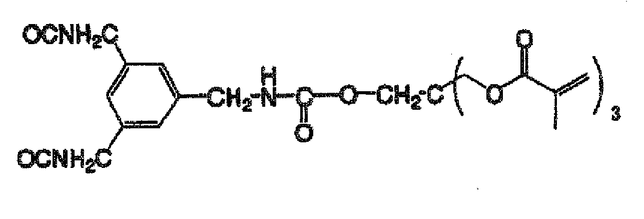

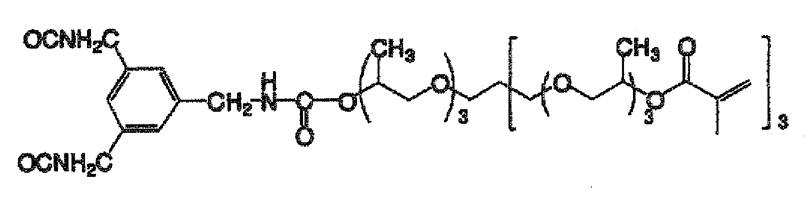

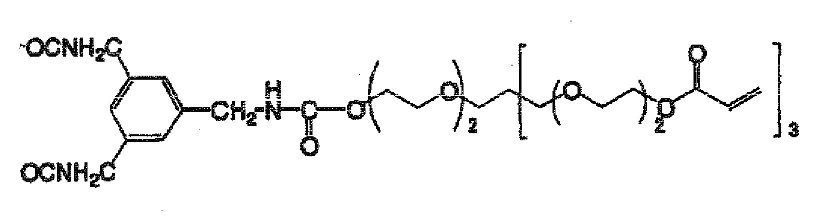

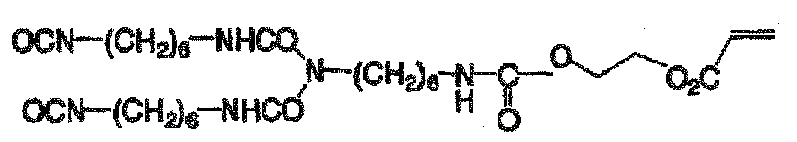

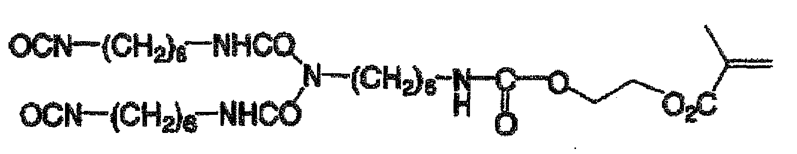

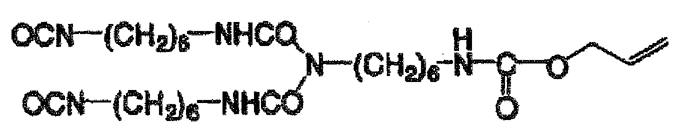

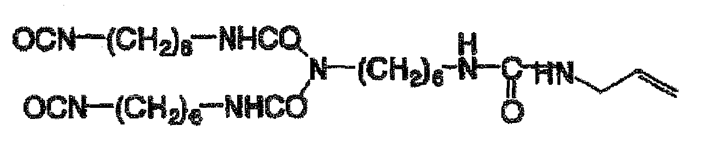

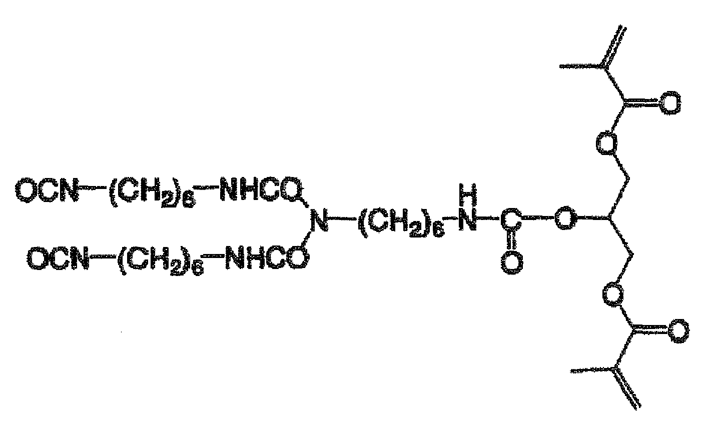

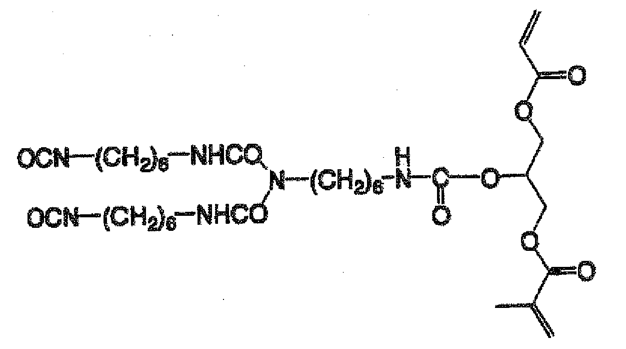

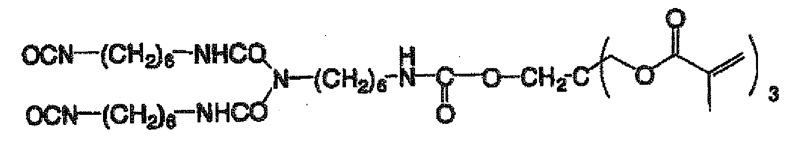

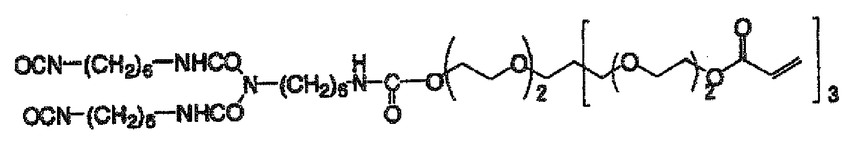

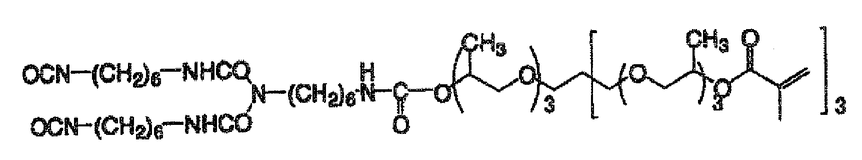

### (iv) Other diol compound

A method of using a diol compound having an unsaturated group in its side chain as a raw material for the production of polyurethane resin is also preferred as well as the method described above as the method of introducing the unsaturated group into the side chain of the polyurethane resin. Such a diol compound may be a commercially available compound, for example, trimethylolpropane monoallyl ether or a compound easily produced by a reaction of a halogenated diol compound, a triol compound or an aminodiol compound with a carboxylic acid, acid chloride, isocyanate, alcohol, amine, thiol or halogenated alkyl compound having an unsaturated group. As specific examples of the diol compound having an unsaturated group, the compounds set forth below are exemplified, but the invention should not be construed as being limited thereto.

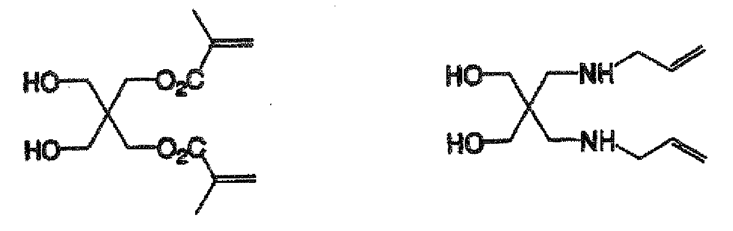

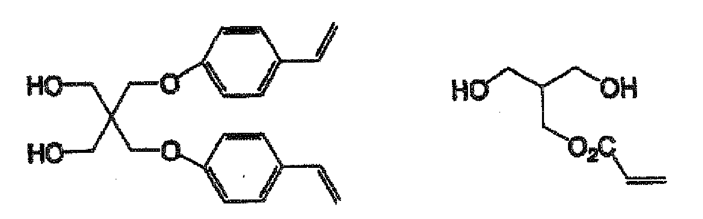

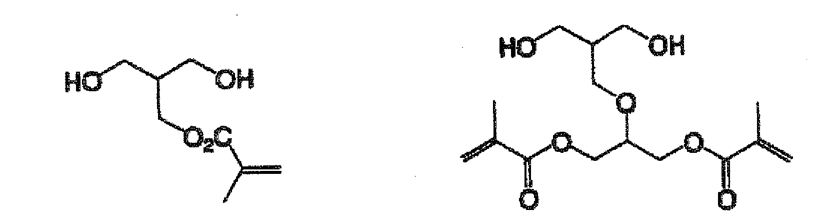

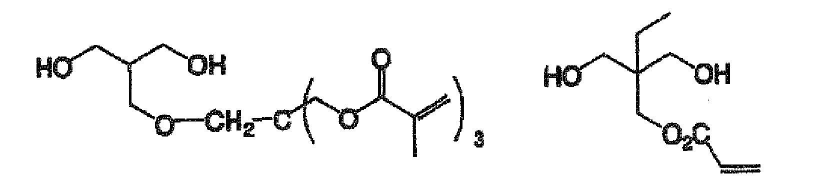

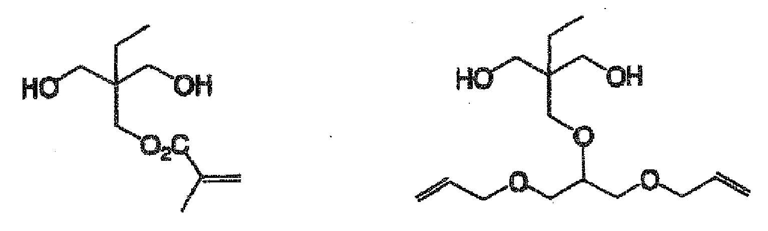

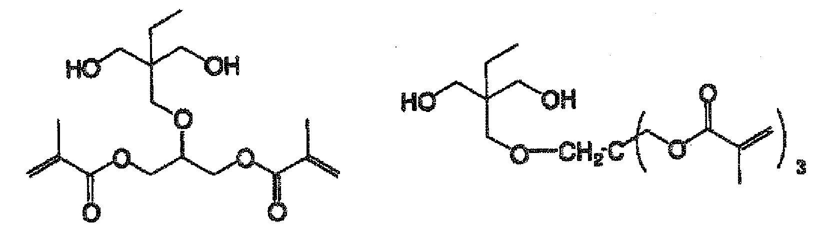

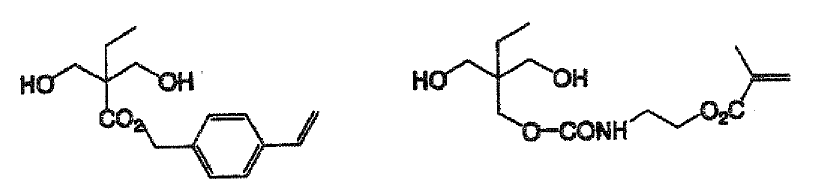

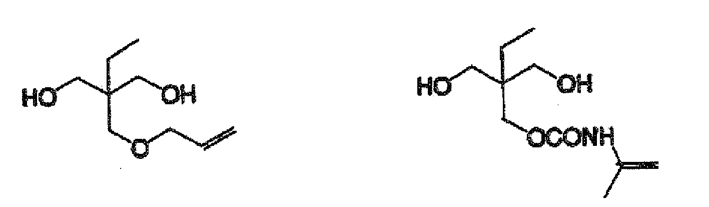

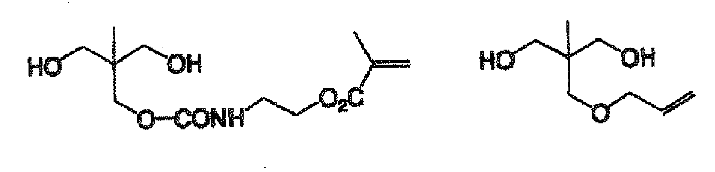

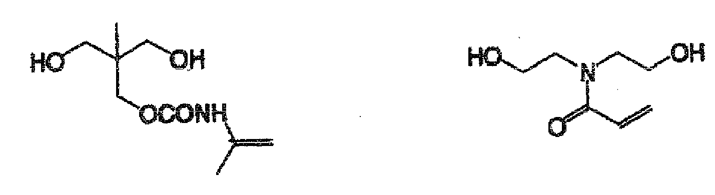

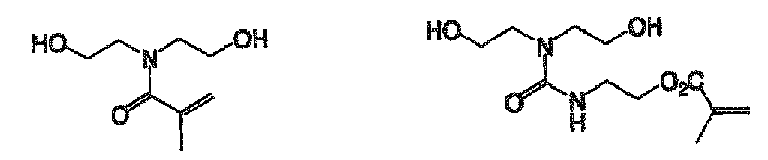

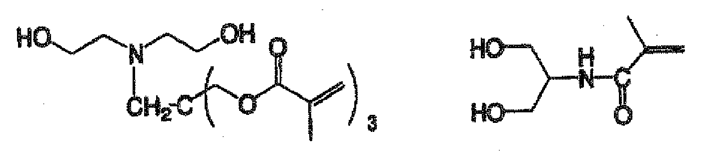

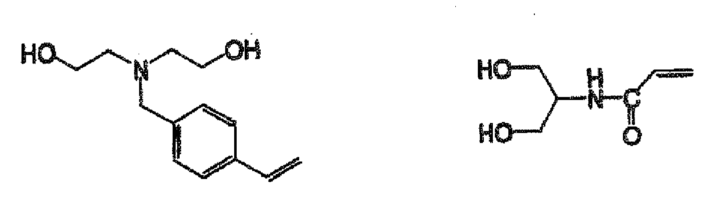

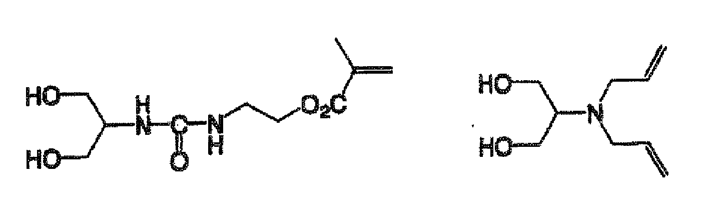

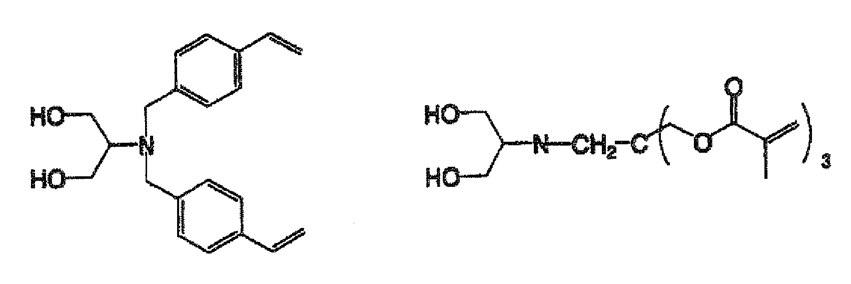

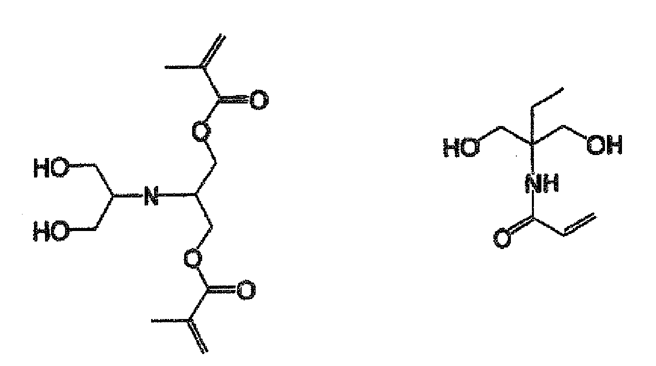

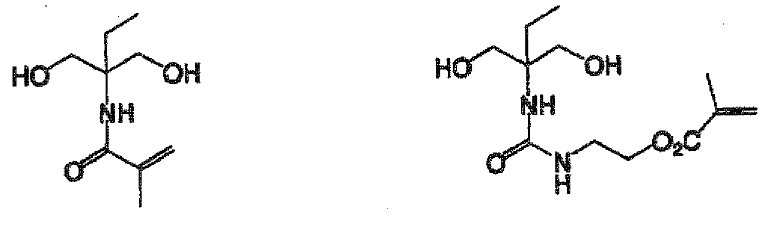

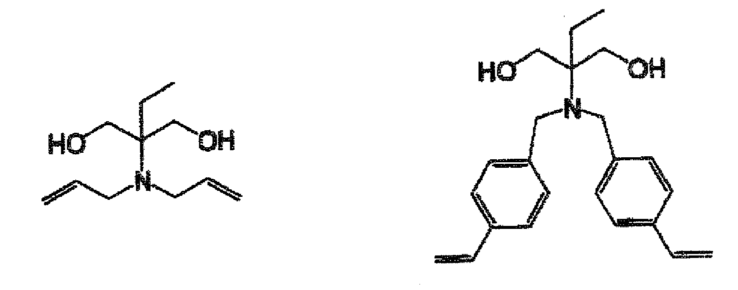

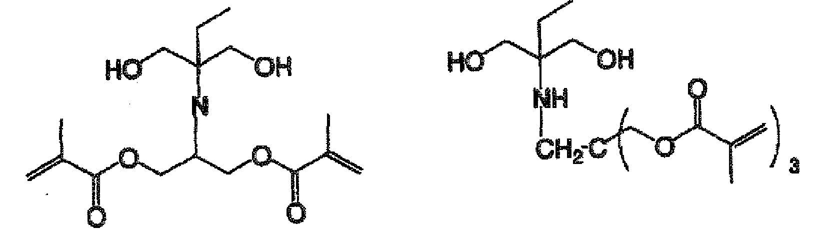

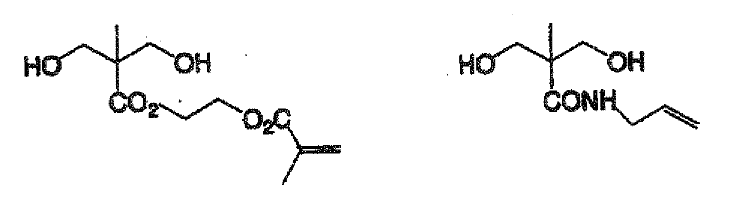

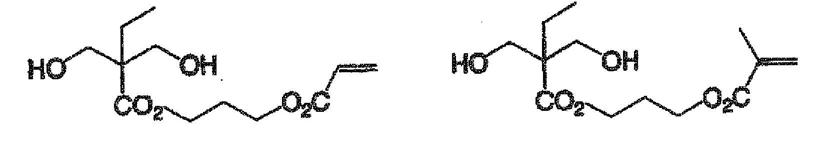

Further, as other diol compounds, ethylene glycol compounds represented by formula (A') shown below are exemplified.

HO-(CH₂CH₂O)ₙ-H (A')

(in the formula, n represents an integer of 1 or more.)

Also, random copolymers and block copolymers between ethylene oxide and propylene oxide having hydroxy groups at the terminals are exemplified.

Further, an ethylene oxide adduct of bisphenol A (addition number of the ethylene oxide is from 27 to 100), an ethylene oxide adduct of bisphenol F (addition number of the ethylene oxide is from 22 to 100), an ethylene oxide adduct of hydrogenated bisphenol A (addition number of the ethylene oxide is from 23 to 100) and an ethylene oxide adduct of hydrogenated bisphenol F (addition number of the ethylene oxide is from 18 to 100) are also used. More specifically, the ethylene glycol compounds represented by formula (A') are preferable in view of the stain property. The ethylene glycol compounds represented by formula (A') wherein n is form 2 to 50 are more preferred, the ethylene glycol compounds wherein n is form 3 to 30 are still more preferred, and the ethylene glycol compounds wherein n is form 4 to 10 are particularly preferred.

Specific examples thereof include 1,2-propylene glycol, di-1,2-propylene glycol, tri-1,2-propylene glycol, tetra-1,2-propylene glycol, hexa-1,2-propylene glycol, 1,3-propylene glycol, di-1,3-propylene glycol, tri-1,3-propylene glycol, tetra-1,3-propylene glycol, 1,3-butylene glycol, di-1,3-butylene glycol, tri-1,3-butylene glycol, hexa-1,3-butylene glycol, polypropylene glycol having an average molecular weight of 400, polypropylene glycol having an average molecular weight of 700, polypropylene glycol having an average molecular weight of 1,000, polypropylene glycol having an average molecular weight of 2,000, polypropylene glycol having an average molecular weight of 3,000, polypropylene glycol having an average molecular weight of 4,000, neopentyl glycol, 2-butene-1,4-diol, 2,2,4-trimethyl-1,3-pentanediol, 1,4-bis-β-hydroxyethoxycyclohexane, 1,4-butanediol, 1,5-pentanediol, 1,6-hexanediol, 1,7-heptanediol, 1,8-octanediol, cyclohexanedimethanol, tricyclodecanedimethanol, hydrogenated bisphenol A, hydrogenated bisphenol F, an ethylene oxide adduct of bisphenol A (addition number of the ethylene oxide is 26 or less), an ethylene oxide adduct of bisphenol F (addition number of the ethylene oxide is 21 or less), an ethylene oxide adduct of hydrogenated bisphenol A (addition number of the ethylene oxide is 22 or less), an ethylene oxide adduct of hydrogenated bisphenol F (addition number of the ethylene oxide is 17 or less), a propylene oxide adduct of bisphenol A, a propylene oxide adduct of bisphenol F, a propylene oxide adduct of hydrogenated bisphenol A, a propylene oxide adduct of hydrogenated bisphenol F, hydroquinone dihydroxy ethyl ether, p-xylylene glycol, dihydroxyethylsulfone, bis(2-hydroxyethyl)-2,4-tolylenedicarbamate, 2,4-tolylene-bis(2-hydroxyethylcarbamide), bis(2-hydroxyethyl)-m-xylylenedicarbamate and bis(2-hydroxyethyl)isophthalate.

Further, polyether diol compounds of compounds represented by formulae (a), (b), (c), (d) and (e) below are preferably used.

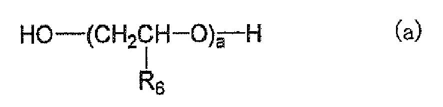

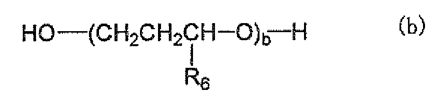

HO-(CH₂CH₂CH₂CH₂-O)_{c}-H (c)

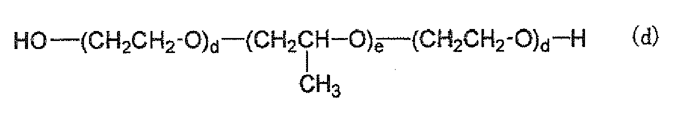

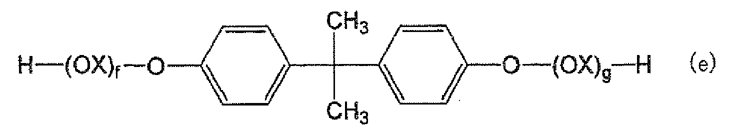

In formulae (a) and (b), R₆ represents a hydrogen atom or a methyl group, provided that R₆ in formula (a) represents a methyl group. X represents a group shown below.

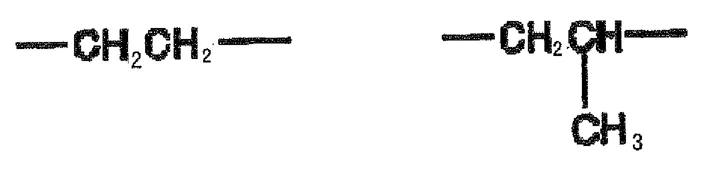

a, b, c, d, e, f and g each represents an integer or 2 or more, and preferably an integer of 2 to 100.

Polyester diol compounds represented by formulae (11) and (12) below are also enumerated as specific examples.

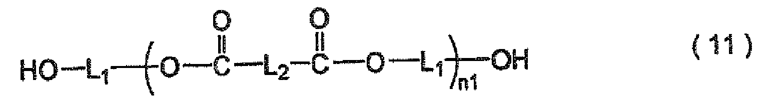

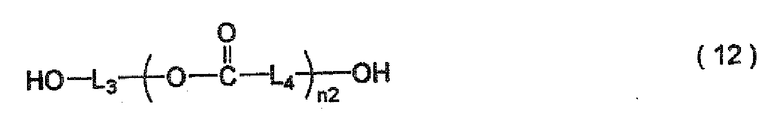

In formulae (11) and (12), L₁, L₂ and L₃, which may be the same or different, each represents a divalent aliphatic or aromatic hydrocarbon group, and L₄ represents a divalent aliphatic hydrocarbon group. Preferably, L₁ L₂ and L₃ each represents an alkylene group, an alkenylene group, an alkynylene group or an arylene group, and L₄ represents an alkylene group. Also, L₁, L₂, L₃ and L₄ each may have other functional group which does not react with the isocyanate group, for example, an ether group, a carbonyl group, an ester group, a cyano group, an olefin group, a urethane group, an amido group, a ureido group or a halogen atom. n1 and n2 each represents an integer of 2 or more, preferably an integer of 2 to 100.

Further, polycarbonate diol compounds represented by formula (13) below are also enumerated as specific examples.

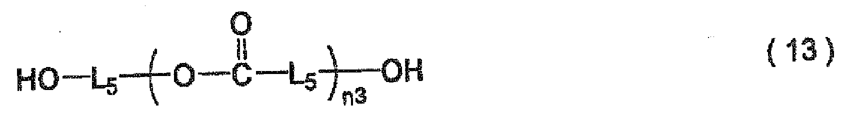

In the formula (13), L₅, which may be the same or different, each represents a divalent aliphatic or aromatic hydrocarbon group. Preferably, L₅ represents an alkylene group, an alkenylene group, an alkynylene group or an arylene group. Also, L₅ may have other functional group which does not react with the isocyanate group, for example, an ether group, a carbonyl group, an ester group, a cyano group, an olefin group, a urethane group, an amido group, a ureido group or a halogen atom. n3 each represents an integer of 2 or more, preferably an integer of 2 to 100.
Specific examples of the diol compound represented by formula (11), (12) or (13) include those shown below. In the specific examples, n represents an integer of 2 or more.

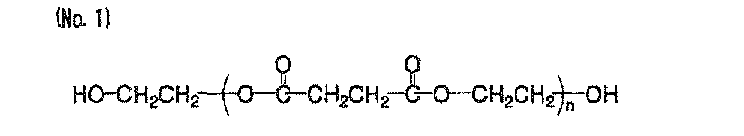

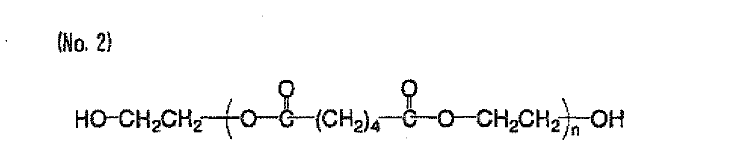

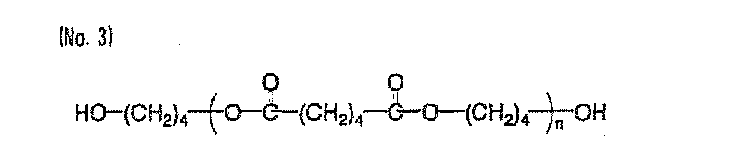

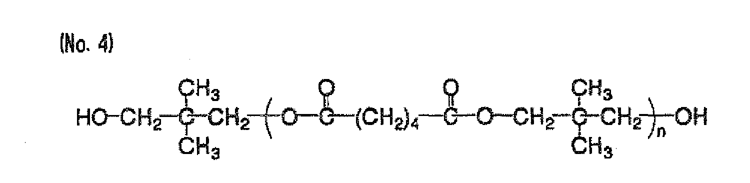

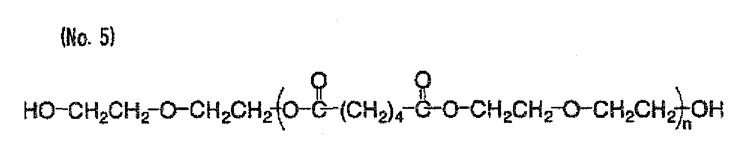

Further, diol compounds shown below are also preferably used.

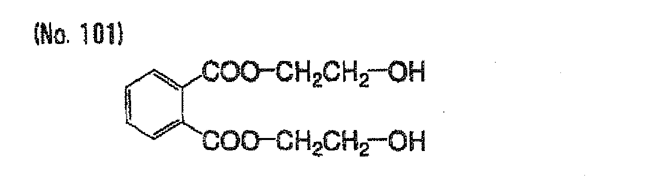

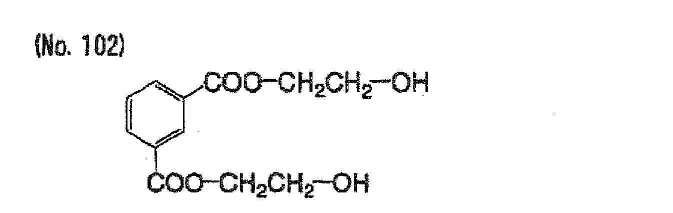

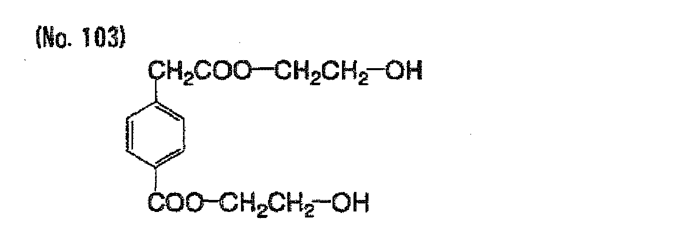

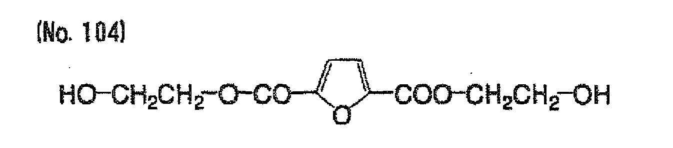

(No. 105) HO-CH₂CH₂-O-CO-CH=CH-COO-CH₂CH₂-OH

(No. 106) HO-CH₂CH₂-O-COC₁₁H₂₂COO-CH₂CH₂-OH

(No. 107) HO-CH₂CH₂-O-COC₁₂H₂₄COO-CH₂CH₂-OH

(No. 108) HO-CH₂CH₂-O-COC₁₄H₂₈COO-CH₂CH₂-OH

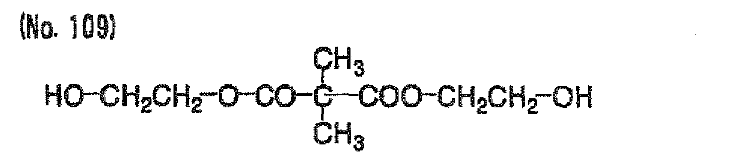

(No. 110) HO-CH₂CH₂-O-CO-C≡C-COO-CH₂CH₂-OH

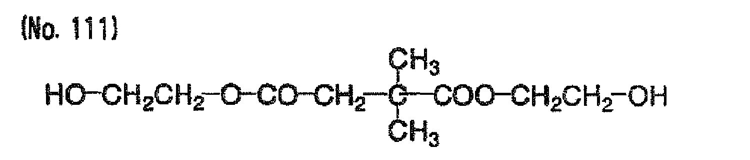

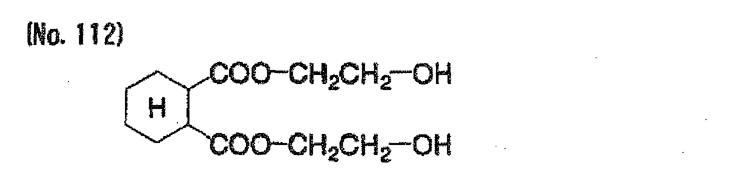

(No. 113) HO-CH₂CH₂-O-CO-CH₂-O-CH₂-COO-CH₂CH₂-OH

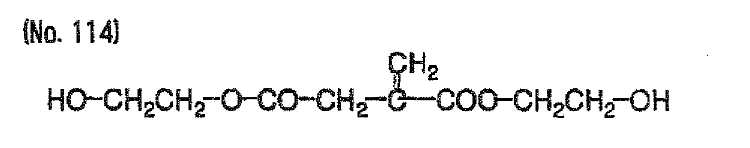

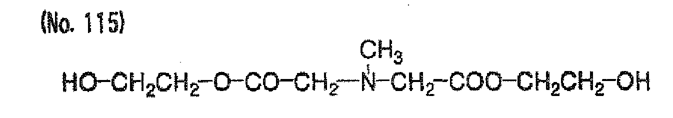

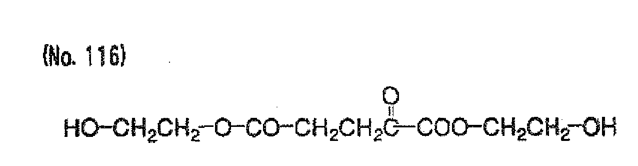

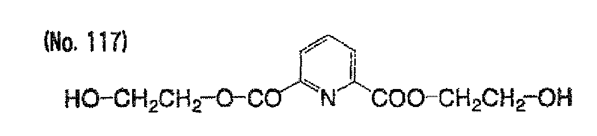

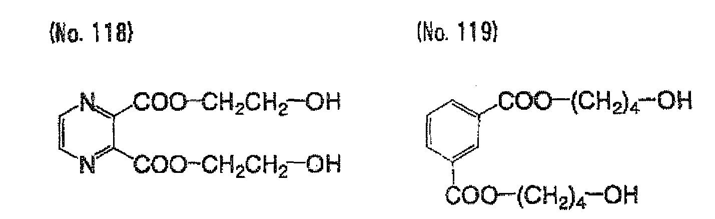

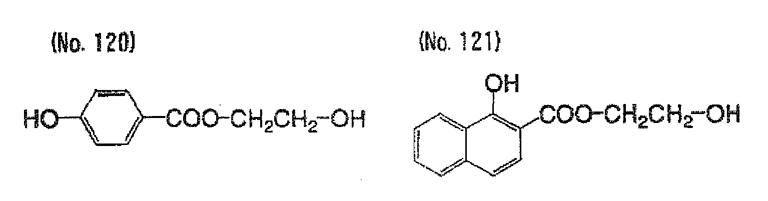

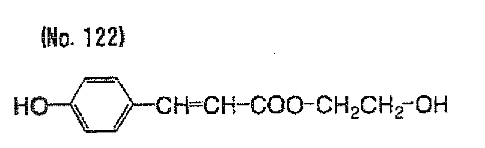

(No. 123) HO-CH₂CH₂-COO-CH₂CH₂-OH

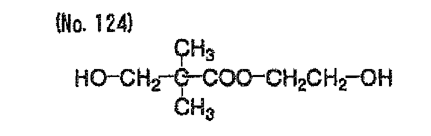

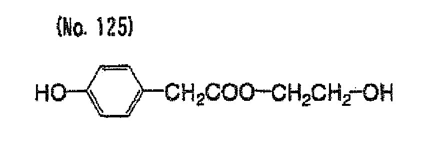

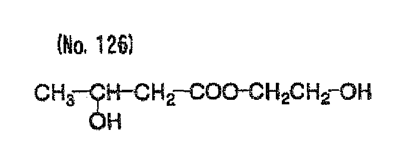

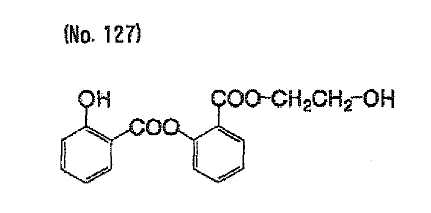

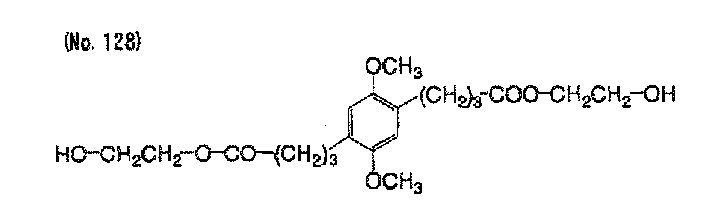

Moreover, diol compounds shown below are also preferably used.

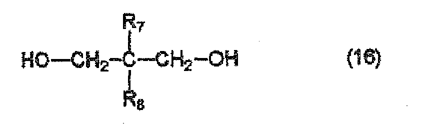

HO-CH₂-C≡C-CH₂-OH (17)

HO-CH₂-CH=CH-CH₂-OH (18)

In the formula (16), R₇ and R₈, which may be the same or different, each represents an alkyl group which may have a substituent, preferably an alkyl group having from 1 to 10 carbon atoms which may have a substituent (for example, a cyano group, a nitro group, a halogen atom (e.g., -F, -Cl, -Br or -I), -CONH₂, -COOR or -OR (wherein R, which may be the same or different, each represents an alkyl group having from 1 to 10 carbon atoms, an aryl group having from 7 to 15 carbon atoms or an aralkyl group)).

Specific examples of the diol compound represented by formula (16) include those shown below.

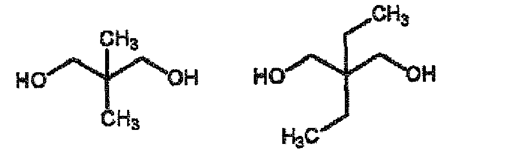

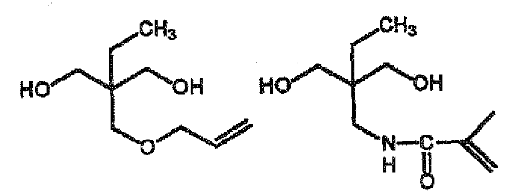

The diol compound represented by formula (17) includes 2-butyne-1,4-diol. The diol compound represented by formula (18) includes cis-2-butene-1,4-diol, trans-2-butene-1,4-diol and the like.
Furthermore, diol compounds represented by formulae (19) and (20) shown below are also preferably used.

HO-L₈-NH-CO-L₉-CO-NH-L₈-OH (19)

HO-L₉-CO-NH-L₈-OH (20)

In the formulae, L₈ and L₉, which may be the same or different, each represents a divalent aliphatic hydrocarbon group, aromatic hydrocarbon group or heterocyclic group, each of which may have a substituent (for example, an alkyl group, an aralkyl group, an aryl group, an alkoxy group, an aryloxy group or a halogen atom (e.g., -F, -Cl, -Br or -I)). L₈ and L₉ each may have other functional group which does not react with the isocyanate group, for example, a carbonyl group, an ester group, a urethane group, an amido group or a ureido group, if desired, Alternatively, L₈ and L₉ may be combined with each other to form a ring.

Specific examples of the diol compound represented by formula (19) or (20) include the compounds shown below.

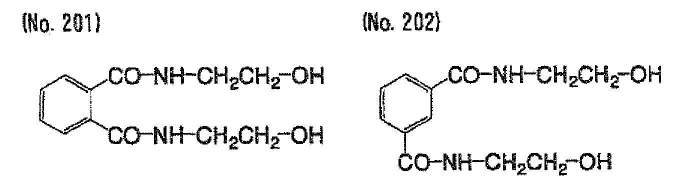

(No. 203) HO-CH₂CH₂-NH-CO-CH=CH-CO-NH-CH₂CH₂-OH

(No. 204) HO-CH₂CH₂-NH-CO-C≡C-CO-NH-CH₂CH₂-OH

(No. 205) HO-CH₂CH₂-NH-CO-(CH₂)₂-CO-NH-CH₂CH₂-OH

(No, 205) HO-CH₂CH₂-NH-CO-(CH₂)₃-CO-NH-CH₂CH₂-OH

(No. 207) HO-CH₂CH₂-NH-CO-(CH₂)₅-CO-NH-CH₂CH₂-OH

(No. 208) HO-CH₂CH₂-NH-CO-(CH₂)₈-CO-NH-CH₂CH₂-OH

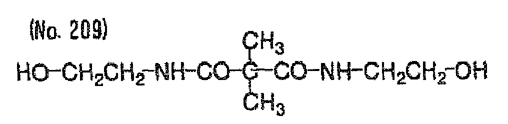

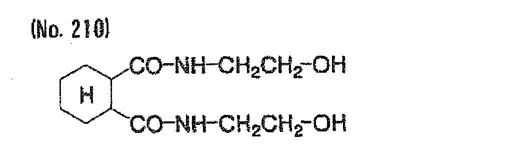

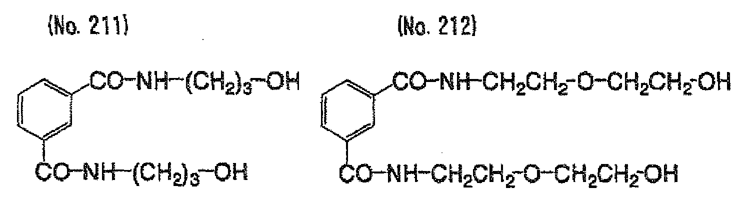

(No. 213) HO-(CH₂)₃-NH-(CH₂)₃-NH-CO-(CH₂)₂-CO-NH-(CH₂)₃-OH

(No. 214) HO-CH₂CH₂-O-CH₂CH₂-NH-CO-(CH₂)₄-CO-NH-CH₂CH₂-O-CH₂CH₂-OH

(No. 215) HO-CH₂CH₂-NH-CO-CH₂-O-CH₂-CO-NH-CH₂CH₂-OH

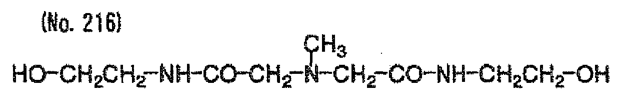

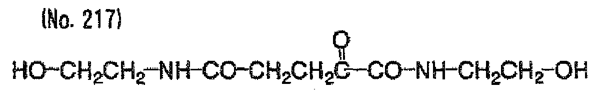

(No. 218) HO-CH₂CH₂-NH-CO-CH₂-S-CH₂-CO-NH-CH₂CH₂-OH

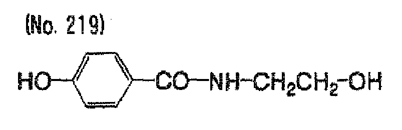

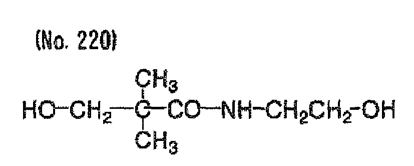

Furthermore, diol compounds represented by formulae (21) and (22) shown below are also preferably used.

HO-Ar₂-(L₁₆-Ar₃)ₙ-OH (21)

HO-Ar₂-L₁₆-OH (22)

In the formulae, L₁₆ represents a divalent aliphatic hydrocarbon group which may have a substituent (for example, an alkyl group, an aralkyl group, an aryl group, an alkoxy group, an aryloxy group or a halogen atom). L₁₆ may have other functional group which does not react with the isocyanate group, for example, an ester group, a urethane group, an amido group or a ureido group, if desired.

Ar₂ and Ar₃, which may be the same or different, each represents a divalent aromatic hydrocarbon group which may have a substituent, preferably an aromatic group having from 6 to 15 carbon atoms. n represents an integer of 0 to 10.
Specific examples of the diol compound represented by formula (21) or (22) include the compounds shown below.

Specifically, catechol, resorcine, hydroquinone, 4-methylcatechol, 4-tert-butylcatechol, 4-acetylcatechol, 3-methoxycatechol, 4-phenylcatechol, 4-methylresorcine, 4-ethylresorcine, 4-tert-butylresorcine, 4-hexylresorcine, 4-chlororesorcine, 4-bezylresorcine, 4-acetylresorcine, 4-carbomethoxyresorcine, 2-methylresorcine, 5-methylresorcine, tert-butylhydroquinone, 2,5-di-tert-butylhydroquinone, 2,5-di-tert-amylhydroquinone, tetramethylhydroquinone, tetrachlorohydroquinone, methylcarboaminohydroquinone, methylureidohydroquinone, methylthiohydroquinone, benzonorbornene-3,6-diol, bisphenol A, bisphenol S, 3,3'-dichlorobisphenol S, 4,4'-dihydroxybenzophenone, 4,4'-dihydroxybiphenyl, 4,4'-thiodiphenol, 2,2'-dihydroxydiphenylmethane, 3,4-bis(p-hydroxyphenyl)hexane, 1,4-bis(2-p-hydroxyphenyl)prapyl)benzene, bis(4-hydroxyphenyl)methylamine, 1,3-dihydroxynaphthalene, 1,4-dihydroxynaphthalene, 1,5-dihydroxynaphthalene, 2,6-dihydroxynaphthalene, 1,5-dihydroxyanthraquinone, 2-hydroxybezyl alcohol, 4-hydroxybezyl alcohol, 2-hydroxy-3,5-di-tert-butylbezyl alcohol, 4-hydroxy-3,5-di-tert-butylbezyl alcohol, 4-hydroxyphenethyl alcohol, 2-hydroxyethyl-4-hydroxybenzoate, 2-hydroxyethyl-4-hydroxyphenylacetate and resorcine mono-2-hydroxyethyl ether are exemplified. The diol compounds shown below are also preferably used.

### (v) Other amino group-containing compound

In the polyurethane resin binder according to the invention, an amino group-containing compound represented by formula (31) or (32) shown below may be used together to react with the diisocyanate compound, thereby forming a urea structure to incorporate into the polyurethane resin.

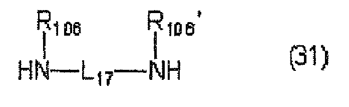

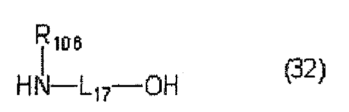

In the formulae, R₁₀₆ and R₁₀₆', which may be the same or different, each represents a hydrogen atom, an alkyl group, an aralkyl group or an aryl group, each of which may have a substituent (for example, an alkoxy group, a halogen atom (e.g., -F, -Cl, -Br or -I), an ester group or a carboxyl group), preferably a hydrogen atom, an alkyl group having from 1 to 8 carbon atoms or an aryl group having from 6 to 15 carbon atoms, each of which may have a carboxyl group as a substituent. L₁₇ represents a divalent aliphatic hydrocarbon group, aromatic hydrocarbon group or heterocyclic group, each of which may have a substituent (for example, an alkyl group, an aralkyl group, an aryl group, an alkoxy group, an aryloxy group, a halogen atom (e.g., -F, -Cl, -Br or -I) or a carboxyl group). L₁₇ may have other functional group which does not react with the isocyanate group, for example, a carbonyl group, an ester group, a urethane group or an amido group, if desired. Alternatively, two of R₁₀₆, L₁₇ and R₁₀₆' may be combined with each other to form a ring.

Specific examples of the compound represented by formula (31) or (32) include the compounds shown below.

Specifically, aliphatic diamine compounds, for example, ethylenediamine, propylenediamine, tetramethylenediamine, pentamethylenediamine, hexamemylenediamine, heptamethylenediamine, octamethylenediamine, dodecamethylenediamine, propane-1,2-diamine, bis(3-aminopropyl)methylamine, 1,3-bis(3-aminopropyl)tetramethylsiloxane, piperazine, 2,5-dimethylpiperazine, N-(2-aminoethyl)piperazine, 4-amino-2,2,6,6-tetramethylpiperidine, N,N-dimethylethylenediamine, lysine, L-cystine or isophorondiamine; aromatic diamine compounds, for example, o-phenylenediamine, m-phenylenediamine, p-phenylenediamine, 2,4-tolylenediamine, benzidine, o-ditoluidine, o-dianisidine, 4-nitro-m-phenylenediamine, 2,5-dimethoxy-p-phenylenediamine, bis(4-aminophenyl)sulfone, 4-carboxy-o-phenylenediamine, 3-carboxy-m-phenylenediamine, 4,4'-diaminophenyl ether or 1,8-naphthalenediamine; heterocyclic amine compounds, for example, 2-aminoimidazole, 3-aminotriazole, 5-amino-1H-tetrazole, 4-aminopyrazole, 2-aminobenzimidazole, 2-amino-5-carboxytriazole, 2,4-diamono-6-methyl-S-triazine, 2,6-diaminopyridine, L-hystidine, DL-tryptophan or adenine; and aminoalcohol or aminophenol compounds, for example, ethanolamine, N-methylethanolamine, N-ethylethanolamine, 1-amino-2-propanol, 1-amino-3-propanol, 2-aminoethoxyethanol, 2-aminothioethoxyethanol, 2-amino-2-methyl-1-propanol, p-aminophenol, m-aminophenol, o-aminophenol, 4-methyl-2-aminophenol, 2-chloro-4-aminophenol, 4-methoxy-3-aminophenol, 4-hydroxybenzylamine, 4-amino-1-naphthol, 4-aminosalicylic acid, 4-hydroxy-N-phenylglycine, 2-aminobenzyl alcohol, 4-aminophenethyl alcohol, 2-carboxy-5-amino-1-naphthol or L-tyrosine are exemplified.

A polyurethane resin obtained by introducing a crosslinkable group into polyurethane having a carboxyl group by a polymer reaction as described in JP-A-2003-270775 may also be used as the binder polymer according to the invention as well as the above-described polyurethane resin obtained by introducing a crosslinkable group into a side chain at the synthesis of polyurethane.

According to the invention, a combination of a monomer having a melting point of 45°C or more with the urethane resin containing a crosslinkable group described above is particularly preferably used. Specific example of the urethane resin is set forth below, but the invention should not be construed as being limited thereto.

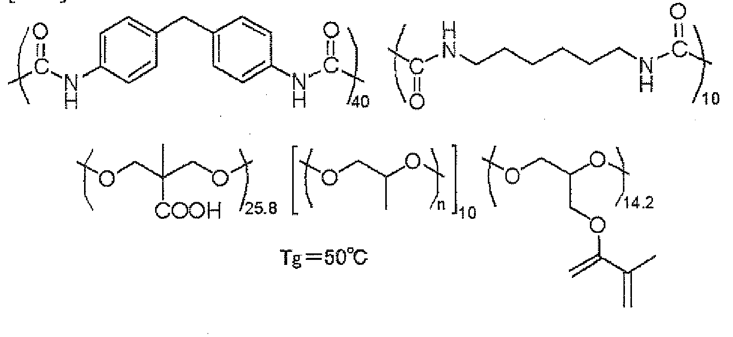

In order to maintain the developing property of the photosensitive layer, it is preferred that the binder polymer used has an appropriate molecular weight. The weight average molecular weight thereof is preferably in a range of 5,000 to 300,000, and more preferably in a range of 20,000 to 150,000.

Although the binder polymer can be incorporated into the photosensitive layer in an appropriate amount, when the amount of the binder polymer exceeds 90% by weight of the photosensitive layer, a preferable result may not be obtained in view of image strength formed or the like in some cases. It is preferably from 10 to 90% by weight, and more preferably from 30 to 80% by weight.

Into the photosensitive layer for use in the invention, other components may be incorporated in addition to the essential components described above, if desired. For instance, the photosensitive layer may contain a dye or pigment capable of absorbing light having a wavelength of a laser emission wavelength for use in the image exposure ± 50 nm. However, such a dye or pigment is different from the sensitizing dye and does not have the function for transmitting energy to the photopolymerization initiator.

The above-described dye or pigment is not particularly restricted as long as it is a dye or pigment which is capable of absorbing light having a wavelength range of a laser emission wavelength ± 50 nm. It is preferably a dye or pigment having an absorption maximum in a wavelength range of a laser emission wavelength ± 50 nm, more preferably a dye or pigment having an absorption maximum in a wavelength range of a laser emission wavelength ± 20 nm, and still more preferably a dye or pigment having an absorption maximum at a wavelength same as a laser emission wavelength.

The exposure by a blue or violet region laser emitting light of 350 to 450 nm is particularly desirable according to the invention, and as the dye or pigment corresponding to the laser, a yellow dye or pigment is desired.

Examples of the yellow dye include yellow acid dyes. Specific examples of the yellow dye include acid dyes described in Senryo Binran (Dye Handbook) and a group of C.I. Acid Yellow. Particularly effective dyes include C.I. Acid Yellow 17, C.I. Acid Yellow 19, C.I. Acid Yellow 23, C.I. Acid Yellow 38, C.I. Acid Yellow 42, C.I. Acid Yellow 61, C.I. Acid Yellow 72 and C.I. Acid Yellow 141.

The dyes set forth below are also preferably used.

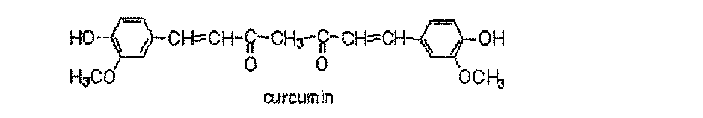

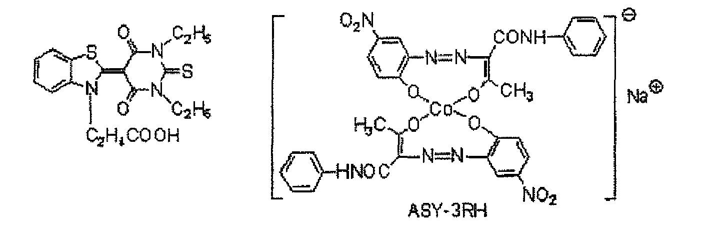

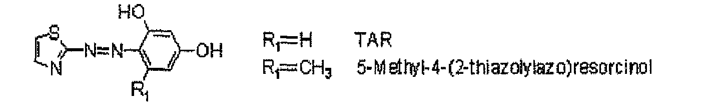

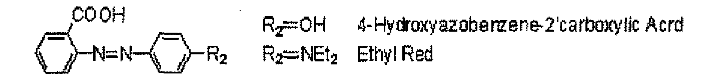

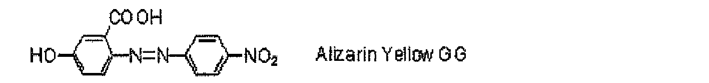

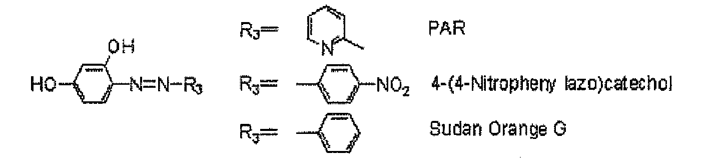

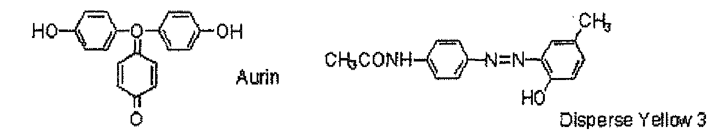

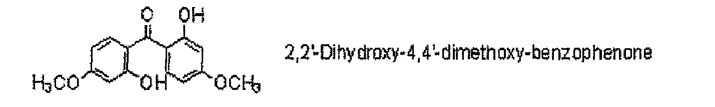

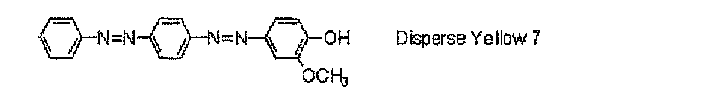

Examples of the yellow pigment include Novoperm Yellow H2G, Seikafast Yellow 2200, Seikafast Yellow 2300, Seikafast Yellow, HOSTACOPY Y501, Yellow master batch, PV Fast Yellow HG, Novoperm Yellow P-HG and Novoperm Yellow M2R.

By using the above-described dye or pigment, the effect for preventing thickening or spreading in the shadow area due to reflected light or scattered light of the laser is achieved and a lithographic printing plate can be provided, which is suitable for high definition AM screen printing or FM screen printing, and particularly, which can provide good printed materials without unevermess of halftone dots in the halftone area even in case of exposure using the FM screen.

The amount of the dye or pigment added to the photosensitive layer is preferably 0.01% by weight or more, more preferably 0.05% by weight or more, based on the weight of the photosensitive layer. Also, from the standpoint of maintaining the amount of light reaching the photosensitive layer and keeping the sensitivity in a preferable range, the amount of the dye or pigment added is preferably 10% by weight or less, more preferably 5% by weight or less.

Further, it is desired to add a small amount of a thermal polymerization inhibitor to the photosensitive layer for use in the invention in order to prevent the addition polymerizable compound having an ethylenically unsaturated double bond from undergoing undesirable thermal polymerization during the production or preservation of the composition (photopolymerization type photosensitive composition) for forming the photosensitive layer. Examples of suitable thermal polymerization inhibitor include hydroquinone, p-methoxyphenol, di-tert-butyl-p-cresol, pyrogallol, tert-butylcatechol, benzoquinone, 4,4'-thiobis(3-methyl-6-tert-butylphenol), 2,2'-methylenebis(4-methyl-6-tert-butylphenol), N-nitrosophenylhydroxyamine cerium(III) salt and N'-nitrosophenylhydroxyamine aluminum salt. The amount of the thermal polymerization inhibitor added is preferably from about 0.01 to about 5% by weight based on the total components of the composition. If desired, in order to prevent polymerization inhibition due to oxygen, a higher fatty acid derivative, for example, behenic acid or behenic acid amide may be added and allowed to localize on the surface of the photosensitive layer during a drying step after the coating. The amount of the higher fatty acid derivative added is preferably from about 0.5 to about 10% by weight based on the total components of the photopolymerization type photosensitive composition.

A coloring agent may be added for the purpose of coloring the photosensitive layer. The coloring agent includes a pigment, for example, phthalocyanine-base pigment (C.I. Pigment Blue 15:3, C.I. Pigment Blue 15:4, C.I. Pigment Blue 15:6 or the like), an azo-base pigment, carbon black or titanium oxide, and a dye, for example, Ethyl Violet, Crystal Violet, an azo dye, an anthraquinone-base dye or a cyanine-base dye. The amount of the coloring agent added is preferably from about 0.5 to about 5% by weight based on the total components of the photopolymerization type photosensitive composition.
In order to improve physical properties of the cured layer, an additive, for example, inorganic filler or a plasticizer, e.g., dioctyl phthalate, dimethyl phthalate or tricresyl phosphate may be added. The amount of the additive added is preferably 10% by weight or less based on the total components of the photopolymerization type photosensitive composition.
To the composition for forming the photosensitive layer can be added a surfactant for improving surface quality of the coating. Preferable examples of the surfactant include a fluorine-based nonionic surfactant.

According to the invention, the composition for photosensitive layer is coated on the support described hereinafter to form a photosensitive layer. In case of coating the composition for photosensitive layer on the support, the photosensitive composition is dissolved in an organic solvent to prepare a coating solution. Examples of the solvent capable of being used include acetone, methyl ethyl ketone, cyclohexane, ethyl acetate, ethylene dichloride, tetrahydrofuran, toluene, ethylene glycol monomethyl ether, ethylene glycol monoethyl ether, ethylene glycol dimethyl ether, propylene glycol monomethyl ether, propylene glycol monoethyl ether, acetylacetone, cyclohexanone, diacetone alcohol, ethylene glycol monomethyl ether acetate, ethylene glycol ethyl ether acetate, ethylene glycol monoisopropyl ether, ethylene glycol monobutyl ether acetate, 3-methoxypropanol, methoxymemoxyethanol, diethylene glycol monomethyl ether, diethylene glycol monoethyl ether, diethylene glycol dimethyl ether, diethylene glycol diethyl ether, propylene glycol monomethyl ether acetate, propylene glycol monoethyl ether acetate, 3-methoxypropyl acetate, N,N-dimethylformamide, dimethyl sulfoxide, γ-butyrolactone, methyl lactate and ethyl lactate. The solvents may be used individually or as a mixture thereof. The concentration of solid content in the coating solution is appropriately from 1 to 50% by weight.
The coating amount of the photosensitive layer of the lithographic printing plate precursor according to the invention is preferably in a range of about 0.1 to about 10 g/m², more preferably in a range of 0.3 to 5 g/m², still more preferably in a range of 0.5 to 3 g/m², in terms of weight after drying.

### [Protective layer]

On the photosensitive layer described above, an oxygen blocking protective layer (overcoat layer) is preferably provided in order to avoid polymerization inhibiting function of oxygen.
The coating amount of the protective layer is preferably in a range of 0.5 to 3.0 g/m². When the coating amount is less than 0.5 g/m², the sensitivity may decrease in some cases, whereas when it exceeds 3.0 g/m², the burden on treatment process may increase in some cases. The coating amount is preferably in a range of 0.7 to 2.5 g/m².

The protective layer preferably contains a water-soluble polymer. The water-soluble polymer specifically includes, for example, polyvinyl alcohol, a partial ester, ether or acetal thereof and a copolymer thereof containing a substantial amount of an unsubstituted vinyl alcohol unit necessary for providing the water-solubility. The polyvinyl alcohol preferably has a hydrolysis degree of 71 to 100% and a polymerization degree of 300 to 2,400. Specifically, PVA-105, PVA-110, PVA-117, PVA-117H, PVA-120, PVA-124, PVA-124H, PVA-CS, PVA-CST, PVA-HC, PVA-203, PVA-204, PVA-205, PVA-210, PVA-217, PVA-220, PVA-224, PVA-217EE, PVA-217E, PVA-220E, PVA-224E, PVA-405, PVA-420, PVA-613 and L-8, produced by Kuraray Co., Ltd., are exemplified. Further, polyvinyl acetate chloroacetate or propionate, polyvinyl formal and polyvinyl acetal each hydrolyzed to an extent of 88 to less than 100% are exemplified. Other useful water-soluble polymers include polyvinyl pyrrolidone, gelatin, gum arabic and the like. The water-soluble polymers may be used individually or in combination.
In order to obtain the particularly preferable results according to the invention, it is desired to use polyvinyl alcohol having a hydrolysis degree of 95% or more.

In the protective layer, a modified polyvinyl alcohol may also be used. In particular, an acid-modified polyvinyl alcohol is preferably used.

### (Acid-modified polyvinyl alcohol)

The acid-modified polyvinyl alcohol is not particularly restricted as long as it is a vinyl alcohol polymer containing an appropriate amount of an acid group. Particularly, a vinyl alcohol polymer including appropriate amount of a sulfonic acid group or a carboxyl group is preferably used. The former is referred to as a sulfonic acid-modified polyvinyl alcohol and the latter is referred to as a carboxylic acid-modified polyvinyl alcohol.
The acid-modified polyvinyl alcohol is preferably synthesized by a method wherein a monomer having an acid group is copolymerized with vinyl acetate and then the vinyl acetate is partially or wholly saponified to change to vinyl alcohol. However, it is also possible to synthesize by connecting a compound having an acid group to a hydroxy group of polyvinyl alcohol.

Examples of the monomer having a sulfonic acid group include ethylenesulfonic acid, allylsulfonic acid, methallylsulfonic acid, 2-acrylamido-2-methylpropanesulfonic acid and salts thereof. Examples of the compound having a sulfonic acid group include an aldehyde derivative having a sulfonic acid group, for example, p-sulfonic acid benzaldehyde and salts thereof. The compound can be introduced by a conventionally known acetalization reaction.

Examples of the monomer having a carboxyl group include fumaric acid, maleic acid, itaconic acid, maleic anhydride, phthalic anhydride, trimellitic anhydride, acrylic acid and salts thereof, an acrylic acid ester, for example, methyl acrylate, and a methacrylic acid ester, for example, methyl methacrylate. Examples of the compound having a carboxyl group include a monomer, for example, acrylic acid. The compound can be introduced according to a conventionally known Michael addition reaction.
The acid-modified polyvinyl alcohol may be a compound appropriately synthesized or a commercially available compound.
The acid-modified polyvinyl alcohol can avoid degradation of the removability of photosensitive layer by development. Particularly, the acid-modified polyvinyl alcohol having a saponification degree of 91% by mole or more is preferred.
Specific examples of the acid-modified polyvinyl alcohol having such a high saponification degree include as the carboxy-modified polyvinyl alcohol, for example, KL-118 (saponification degree: 97% by mole, average polymerization degree: 1,800), KM-618 (saponification degree: 94% by mole, average polymerization degree: 1,800), KM-118 (saponification degree: 97% by mole, average polymerization degree: 1,800) and KM-106 (saponification degree: 98.5% by mole, average polymerization degree: 600) produced by Kuraray Co., Ltd., GOSENAL T-330H (saponification degree: 99% by mole, average polymerization degree: 1,700), GOSENAL T-330 (saponification degree: 96.5% by mole, average polymerization degree: 1,700), GOSENAL T-350 (saponification degree: 94% by mole, average polymerization degree: 1,700), GOSENAL T-230 (saponification degree: 96.5% by mole, average polymerization degree: 1,500), GOSENAL T-215 (saponification degree: 96.5% by mole, average polymerization degree: 1,300) and GOSENAL T-HS-1 (saponification degree: 99% by mole, average polymerization degree: 1,300) produced by Nippon Synthetic Chemical Industry Co., Ltd., and AF-17 (saponification degree: 96.5% by mole, average polymerization degree: 1,700) and AT-17 (saponification degree: 93.5% by mole, average polymerization degree: 1,700) produced by Japan VAM & Poval Co., Ltd. Also, as the sulfonic acid-modified polyvinyl alcohol, for example, SK-5102 (saponification degree: 98% by mole, average polymerization degree: 200) produced by Kuraray Co., Ltd. and GOSERAN CKS-50 (saponification degree: 99% by mole, average polymerization degree: 300) produced by Nippon Synthetic Chemical Industry Co., Ltd. are exemplified.

Further, in view of preventing more effectively the degradation of the removability of photosensitive layer by development, it is particularly preferred to use the acid-modified polyvinyl alcohol having an average polymerization degree of vinyl alcohol unit of 100 to 800. By using the acid-modified polyvinyl alcohol having such a low polymerization degree and a high saponification degree, a protective layer which is effectively preventing the degradation of the removability of photosensitive layer by development while maintaining the excellent characteristic of oxygen-blocking property can be obtained.

As the acid-modified polyvinyl alcohol having a low polymerization degree and a high saponification degree as described above, a carboxy-modified polyvinyl alcohol modified with itaconic acid or maleic acid or sulfonic acid-modified polyvinyl alcohol having a saponification degree of 91 % by mole or more and an average polymerization degree of vinyl alcohol unit of 100 to 800 is preferred.
The modification degree of the acid-modified polyvinyl alcohol means a molar ratio of unit having an acid group contained in a copolymer of the acid-modified polyvinyl alcohol. The modification degree of the acid-modified polyvinyl alcohol is preferably from 0.1 to 20% by mole, and more preferably from 0.2 to 5% by mole.

As a solvent used for preparing a coating solution for protective layer, although pure water is preferred, a mixture of pure water with an alcohol, for example, methanol or ethanol or a ketone, for example, acetone or methyl ethyl ketone may also be used. The concentration of the solid content in the coating solution is appropriately from 1 to 20% by weight. To the protective layer may be added known additives, for example, a surfactant for improving coating property or a water-soluble plasticizer for improving physical property of the coated layer. The water-soluble plasticizer includes, for example, propionamide, cyclohexanediol, glycerin, sorbitol and the like. Also, a water-soluble (meth)acrylic polymer may be added. The coating amount of the protective layer is preferably in a range of about 0.1 to about 15 g/m², more preferably in a range of 1.0 to about 5.0 g/m², in terms of weight after drying.

### [Method of preparing lithographic printing plate]

Now, a method of preparing a lithographic printing plate using the lithographic printing plate precursor according to the invention is described in detail below. The method of preparing a lithographic printing plate according to the invention comprises after image exposure (exposure step) of the lithographic printing plate precursor, processing (development step) the exposed lithographic printing plate precursor with an aqueous solution containing a carbonate ion, a hydrogen carbonate ion and a water-soluble polymer compound. A step of exposing to light and/or heating the entire surface of lithographic printing plate precursor may be provided between the exposure step and the development step and/or after the development step, if desired.

The image exposure of the lithographic printing plate precursor is performed by a method of exposing through a transparent original having a line image, a halftone dot image or the like or a method of scanning of laser beam based on digital data. The desirable wavelength of the light source is from 350 to 450 nm.

As for the available laser light source emitting light of 350 to 450 nm, the followings can be utilized. As a gas laser, Ar ion laser (364 nm, 351 nm, 10 mW to 1 W), Kr ion laser (356 nm, 351 nm, 10 mW to 1 W) and He-Cd laser (441 nm, 325 nm, 1 mW to 100 mW); as a solid laser, a combination of Nd:YAG (YVO₄) with SHG crystalsxtwice (355 nm, 5 mW to 1 W) and a combination of Cr:LiSAF with SHG crystal (430 nm, 10 mW); as a semiconductor laser system, a KNbO₃ ring resonator (430 nm, 30 mW), a combination of a waveguide-type wavelength conversion element with an AlGaAs or InGaAs semiconductor (380 nm to 450 nm, 5 mW to 100 mW), a combination of a waveguide-type wavelength conversion element with an AlGaInP or AlGaAs semiconductor (300 nm to 350 nm, 5 mW to 100 mW) and AlGaInN (350 nm to 450 nm, 5 mW to 30 mW); and as a pulse laser, N₂ laser (337 nm, pulse 0.1 to 10 mJ) and XeF (351 nm, pulse 10 to 250 mJ). Among them, an AlGaInN semiconductor laser (commercially available InGaN semiconductor laser, 400 to 410 nm, 5 to 30 mW) is preferred in view of the wavelength characteristics and cost.

As for the exposure device for the lithographic printing plate precursor of scanning exposure system, the exposure mechanism may be any of an internal drum system, an external drum system and a flat bed system. As the light source, among the light sources described above, those capable of conducting continuous oscillation can be preferably utilized.

Further, as other examples of the exposure light source usable in the invention, an ultra-high pressure, high pressure, medium pressure or low pressure mercury lamp, a chemical lamp, a carbon arc lamp, a xenon lamp, a metal halide lamp, various visible or ultraviolet laser lamps, a fluorescent lamp, a tungsten lamp, sunlight and the like are exemplified.

Now, the development step is described in detail. A conventional processing process comprises removing a protective layer in a pre-water washing step, conducting alkali development, removing the alkali in a post-water washing step, conducting gum treatment in a gumming step and drying in a drying step. On the contrary, according to the invention, it is characterized to conduct the development and gumming at the same time by using an aqueous solution containing a carbonate ion, a hydrogen carbonate ion and a water-soluble polymer compound. Thus, the post-water washing step is not particularly necessary, and after conducting the development and gumming with one solution, the drying step can be performed. Moreover, since the removal of protective layer can also be conducted simultaneously with the development and gumming, the pre-water washing step is also unnecessary. It is preferred that after the development and gumming, the excess processing solution is removed using a squeeze roller or the like, followed by drying.

The development step is preferably performed by an automatic processor equipped with a rubbing member. As the automatic processor, for example, an automatic processor in which a lithographic printing plate precursor after image exposure is subjected to a rubbing treatment while it is transported described in JP-A-2-220061 and JP-A-60-59351, and an automatic processor in which a lithographic printing plate precursor after image exposure placed on a cylinder is subjected to a rubbing treatment while rotating the cylinder described in U.S. Patents 5,148,746 and 5,568,768 and British Patent 2,297,719 are exemplified. Among them, the automatic processor using a rotating brush roll as the rubbing member is particularly preferred.

The rotating brush roller which can be used in the invention can be appropriately selected by taking account of scratch resistance of the image area, and further, nerve strength of the support of the lithographic printing plate precursor and the like. As for the rotating brush roller, a known rotating brush roller produced by implanting a brush material in a plastic or metal roller can be used. For example, a rotating brush roller described in JP-A-58-159533 and JP-A-3-100554, or a brush roller in which a metal or plastic groove-type member having implanted therein in rows a brush material is closely radially wound around a plastic or metal roller acting as a core as described in JP-U-B-62-167253 can be used.
As the brush material, a plastic fiber (for example, a polyester-based, e.g., polyethylene terephthalate or polybutylene terephthalate, a polyamide-based, e.g., nylon 6.6 or nylon 6.10, a polyacrylic based, e.g., polyacrylonitrile or polyalkyl (meth)acrylate, and a polyolefin-based, e.g., polypropylene or polystyrene) can be used. For instance, a brush material having a fiber bristle diameter of 20 to 400 µm and a bristle length of 5 to 30 mm can be preferably used.
The outer diameter of the rotating brush roller is preferably from 30 to 200 mm, and the peripheral velocity at the tip of the brush rubbing the plate surface is preferably from 0.1 to 5 m/sec. It is preferred to use a plurality of the rotating brush rollers.

The rotary direction of the rotating brush roller may be the same direction or the opposite direction with respect to the transporting direction of the lithographic printing plate precursor, but when two or more rotating brush rollers are used, it is preferred that at least one rotating brush roller rotates in the same direction and at least one rotating brush roller rotates in the opposite direction with respect to the transporting direction. By such arrangement, the non-image area of the photosensitive layer is more steadily removed. Further, it is also effective to rock the rotating brush roller in the rotation axis direction of the brush roller.

After the development step, a drying step is preferably provided continuously or discontinuously. The drying is conducted using hot air, an infrared ray, a far-infrared ray or the like.

An example of the structure of automatic processor preferably used in the method of preparing a lithographic printing plate according to the invention is schematically shown in Fig. 1. The automatic processor shown in Fig. 1 comprises basically a developing unit 6 and a drying unit 10. A lithographic printing plate precursor 4 is subjected to the development and gumming in a developing bath 20 and dried in the drying unit 10.

A processing solution (hereinafter, also referred to as a developer) for use in the development step is an aqueous solution containing a carbonate ion, a hydrogen carbonate ion and a water-soluble polymer compound. Due to the presence of a carbonate ion and a hydrogen carbonate ion, a buffer function is expressed and fluctuation of the pH can be prevented even when the developer is used for a long period of time. Thus, the deterioration of developing property resulting from the fluctuation of pH, the occurrence of development scum and the like are restrained. In order for a carbonate ion and a hydrogen carbonate ion to be present in a developer, a carbonate and a hydrogen carbonate may be added to the developer or a carbonate ion and a hydrogen carbonate ion may be generated by adding a carbonate or a hydrogen carbonate to a developer and then adjusting the pH. The carbonate or hydrogen carbonate used is not particularly restricted and it is preferably an alkali metal salt thereof. As the alkali metal, lithium, sodium and potassium are exemplified and sodium is particularly preferred. The alkali metals may be used individually or in combination of two or more thereof.
The pH of the developer is not particularly restricted as long as it is pH at which the buffer function is expressed and is preferably in a range of 8.5 to 10.8. When the pH is lower than 8.5, the developing property of the non-image area is degraded. When the pH is higher 10.8, the processing ability is degraded due to the influence of carbon dioxide in the atmosphere.

The total amount of the carbonate ion and hydrogen carbonate is preferably from 1 to 20% by weight, more preferably from 3 to 15% by weight, particularly preferably from 4 to 12% by weight, based on the weight of the aqueous alkali solution. When the total amount is 1% by weight or more, the developing property and processing ability are not degraded. When the total amount is 20% by weight or less, precipitates and crystals hardly generate and since gelation at neutralization of waste liquid of the developer hardly occur, treatment of the waste liquid can be carried out without trouble.

Further, for the purpose of finely adjusting the alkali concentration or aiding dissolution of the photosensitive layer in the non-image area, ether alkali agent, for example, an organic alkali agent may be supplementarily used together. The organic alkali agent includes monomethylamine, dimethylamine, trimethylamine, monoethylamine, diethylamine, triethylamine, monoisopropylamine, diisopropylamine, triisopropylamine, n-butylamine, monoethanolamine, diethanolamine, triethanolamine, monoisopropanolamine, diisopropanolamine, ethyleneimine, ethylenediamine, pyridine, tetramethylammonium hydroxide and the like. The supplementary alkali agents may be used individually or in combination of two or more thereof

As the water-soluble polymer compound for use in the invention, soybean polysaccharide, modified starch, gum arabic, dextrin, a cellulose derivative (for example, carboxymethyl cellulose, carboxyethyl cellulose or methyl cellulose) and a modified product thereof, pllulan, polyvinyl alcohol and a derivative thereof, polyvinyl pyrrolidone, polyacrylamide, an acrylamide copolymer, a vinyl methyl ether/maleic anhydride copolymer, a vinyl acetate/maleic anhydride copolymer, a styrene/maleic anhydride copolymer and the like are exemplified. An acid value of the water-soluble polymer compound is preferably from 0 to 3.0 meq/g.

As the soybean polysaccharide, that conventionally known can be used. For example, as a commercial product, SOYAFIVE (produced by Fuji Oil Co., Ltd.) is available and various grade products can be used. The soybean polysaccharide preferably used has viscosity in a range of 10 to 100 mPa/sec in a 10% by weight aqueous solution thereof.

As the modified starch, that represented by formula (III) shown below is preferred. For the modified starch represented by formula (III), any starch of corn, potato, tapioca, rice, wheat or the like can be used. The modification of the starch can be performed by a method wherein the starch is decomposed with an acid, an enzyme or the like to an extent that the number of glucose residue per molecule is from 5 to 30 and then is added thereto oxypropylene in an alkali, or the like.

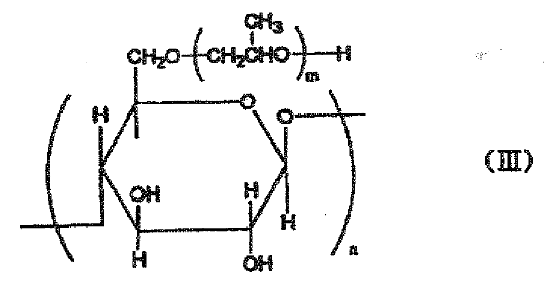

In formula (III), the etherification degree (substitution degree) is in a range of 0.05 to 1.2 per glucose unit, n represents an integer of 3 to 30, and m represents an integer of 1 to 3.

Of the water-soluble polymer compounds, soybean polysaccharide, modified starch, gum arabic, dextrin, carboxymethyl cellulose, polyvinyl alcohol and the like are particularly preferred.
The water-soluble polymer compounds may be used in combination of two or more. The content of the water-soluble polymer compound in the processing solution is preferably from 0.1 to 20% by weight, and more preferably from 0.5 to 10% by weight.

The processing solution may contain a surfactant (for example, an anionic, nonionic or cationic surfactant).
The anionic surfactant includes fatty acid salts, abietic acid salts, hydroxyalkanesulfonic acid salts, alkanesulfonic acid salts, dialkylsulfosuccinic acid salts, straight-chain alkylbenzenesulfonic acid salts, branched alkylbenzenesulfonic acid salts, alkylnaphthalenesulfonic acid salts, alkylphenoxy polyoxyethylene propylsulfonic acid salts, polyoxyethylene alkylsulfophenyl ether salts, N-methyl-N-oleyltaurine sodium salt, N-alkylsulfosuccinic acid monoamide disodium salts, petroleum sulfonic acid salts, sulfated castor oil, sulfated beef tallow oil, sulfate ester slats of fatty acid alkyl ester, alkyl sulfate ester salts, polyoxyethylene alkyl ether sulfate ester salts, fatty acid monoglyceride sulfate ester salts, polyoxyethylene alkyl phenyl ether sulfate ester salts, polyoxyethylene styryl phenyl ether sulfate ester salts, alkyl phosphate ester salts, polyoxyethylene alkyl ether phosphate ester salts, polyoxyethylene alkyl phenyl ether phosphate ester salts, partially saponified products of styrene-maleic anhydride copolymer, partially saponified products of olefin-maleic anhydride copolymer, naphthalene sulfonate formalin condensates and the like. Of the compounds, dialkylsulfosuccinic acid salts, alkyl sulfate ester salts and alkylnaphthalenesulfonic acid salts are particularly preferably used.

The cationic surfactant is not particularly limited and conventionally known cationic surfactants can be used. For example, alkylamine salts, quaternary ammonium salts, polyoxyethylene alkyl amine salts and polyethylene polyamine derivatives are exemplified.

The nonionic surfactant include polyethylenes glycol type higher alcohol ethylene oxide addacts, alkylphenol ethylene oxide addacts, fatty acid ethylene oxide addacts, polyhydric alcohol fatty acid ester ethylene oxide addacts, higher alkylamine ethylene oxide addacts, fatty acid amide ethylene oxide addacts, ethylene oxide addacts of fat, polypropylene glycol ethylene oxide addacts, dimethylsiloxane-ethylene oxide block copolymers, dimethylsiloxane-(propylene oxide-ethylene oxide) block copolymers, fatty acid esters of polyhydric alcohol type glycerol, fatty acid esters of pentaerythritol, fatty acid esters of sorbitol and sorbitan, fatty acid esters of sucrose, alkyl ethers of polyhydric alcohols, fatty acid amides of alkanolamines and the like.

In the invention, ethylene oxide addacts of sorbitol and/or sorbitan fatty acid esters, polypropylene glycol ethylene oxide addacts, dimethylsiloxane-ethylene oxide block copolymers, dimethylsiloxane-(propylene oxide-ethylene oxide) block copolymers and fatty acid esters of polyhydric alcohols are more preferred.

Further, from the standpoint of stable solubility in water or opacity, with respect to the nonionic surfactant, the HLB (hydrophile-lipophile balance) value thereof is preferably 6 or more, and more preferably 8 or more. Moreover, an oxyethylene adduct of acetylene glycol type or acetylene alcohol type or a surfactant of fluorine-based, silicon-based or the like can also be used.
The surfactants may be used individually or in combination. The content of the surfactant in the developer is preferably from 0.01 to 10% by weight, and more preferably from 0.01 to 5% by weight.

The processing solution in the invention may contain a wetting agent, an antiseptic agent, a chelating agent, a defoaming agent, an organic acid, an organic solvent, an inorganic acid, an inorganic salt or the like in addition the components described above.

As the wetting agent, ethylene glycol, propylene glycol, triethylene glycol, butylene glycol, hexylene glycol, diethylene glycol, dipropylene glycol, glycerin, trimethylol propane, diglycerin or the like is preferably used. The wetting agents may be used individually or in combination of two or more thereof The wetting agent is ordinarily used in an amount of 0.1 to 5% by weight based on the total weight of the processing solution.

As the antiseptic agent, phenol or a derivative thereof, formalin, an inidazole derivative, sodium dehydroacetate, a 4-isothiazolin-3-one derivative, benzisotiazolin-3-one, 2-methyl-4-isothiazolin-3-one, a benzotriazole derivative, an amidine guanidine derivative, a quaternary ammonium salt, a derivative of pyridine, quinoline, guanidine or the like, diazine, a triazole derivative, oxazole, an oxazine derivative, a nitrobromoalcohol-based compound, e.g., 2-bromo-2-nitropropane-1,3-diol, 1,1-dibromo-1-nitro-2-ethanol, 1,1-dibromo-1-nitro-2-propanol or the like is preferably used. It is preferred to use two or more kinds of the antiseptic agents so as to exert the effect to various molds and bacteria. The amount of the antiseptic agent added is an amount stably exerts the effect to bacterium, molds, yeast or the like. Although the amount of the antiseptic agent may be varied depending on the kind of the bacterium, molds, yeast or the like, it is preferably in a range of 0.01 to 4% by weight based on the processing solution.

As the chelating agent, for example, ethylenediaminetetraacetic acid, potassium salt thereof, sodium salt thereof; diethylenetriaminepentaacetic acid, potassium salt thereof, sodium salt thereof; triethylenetetraminehexaacetic acid, potassium salt thereof, sodium salt thereof; hydroxyethylethylenediaminetriacetic acid, potassium salt thereof, sodium salt thereof; nitrilotriacetic acid, sodium salt thereof; an organic phosphonic acid, for example, 1-hydroxyethane-1,1-diphosphonic acid, potassium salt thereof, sodium salt thereof, aminotri(methylenephosphonic acid), potassium salt thereof, sodium salt thereof or a phosphonoalkanetricarboxylic acid is exemplified. A salt of an organic amine is also effectively used in place of the sodium salt or potassium salt in the chelating agent.
The chelating agent is so selected that it is stably present in the processing solution composition and does not impair the printing property. The amount of the chelating agent added is preferably from 0.001 to 1.0% by weight based on the processing solution.

As the defoaming agent, a conventional silicone-based self-emulsifying type or emulsifying type defoaming agent, a nonionic compound having HLB of 5 or less or the like is used. The silicone defoaming agent is preferably used. Any of emulsifying dispersing type, solubilizing type and the like can be used. The content of the defoaming agent is preferably from 0.001 to 1.0% by weight based on the processing solution.

As the organic acid, citric acid, acetic acid, oxalic acid, malonic acid, salicylic acid, caprylic acid, tartaric acid, malic acid, lactic acid, levulinic acid, p-toluenesulfonic acid, xylenesulfonic acid, phytic acid, an organic phosphonic acid or the like is exemplified. The organic acid can also be used in the form of an alkali metal salt or an ammonium salt. The content of the organic acid is preferably from 0.01 to 0.5% by weight based on the processing solution.

As the organic solvent, for example, an aliphatic hydrocarbon (e.g., hexane, heptane, ISOPAR E, ISOPAR H, ISOPAR G (produced by ESSO Chemical Co., Ltd.), gasoline or kerosene), an aromatic hydrocarbon (e.g., toluene or xylene), a halogenated hydrocarbon (e.g., methylene dichloride, ethylene dichloride, trichlene or monochlorobenzene) or a polar solvent is exemplified.

As the polar solvent, an alcohol (e.g., methanol, ethanol, propanol, isopropanol, benzyl alcohol, ethylene glycol monomethyl ether, 2-ethyoxyethanol, diethylene glycol monoethyl ether, diethylene glycol monohexyl ether, triethylene glycol monomethyl ether, propylene glycol monoethyl ether, propylene glycol monomethyl ether, polyethylene glycol monomethyl ether, polypropylene glycol, tetraethylene glycol, ethylene glycol monobutyl ether, ethylene glycol monobenzyl ether, ethylene glycol monophenyl ether, methyl phenyl carbinol, n-amyl alcohol or methylamyl alcohol), a ketone (e.g., acetone, methyl ethyl ketone, ethyl butyl ketone, methyl isobutyl ketone or cyclohexanone), an ester (e.g., ethyl acetate, propyl acetate, butyl acetate, aryl acetate, benzyl acetate, methyl lactate, butyl lactate, ethylene glycol monobutyl acetate, polyethylene glycol monomethyl ether acetate, diethylene glycol acetate, diethyl phthalate or butyl levulinate), others (e.g., triethyl phosphate, tricresyl phosphate, N-phenylethanolamine or N-phenyldiethanolamine) or the like is exemplified.

Further, when the organic solvent is insoluble in water, it may be employed by being solubilized in water using a surfactant or the like. In the case where the developer contains the organic solvent, the concentration of the organic solvent is desirably less than 40% by weight in view of safety and inflammability.

As the inorganic acid or inorganic salt, phosphoric acid, methaphosphoric acid, ammonium primary phosphate, ammonium secondary phosphate, sodium primary phosphate, sodium secondary phosphate, potassium primary phosphate, potassium secondary phosphate, sodium tripolyphosphate, potassium pyrophosphate, sodium hexamethaphosphate, magnesium nitrate, sodium nitrate, potassium nitrate, ammonium nitrate, sodium sulfate, potassium sulfate, ammonium sulfate, sodium sulfite, ammonium sulfite, sodium hydrogen sulfate, nickel sulfate or the like is exemplified. The content of the inorganic salt is preferably from 0.01 to 0.5% by weight based on the total weight of the processing solution.

The temperature of the development is ordinarily 60°C or lower, and preferably from about 15 to about 40°C. In the case of conducting the development processing using an automatic developing machine, the developer becomes fatigued in accordance with the processing amount, and hence the processing ability may be restored using a replenisher or a fresh developer.

In the method of preparing a lithographic printing plate according to the invention, the entire surface of the lithographic printing plate precursor may be heated between the exposure and the development, if desired. By the heating, the image-forming reaction in the image-recording layer is accelerated and advantages, for example, improvements in the sensitivity and printing durability and stabilization of the sensitivity may be achieved.

The conditions of the heating can be appropriately determined in a range for achieving such effects. As the heating means, a conventional convection oven, an IR irradiation apparatus, an IR laser, a microwave apparatus, a Wisconsin oven or the like is exemplified. For instance, the heat treatment can be conducted by maintaining the lithographic printing plate precursor at a plate surface temperature ranging from 70 to 150°C for a period of one second to 5 minutes, preferably at 80 to 140°C for 5 to one minute, more preferably at 90 to 130°C for 10 to 30 seconds. The above-described range is preferred because the effects described above are efficiently achieved and an adverse affect, for example, change in shape of the lithographic printing plate precursor due to the heat can be preferably avoided.
It is preferred that a heat treatment means used in the heat treatment step is connected with a plate setter used in the exposure step and a development apparatus used in the development processing step and the lithographic printing plate precursor is subjected to automatically continuous processing. Specifically, a plate making line wherein the plate setter and the development apparatus are connected with each other by transport means, for example, a conveyer is exemplified. Also, the heat treatment means may be placed between the plate setter and the development apparatus or the heat treatment means and the development apparatus may constitute a unit apparatus.

In case where the lithographic printing plate precursor used is apt to be influenced by surrounding light under a working environment, it is preferred that the plate making line is blinded by a filter, a cover or the like.
The entire surface of lithographic printing plate after development may be exposed to active ray, for example, ultraviolet light to accelerate curing of the image area. As a light source for the entire surface exposure, for example, a carbon arc lamp, a mercury lamp, a gallium lamp, a metal halide lamp, a xenon lamp, a tungsten lamp or various laser beams is exemplified. In order to obtain sufficient printing durability, the amount of the entire surface exposure is preferably 10 mJ/cm² or more, and more preferably 100 mJ/cm² or more.
Heating may be performed at the same time with the entire surface exposure. By performing the heating, further improvement in the printing durability is recognized. Examples of the heating means include a conventional convection oven, an IR irradiation apparatus, an IR laser, a microwave apparatus or a Wisconsin oven. The plate surface temperature at the heating is preferably from 30 to 150°C, more preferably from 35 to 130°C, and still more preferably from 40 to 120°C. Specifically, a method described in JP-A-2000-89478 can be utilized.
Further, for the purpose of increasing printing durability, the lithographic printing plate after development can be heated under very strong conditions. The heat temperature is ordinarily in a range of 200 to 500°C. When the temperature is too low, a sufficient effect of strengthening the image may not be obtained, whereas when it is excessively high, problems of deterioration of the support and thermal decomposition of the image area may occur sometimes.
The lithographic printing plate thus-obtained is mounted on an off-set printing machine to use for printing a large number of sheets.

### Example 1

### <Example>

Fig. 3(a)
Capacity of the developing bath: 92 liters
Capacity of the external tank according to the invention: 8 liters
100 liters in total
Capacity of the developer circulation pump for the external tank and the developing bath: 200 cc per minute

### (Developer)

An aqueous solution shown in Table 2 was prepared (in gram unit).

### Processing solution 1 (pH: 9.7)

| | |
|---|---|
| Water | 8329.8 |
| Sodium carbonate | 130 |
| Sodium hydrogen carbonate | 70 |
| NEWCOL B13 | 500 |
| Gum arabic | 250 |
| Hydroxy-alkylated starch (PENNON JE66, produced by Nippon Starch Chemical Co., Ltd.) | 700 |
| Ammonium primary phosphate | 20 |
| 2-Bromo-2-nitropropane-1,3-diol | 0.1 |
| 2-Methyl-4-isothiazolin-3-one | 0.1 |

### Lithographic printing plate precursor:

### [Support Example 1]

### (Support 1: Anodized aluminum support)

### (a) Mechanical surface roughening treatment

Mechanical surface roughening treatment of an aluminum plate was conducted by means of rotating roller-form nylon brush while supplying a suspension having specific gravity of 1.12 of an abrasive (pumice) in water as an abrasion slurry liquid to a surface of the aluminum plate. The average particle size of the abrasive was 30 µm and the maximum particle size was 100 µm. The material of the nylon brush was 6·10 nylon and the brush has a bristle length of 45 mm and a bristle diameter of 0.3 mm. The nylon brush was made by making holes in a stainless steel cylinder having a diameter of 300 mm and densely filling the brush bristles. Three of the rotating nylon brushes were used. Two supporting rollers (each having a diameter of 200 mm) were provided under the brush rollers at 300 mm intervals. The brush rollers were pressed against the aluminum plate till the load applied to a driving motor for rotating the brush became 7 kW greater than the load before pressing the brush rollers against the aluminum plate. The rotating direction of the brushes was the same as the moving direction of the aluminum plate. The rotation number of the brushes was 200 rpm.

### (b) Alkali etching treatment

Alkali etching treatment of the aluminum plate was conducted by spraying an aqueous solution having sodium hydroxide concentration of 2.6% by weight, aluminum ion concentration of 6.5% by weight and temperature of 70°C to dissolve the aluminum plate in an amount of 1 g/m². Subsequently, the plate was washed with water by spraying.

### (c) Desmut treatment

Desmut treatment of the aluminum plate was conducted by spraying an aqueous 1% by weight nitric acid solution (containing 0.5% by weight of aluminum ion) having temperature of 30°C, followed by washing with water by spraying. As the aqueous nitric acid solution for the desmut treatment, a waste liquid from a process of electrochemical surface roughening treatment using alternating current in an aqueous nitric acid solution was used.

### (d) Electrochemical surface roughening treatment

Electrochemical surface roughening treatment of the aluminum plate was continuously conducted by applying 60 Hz alternating current voltage. The electrolytic solution used was an aqueous solution containing 10.5 g/liter of nitric acid (containing 5 g/liter of aluminum ion and 0.007% by weight of ammonium ion) and the solution temperature was 50°C. The electrochemical surface roughening treatment was conducted using a trapezoidal rectangular wave alternating current where time (TP) for reaching the current to its peak from zero was 0.8 msec and a duty ratio was 1:1, and using a carbon electrode as a counter electrode. A ferrite was used as an auxiliary anode. The electrolytic cell used was a radial cell type.
The current density was 30 A/dm² at the peak current, and the electric quantity was 220 C/dm² in terms of the total electric quantity during the aluminum plate functioning as an anode. To the auxiliary anode, 5% of the current from the electric source was divided. Subsequently, the plate was washed with water by spraying.

### (e) Alkali etching treatment

Alkali etching treatment of the aluminum plate was conducted at 32°C by spraying an aqueous solution having a sodium hydroxide concentration of 26% by weight and an aluminum ion concentration of 6.5% by weight to dissolve the aluminum plate in an amount of 4.50 g/m². Thus, the smut component mainly comprising aluminum hydroxide formed in the precedent step of electrochemical surface roughening treatment using alternating current was removed and an edge portion of the pit formed was dissolved to smoothen the edge portion. Subsequently, the plate was washed with water by spraying.

### (f) Desmut treatment

Desmut treatment of the aluminum plate was conducted by spraying an aqueous 15% by weight sulfuric acid solution (containing 4.5% by weight of aluminum ion) having temperature of 30°C, followed by washing with water by spraying. As the aqueous nitric acid solution for the desmut treatment, a waste liquid from a process of electrochemical surface roughening treatment using alternating current in an aqueous nitric acid solution was used.

### (g) Electrochemical surface roughening treatment

Electrochemical surface roughening treatment of the aluminum plate was continuously conducted by applying 60 Hz alternating current voltage. The electrolytic solution used was an aqueous solution containing 5.0 g/liter of hydrochloric acid (containing 5 g/liter of aluminum ion) and the solution temperature was 35°C. The electrochemical surface roughening treatment was conducted using a trapezoidal rectangular wave alternating current where time (TP) for reaching the current to its peak from zero was 0.8 msec and a duty ratio was 1:1, and using a carbon electrode as a counter electrode. A ferrite was used as an auxiliary anode. The electrolytic cell used was a radial cell type.
The current density was 25 A/dm² at the peak current, and the electric quantity was 50 C/dm² in terms of the total electric quantity during the aluminum plate functioning as an anode. Subsequently, the plate was washed with water by spraying.

### (h) Anodizing treatment

Anodizing treatment of the aluminum plate was conducted using an anodizing treatment apparatus according to a two-stage feeding electrolytic treatment method (lengths of a first electrolytic unit and a second electrolytic unit: 6 m each; lengths of a first feeding unit and a second feeding unit: 3 m each; lengths of a first feeding electrode unit and a second feeding electrode unit: 2.4 m each). As an electrolytic solution supplied to the first electrolytic unit and second electrolytic unit, sulfuric acid was used. The electrolytic solution was an aqueous solution having sulfuric acid concentration of 50 g/liter (containing 0.5% by weight of aluminum ion) and the solution temperature was 20°C. Subsequently, the plate was washed with water by spraying. The amount of the final anodic oxide film was 2.7 g/m².
On the support described above was coated an undercoat solution shown below using a bar coater so as to have a dry coating amount of 6 mg/m², followed by drying at 80°C for 20 seconds to prepare Support 1.

### [Undercoat solution]

| | |
|---|---|
| Polymer (SP2) | 0.3 g |
| Pure water | 60.0 g |
| Methanol | 939.7 g |

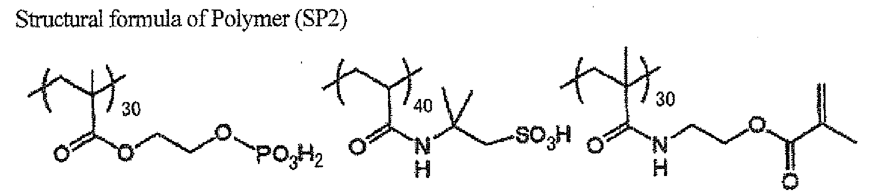

### [Photosensitive layer and Protective layer]

On the support was coated a photosensitive composition having the composition shown below using a bar coater, followed by drying at 90°C for one minute. The weight of the photosensitive composition after drying was 1.35 g/m².
The binder polymer used was PP-3 shown in Table 1. The sensitizing dye used was Compound (D40) shown in the specific examples thereof. The mercapto group-containing heterocyclic compound used was Compound SH-8 shown in the specific examples thereof.

| | |
|---|---|
| PLEX 6661-O (produced by Degussa AG) | 1.69 parts by weight |
| Binder Polymer PP-3 | 1.87 parts by weight |
| Sensitizing Dye (D40) | 0.13 parts by weight |
| BIMD (hexaarylbisimidazole, produced by Kurogane Kasei Co., Ltd.) | 0.46 parts by weight |
| ε-Phthalocyanine (F1) dispersion (25% MEK dispersion) | 1.70 parts by weight |
| Mercapto Group-containing Heterocyclic Compound SH8 | 0.34 parts by weight |
| Fluorine-based nonionic surfactant (MEGAFAC F-780F, produced by Dainippon Ink & Chemicals, Inc.) | 0.03 parts by weight |
| CUPFERRON AL (produced by Wako Pure Chemical Industries, Ltd)(10% tricresyl phosphate solution) | 0.12 parts by weight |
| Methyl ethyl ketone | 27.0 parts by weight |
| Propylene glycol monomethyl ether | 26.7 parts by weight |
| NOVOPERM Yellow H2G (produced by Clariant Corp.) | 0.20 parts by weight |

In the photopolymerization type photosensitive composition, ε-Phdialocyanine (F1) used is a compound illustrated by the chemical formula shown below. Binder Polymer PP-3 has a molar ratio of repeating units of 10:14:76 in order from the left and a weight average molecular weight of 90,000. BIMD is a compound illustrated by the chemical formula shown below.

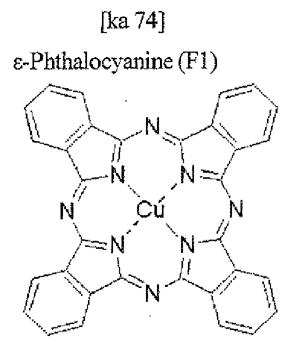

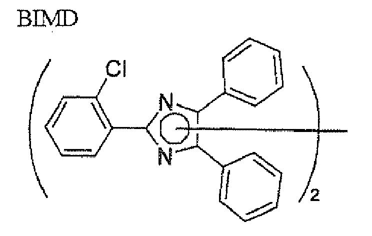

On the photosensitive layer was coated an aqueous solution for protective layer comprising

| | |
|---|---|
| GOSERAN CKS-50 (produced by Nippon Synthetic Chemical Industry Co., Ltd., saponification degree: 99% by mole, average polymerization degree: 300, modification degree: about 0.4% by mole) | 1.80 parts by weight |
| Polyvinyl pyrrolidone | 0.40 parts by weight |
| EMALEX 710 (nonionic surfactant, produced by Nihon-Emulsion Co., Ltd.) | 0.04 parts by weight |
| PIONIN D230 (produced by Takemoto Oil & Fat Co., Ltd.) | 0.05 parts by weight |
| LUVISKOL V64W (produced by BASF AG) | 0.06 parts by weight |
| 13% Aqueous solution of sulfonic acid group-containing polymer having structure shown below | 0.36 parts by weight |
| Pure water | 36.0 parts by weight |

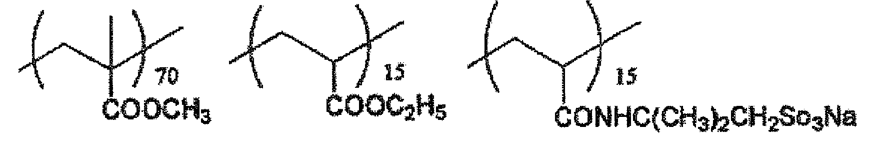

using a bar coater so as to have a dry coating amount of 2.5 g/m², followed by drying at 120°C for one minute.

### [Development processing]

A total area of 2,000 m² of the lithographic printing plate precursor was developed by the automatic developing apparatus shown in Fig. 3(a) taking about 1 month. Replenishment of the developer was not conducted. The total amount of the developer used was 100 liters.

### [Comparative Example 1]

### Automatic developing apparatus shown in Fig. 3(b)

### Capacity of the developing bath: 92 liters

### Developer: High-alkali developer (pH: 12)

### Composition:

| | |
|---|---|
| Pure water | 950.0 g |
| EDTA (tetradiamine tetraacetate) | 1.5 g |
| Potassium carbonate | 2.2 g |
| KOH (48%) | 1.5 g |
| Polyethylene naphthyl ether (C = 14) | 46.0 g |

Lithographic printing plate precursor: CTP plate (LP-NNV (photopolymerization type CTP lithographic printing plate) produced by FUJIFILM Corp.)

### Development processing:

A total area of 2,000 m² of the lithographic printing plate precursor was developed by the automatic developing apparatus shown in Fig. 3(b) taking about 1 month. In order to maintain the developing performance, the above-described developer was replenished. The total amount of the developer used reached 258 liters.

### [Example 2]

### (Preparation of aqueous dispersion of silica-containing organic resin particle)

### (1) Preparation of aqueous dispersion of ART PEARL J-7P

For the purpose of increasing dispersion stability, 3.0 parts by weight of a nonionic surfactant (EMALEX 710, produced by Nihon-Emulsion Co., Ltd.) and 77.0 parts by weight of a mica dispersion (MEB-3L, produced by CO-OP Chemical Co., Ltd., solid content concentration: 3.4%) were added and mixed. To the aqueous solution was added 20 parts by weight of silica composite crosslinked acrylic resin particle (ART PEARL J-7P, produced by Negami Chemical Industrial Co., Ltd., average particle size: 6.6 µm) and the mixture was dispersed by ACE HOMOGENIZER (produced by Nihonseiki Kaisha Ltd.) at 10,000 rpm for 15 minutes to obtain Aqueous dispersion 1 of ART PEARL J-7P.
With respect to ART PEARL J-7P, TEM observation and X-ray fluorescence analysis were conducted and it was confirmed that silica was present on the surface thereof. The aqueous dispersion was used in a coating solution for protective layer described hereinafter.

### <Preparation of lithographic printing plate precursor A>

### (Preparation of Support 1)

An aluminum plate of JIS A1050 having a thickness of 0.30 mm and a width of 1,030 mm was subjected to surface treatment shown below.

### (Surface treatment)

The surface treatment was carried out by continuously conducting the following various processes (a) to (f). After each process and water washing, liquid removal was conducted with a nip roller.
(a) Etching treatment of the aluminum plate was conducted with sodium hydroxide concentration of 26% by weight, aluminum ion concentration of 6.5% by weight and temperature of 70°C to dissolve the aluminum plate in an amount of 5 g/m². Subsequently, the plate was washed with water.
(b) Desmut treatment of the aluminum plate was conducted by spraying an aqueous solution having nitric acid concentration of 1% by weight (containing 0.5% by weight of aluminum ion) having temperature of 30°C, followed by washing with water.
(c) Electrochemical surface roughening treatment of the aluminum plate was continuously conducted by applying 60 Hz alternating current voltage. The electrolytic solution used was an aqueous 1% by weight nitric acid solution (containing 0.5% by weight of aluminum ion and 0.007% by weight of ammonium ion) and the solution temperature was 30°C. The electrochemical surface roughening treatment was conducted using a trapezoidal rectangular wave alternating current where time (TP) for reaching the current to its peak from zero was 2 msec and a duty ratio was 1:1 as an alternating current source, and using a carbon electrode as a counter electrode. A ferrite was used as an auxiliary anode. The current density was 25 A/dm² at the peak current, and the electric quantity was 250 C/dm² in terms of the total electric quantity during the aluminum plate functioning as an anode. To the auxiliary anode, 5% of the current from the electric source was divided. Subsequently, the plate was washed with water.
(d) Etching treatment of the aluminum plate was conducted at 35°C by spraying with a sodium hydroxide concentration of 26% by weight and an aluminum ion concentration of 6.5% by weight to dissolve the aluminum plate in an amount of 0.2 g/m². Thus, the smut component mainly comprising aluminum hydroxide formed in the precedent step of electrochemical surface roughening treatment using alternating current was removed and an edge portion of the pit formed was dissolved to smoothen the edge portion. Subsequently, the plate was washed with water.
(e) Desmut treatment of the aluminum plate was conducted by spraying an aqueous 25% by weight sulfuric acid solution (containing 0.5% by weight of aluminum ion) having temperature of 60°C, followed by washing with water by spraying.
(f) Anodizing treatment of the aluminum plate was conducted with sulfuric acid concentration of 170 g/liter (containing 0.5% by weight of aluminum ion) at temperature of 33°C and an electric density of 5 A/dm² for 50 seconds. Subsequently, the plate was washed with water. The weight of the anodic oxide film was 2.7 g/m².
The aluminum support thus-obtained had a surface roughness (Ra) of 0.27µm (measuring instrument: SURFCOM having a stylus with a tip diameter of 2 µm, produced by Tokyo Seimitsu Co. Ltd.,).

A coating solution (1) for intermediate layer shown below was coated on the aluminum support subjected to the surface treatment described above so as to have a dry coating amount of 10 mg/m² and dried.

### [Coating solution (1) for intermediate layer]

| | |
|---|---|
| Compound (1) shown below | 0.017 g |
| Methanol | 9.00 g |
| Water | 1.00 g |

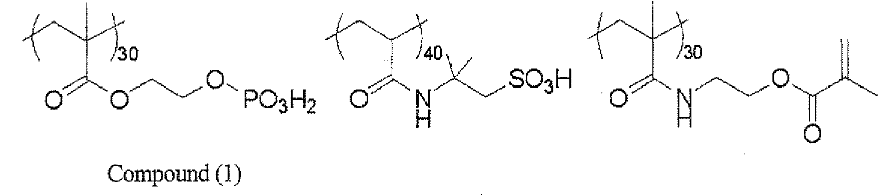

### (Preparation of lithographic printing plate precursor)

A coating solution (1) for image-forming layer (photosensitive layer) was coated on the support provided with the intermediate layer described above using a bar and dried in an oven at 100°C for 75 seconds to form an image-forming layer (photosensitive layer) having a dry coating amount of 1.0 g /m². Further, a coating solution (1) for protective layer having the composition shown below was coated on the image-forming layer using a bar so as to have a dry coating amount of 0.5 g /m² and dried in an oven at 100°C for 90 seconds to prepare Lithographic printing plate precursor A.
The coating solution (1) for image-terming layer (photosensitive layer) was prepared by mixing Photosensitive solution (1) shown below with Microcapsule solution (1) shown below just before coating, followed by stirring.

### (Photosensitive solution (1))

| | |
|---|---|
| Binder Polymer PP-3 | 0.162 parts by weight |
| Polymerization Initiator (1) shown below | 0.100 parts by weight |
| Infrared Absorbing Agent (1) shown below | 0.020 parts by weight |
| Ethylenically unsaturated compound (ARONIX M-315, produced by Toa Gosei Co., Ltd., triacrylate of 3 mole ethylene oxide adduct of isocyanuric acid) | 0.385 parts by weight |
| Fluorine-Based Surfactant (1) shown below | 0.044 parts by weight |
| Crystal Violet (produced by Hodogaya Chemical Co., Ltd.) | 0.050 parts by weight |
| Methyl ethyl ketone | 1.091 parts by weight |
| 1-Methoxy-2-propanol | 8.609 parts by weight |

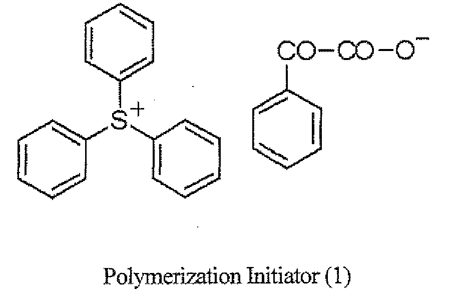

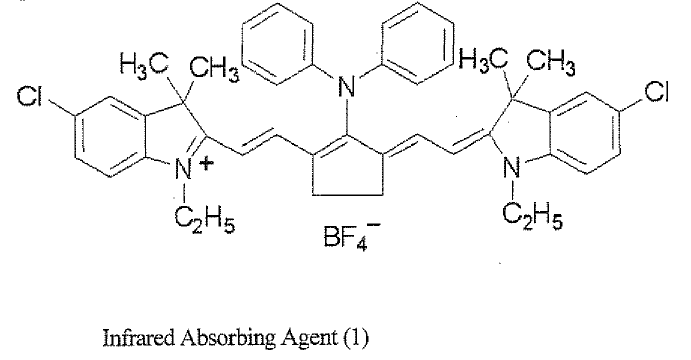

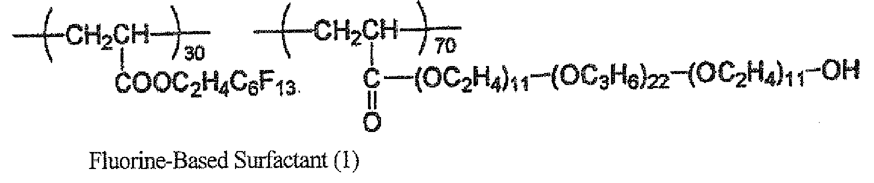

### (Microcapsule solution (1))

| | |
|---|---|
| Microcapsule (1) prepared as shown below | 2.640 parts by weight |
| Water | 2.425 parts by weight |

### (Preparation of Microcapsule (1))

As an oil phase component, 10 parts by weight of adduct of trimethylolpropane and xylene diisocyanate (TAKENATE D-110N, produced by Mitsui Takeda Chemicals, Inc., 75% by weight ethyl acetate solution), 6.00 parts by weight of ARONIX M-215 (produced by Toa Gosei Co., Ltd., bis(acryloyloxyethyl)isocyanurate) and 0.12 parts by weight of PIONIN A-41C (produced by Takemoto Oil & Fat Co., Ltd.) were dissolved in 16.67 parts by weight of ethyl acetate. As an aqueous phase component, 37.5 parts by weight of an aqueous 4% by weight PVA-205 solution was prepared. The oil phase component and the aqueous phase component were mixed and emulsified using a homogenizer at 12,000 rpm for 10 minutes. The resulting emulsion was added to 25 parts by weight of distilled water and the mixture was stirred at room temperature for 30 minutes and then stirred at 40°C for 2 hours. The thus-obtained microcapsule solution was diluted with distilled water so as to have a solid content concentration of 15% by weight. The average particle size of the microcapsule was 0.2 µm.

### (Coating solution (1) for protective layer)

| | |
|---|---|
| Polyvinyl alcohol (aqueous 6% by weight solution) (CKS 50, produced by Nippon Synthetic Chemical Industry Co., Ltd., saponification degree: 98.5%; polymerization degree: 300) | 2.24 parts by weight |
| Surfactant (EMALEX 710, produced by Nihon Emulsion Co., Ltd., aqueous 1% by weight solution) | 2.15 parts by weight |
| Mica dispersion (aqueous 3.4% by weight dispersion)(Scale-like synthetic mica (SOMASIF MEB-3L, produced by CO-OP Chemical Co., Ltd.) | 3.75 parts by weight |
| Aqueous dispersion 1 of ART PEARL J-7P described above | 0.20 parts by weight |
| Distilled water | 10.60 parts by weight |

### [Development processing]

A total area of 2,000 m² of the lithographic printing plate precursor was developed by the automatic developing apparatus shown in Fig. 3(a) taking about 1 month. Replenishment of the developer was not conducted. The total amount of the developer used was 100 liters.

### [Comparative Example 2]

### Automatic developing apparatus shown in Fig. 3(b)

### Capacity of the developing bath: 92 liters

### Developer: High-alkali developer (pH: 12)

### Composition:

| | |
|---|---|
| Pure water | 950.0 g |
| EDTA (tetramamine tetraacetate) | 1.5 g |
| Potassium carbonate | 2.2 g |
| KOH (48%) | 1.5 g |
| Polyethylene naphthyl ether (C = 14) | 46.0 g |

Lithographic printing plate precursor: CTP plate (LP-NNV (photopolymerization type CTP lithographic printing plate) produced by FUJIFILM Corp.)

### Development processing:

A total area of 2,000 m² of the lithographic printing plate precursor was developed by the automatic developing apparatus shown in Fig. 3(b) taking about 1 month. In order to maintain the developing performance, the above-described developer was replenished. The total amount of the developer used reached 358 liters.

Although the invention has been described in detail and by reference to specific embodiments, it is apparent to those skilled in the art that it is possible to add various alterations and modifications insofar as the alterations and modifications do not deviate from the spirit and the scope of the invention.
This application is based on a Japanese patent application filed on March 25, 2008 (Japanese Patent Application No. 2008-79337), and the contents thereof are incorporated herein by reference.

## Claims

1. An immersion type automatic developing apparatus for a lithographic printing plate in which removal of a non-image area is conducted in a state where a lithographic printing plate precursor having on a support an image-recording layer exposed imagewise is immersed in a developing bath filled with an aqueous solution containing a carbonate ion, a hydrogen carbonate ion and a water-soluble polymer compound, wherein a developer composed of the aqueous solution is circulated between the immersion type developing bath forming a processing pass line and an external tank provided outside the processing path line so as to keep constant a liquid level of the immersion type developing bath.

2. The immersion type automatic developing apparatus as claimed in Claim 1, wherein pH of the developer is from 8.5 to 10.8.

3. The immersion type automatic developing apparatus as claimed in Claim 1, wherein respective blades are provided as kept in contact with a carry-in roller placed upstream in a transporting direction in the developing bath and a carry-out roller placed downstream in the transporting direction in the developing bath to form a closed structure inside the developing bath.

4. The immersion type automatic developing apparatus as claimed in any one of Claims 1 to 3, wherein at least one rubbing member is rotated in a state where at least a part of the rubbing member is kept immersed in the developer to conduct the removal of the non-image area of the lithographic printing plate precursor.

5. The immersion type automatic developing apparatus as claimed in Claim 4, wherein the removal action of the non-image area of the lithographic printing plate precursor by rotation of the rubbing member is performed at least 2 seconds after a part of the lithographic printing plate precursor to be subjected to the removal action is contacted with the developer.

6. The immersion type automatic developing apparatus as claimed in Claim 5, wherein the rubbing member is placed downstream than a center of distance of the developing bath for the developer in the transporting direction.

7. The immersion type automatic developing apparatus as claimed in Claim 6, wherein a spray for spraying the developer in the external tank is provided in a downstream vicinity of the carry-in roller or carry-out roller.

8. The immersion type automatic developing apparatus as claimed in any one of Claims 1 to 7, wherein a water washing unit, an oil-desensitizing treatment unit and a drying treatment unit are provided downstream of the developing bath.

9. The immersion type automatic developing apparatus as claimed in any one of Claims 1 to 8, wherein at least one of a heat treatment unit for heat treatment of the exposed lithographic printing plate precursor and a pre-water washing unit for removing a protective layer when the lithographic printing plate precursor has the protective layer on the photosensitive layer is provided upstream of the developing bath.

10. An automatic developing method for a lithographic printing plate in which removal of a non-image area is conducted in a state where a lithographic printing plate precursor having on a support an image-recording layer exposed imagewise is immersed in a developing bath filled with a developer, wherein the developer is circulated between the immersion type developing bath forming a processing pass line and an external tank provided outside the processing path line so as to keep constant a liquid level of the immersion type developing bath.
